(19) **Europäisches Patentamt / European Patent Office / Office européen des brevets**

(11) **EP 4 383 333 A1**

(12) # EUROPEAN PATENT APPLICATION
published in accordance with Art. 153(4) EPC

(43) Date of publication:
**12.06.2024 Bulletin 2024/24**

(21) Application number: **22852943.4**

(22) Date of filing: **28.07.2022**

(51) International Patent Classification (IPC):
$H01L\ 27/146$ (2006.01)     $G02B\ 1/11$ (2015.01)
$G02B\ 5/00$ (2006.01)     $G02B\ 5/30$ (2006.01)
$H01L\ 31/0232$ (2014.01)     $H01L\ 31/10$ (2006.01)

(52) Cooperative Patent Classification (CPC):
**G02B 1/11; G02B 5/00; G02B 5/30; H01L 27/146;**
**H01L 31/0232; H01L 31/10**

(86) International application number:
**PCT/JP2022/029175**

(87) International publication number:
**WO 2023/013521 (09.02.2023 Gazette 2023/06)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **06.08.2021   JP 2021130077**

(71) Applicant: **Sony Semiconductor Solutions**
**Corporation**
**Atsugi-shi, Kanagawa 243-0014 (JP)**

(72) Inventors:
• **NOUDO, Shinichiro**
  **Atsugi-shi, Kanagawa 243-0014 (JP)**
• **NATORI, Taichi**
  **Atsugi-shi, Kanagawa 243-0014 (JP)**
• **MATSUGAI, Hiroyasu**
  **Atsugi-shi, Kanagawa 243-0014 (JP)**

• **YAMAMOTO, Atsushi**
  **Atsugi-shi, Kanagawa 243-0014 (JP)**
• **OINOUE, Takashi**
  **Atsugi-shi, Kanagawa 243-0014 (JP)**
• **KUROGI, Kana**
  **Atsugi-shi, Kanagawa 243-0014 (JP)**
• **FUKUSHIMA, Kohei**
  **Atsugi-shi, Kanagawa 243-0014 (JP)**
• **TAKEUCHI, Koichi**
  **Atsugi-shi, Kanagawa 243-0014 (JP)**
• **YOKOCHI, Kaito**
  **Atsugi-shi, Kanagawa 243-0014 (JP)**
• **IWASE, Toshihito**
  **Atsugi-shi, Kanagawa 243-0014 (JP)**

(74) Representative: **MFG Patentanwälte**
**Meyer-Wildhagen Meggle-Freund**
**Gerhard PartG mbB**
**Amalienstraße 62**
**80799 München (DE)**

(54) **PHOTODETECTOR, MANUFACTURING METHOD THEREFOR, AND ELECTRONIC DEVICE**

(57)     Collapses of pillars are suppressed. An optical detecting device includes a pixel array section having multiple pixels that are arranged two-dimensionally therein. Further, each pixel of the multiple pixels includes a photoelectric converting section provided on a semiconductor layer and a metasurface structure that is arranged on a light incidence surface side of the semiconductor layer and that guides incident light to the photoelectric converting section. Moreover, the metasurface structure includes multiple pillars that are arranged at distances therebetween which are shorter than a wavelength of the incident light and a transparent support that connects and supports at least some of the multiple pillars.

EP 4 383 333 A1

# F I G . 4

**Description**

[Technical Field]

The present technology (the technology according to the present disclosure) relates to an optical detecting device, a manufacturing method therefor, and electronic equipment, and, in particular, relates to a technology that is effective when applied to an optical detecting device including metasurface structures, a manufacturing method therefor, and electronic equipment.

[Background Art]

In recent years, a technology of controlling optical transmittance, phases, polarization, and wave surfaces by structures called metasurface structures smaller than wavelengths of light has been attracting attention. There are various metasurface structures. PTL 1 discloses a pillar-type metasurface structure including multiple pillars. In addition, PTL 2 discloses an image sensor in which a pillar-type metasurface structure is applied to a color separation lens array.

[Citation List]

[Patent Literature]

[PTL 1]
Japanese Translations of PCT for Patent No. 2020-537193
[PTL 2]
PCT Patent Publication No. WO2019/046827

[Summary]

[Technical Problem]

Meanwhile, a pillar-type metasurface structure needs to have multiple pillars that are formed being dispersed individually. Because of this, there is simply concern over collapses of the pillars, and there has been room for improvement from the viewpoint of the yield of manufacture of optical detecting devices.

An object of the present technology is to provide a technology that can suppress collapses of pillars.

[Solution to Problem]

(1) An optical detecting device according to an aspect of the present technology includes a pixel array section having multiple pixels that are arranged two-dimensionally therein, in which each pixel of the multiple pixels includes a photoelectric converting section provided on a semiconductor layer, and a metasurface structure that is arranged on a light incidence surface side of the semiconductor layer and guides incident light to the photoelectric converting section, and the metasurface structure includes multiple pillars that are arranged at distances therebetween which are shorter than a wavelength of the incident light, an underlying layer that is in contact from a semiconductor layer side of the pillars, and a transparent support that connects and supports at least some of the multiple pillars, the transparent support being at a height position which is different from a height position of the underlying layer.

(2) An optical-detecting-device manufacturing method according to another aspect of the present technology includes forming multiple pillars on a light incidence surface side of an underlying layer, the multiple pillars being arranged at distances therebetween which are shorter than a wavelength of incident light, and forming a transparent support that connects and supports at least some of the multiple pillars between mutually adjacent ones of the pillars.

(3) Electronic equipment according to another aspect of the present technology includes an optical detecting device, an optical lens that forms an image of image light from a subject onto an image capturing surface of the optical detecting device, and a signal processing circuit that performs signal processing on a signal output from the optical detecting device, in which the optical detecting device includes a pixel array section having multiple pixels that are arranged two-dimensionally therein, each pixel of the multiple pixels includes a photoelectric converting section provided on a semiconductor layer and a metasurface structure that is arranged on a light incidence surface side

of the semiconductor layer and guides incident light to the photoelectric converting section, and the metasurface structure includes multiple pillars that are arranged at distances therebetween which are shorter than a wavelength of the incident light, an underlying layer that is in contact from a semiconductor layer side of the pillars, and a transparent support that connects and supports at least some of the multiple pillars, the transparent support being at a height position which is different from a height position of the underlying layer.

[Brief Description of Drawings]

[FIG. 1]

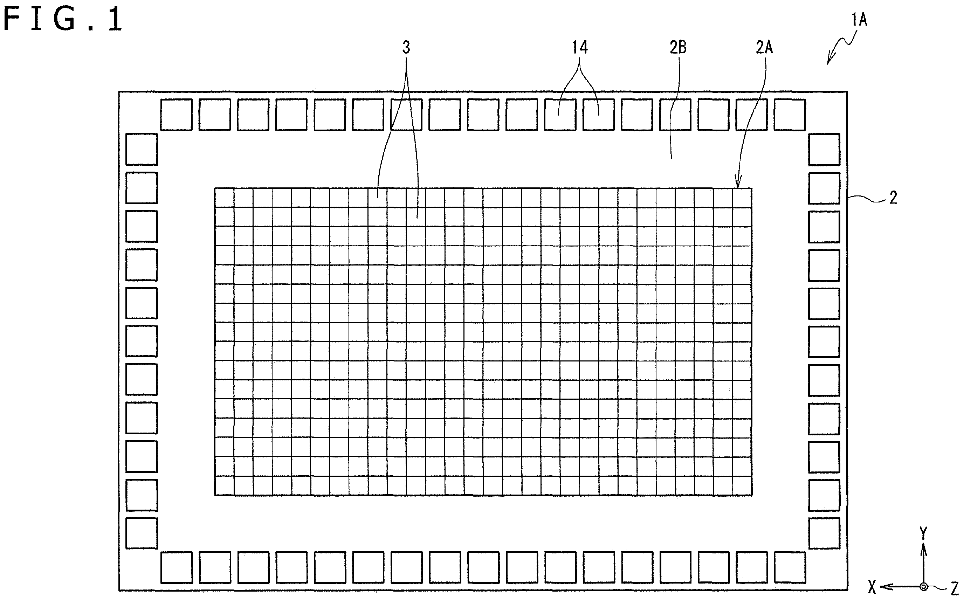

FIG. 1 is a chip layout diagram depicting a configuration example of a solid-state image capturing device according to a first embodiment of the present technology.
[FIG. 2]

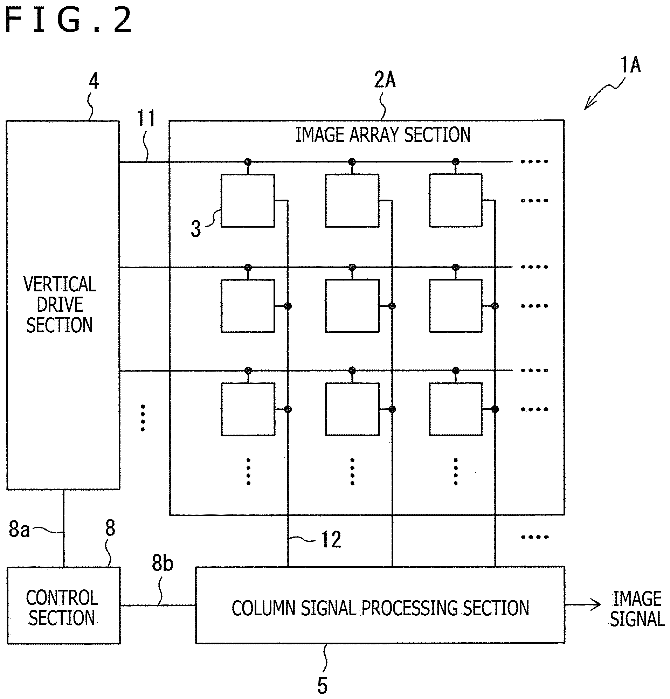

FIG. 2 is a block diagram depicting a configuration example of the solid-state image capturing device according to the first embodiment of the present technology.
[FIG. 3]

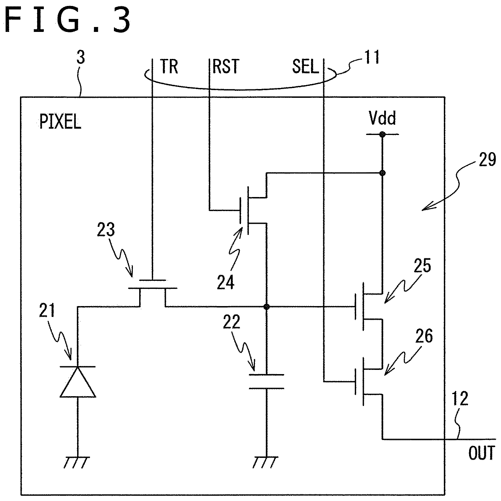

FIG. 3 is an equivalent circuit diagram depicting a configuration example of pixels of the solid-state image capturing device according to the first embodiment of the present technology.
[FIG. 4]

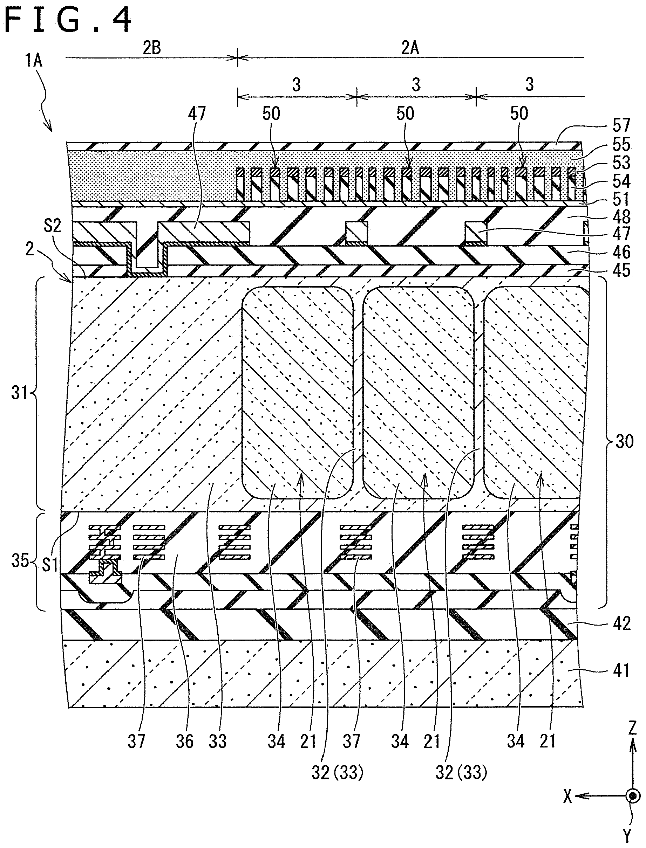

FIG. 4 is a schematic vertical cross-sectional view depicting the schematic configuration of a pixel array section and a periphery of the solid-state image capturing device according to the first embodiment of the present technology.
[FIG. 5]

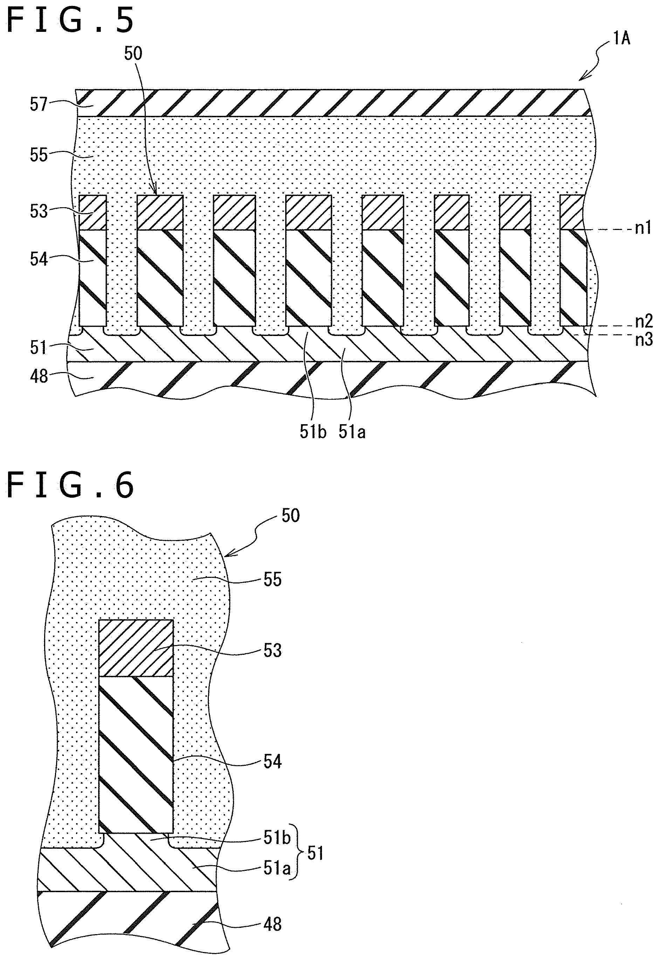

FIG. 5 is a main-section enlarged schematic vertical cross-sectional view of the portion of a metasurface structure in FIG. 4.
[FIG. 6]
FIG. 6 is a main-section enlarged schematic vertical cross-sectional view of a part in FIG. 5.
[FIG. 7]

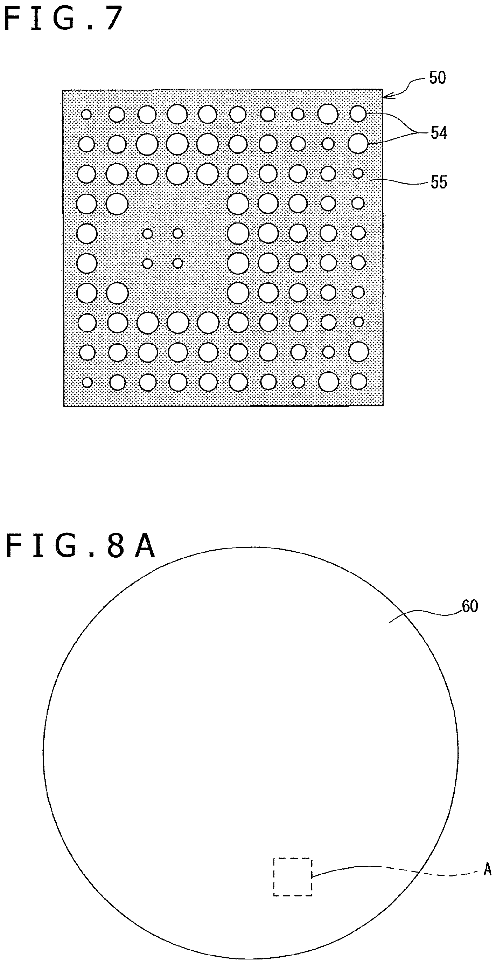

FIG. 7 is a figure depicting an example of a plane layout pattern of pillars.
[FIG. 8A]
FIG. 8A is a figure depicting a planar configuration of a semiconductor wafer.
[FIG. 8B]

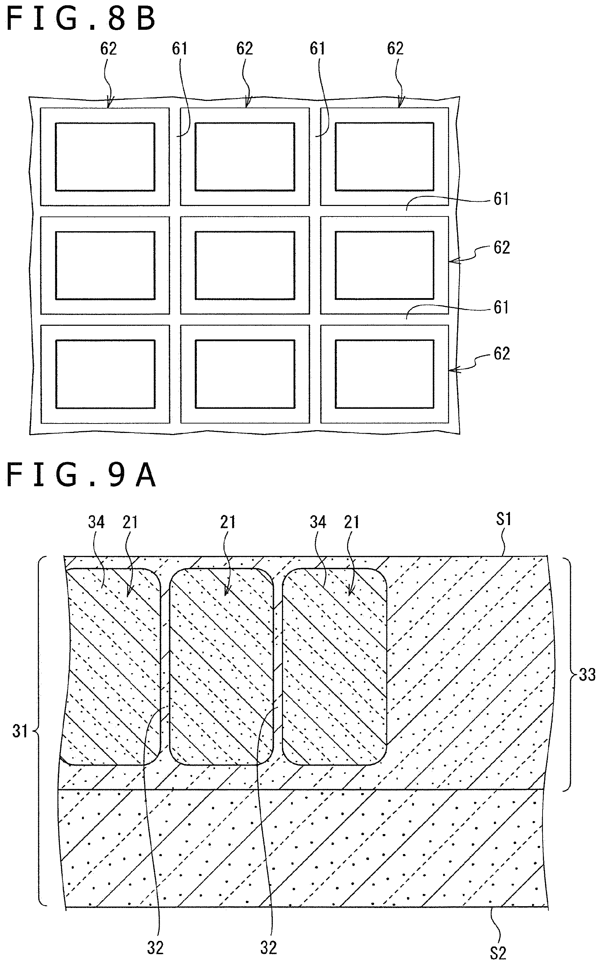

FIG. 8B is an enlarged view of a region A in FIG. 8A, and depicts a configuration of a chip formation region.
[FIG. 9A]
FIG. 9A is a schematic step vertical cross-sectional view depicting a solid-state image-capturing-device manufacturing method according to the first embodiment of the present technology.
[FIG. 9B]

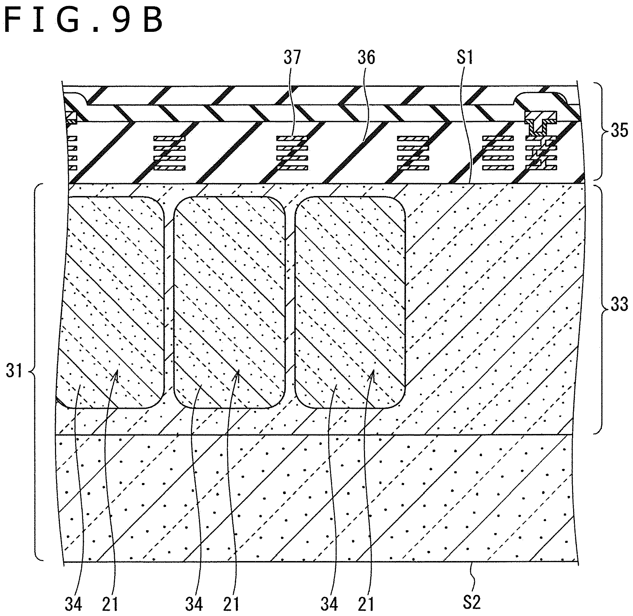

FIG. 9B is a schematic step vertical cross-sectional view of a step subsequent to the step in FIG. 9A.
[FIG. 9C]

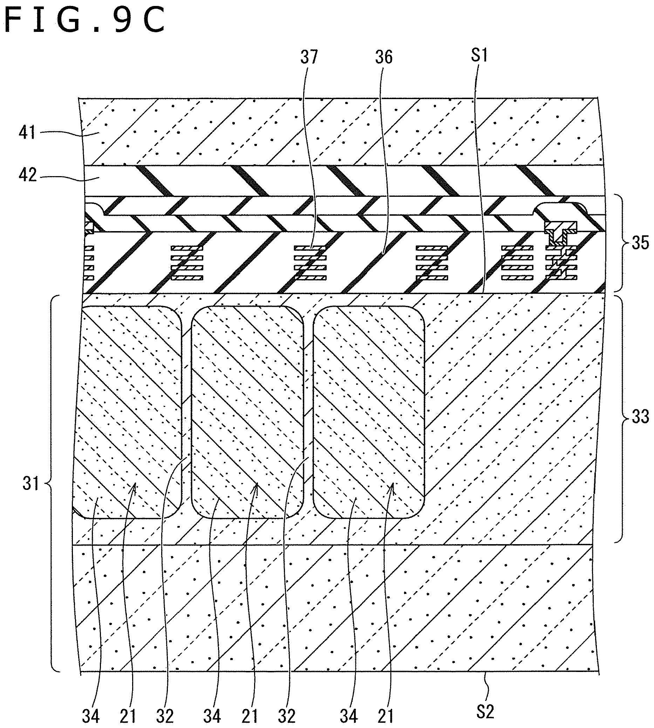

FIG. 9C is a schematic step vertical cross-sectional view of a step subsequent to the step in FIG. 9B.
[FIG. 9D]

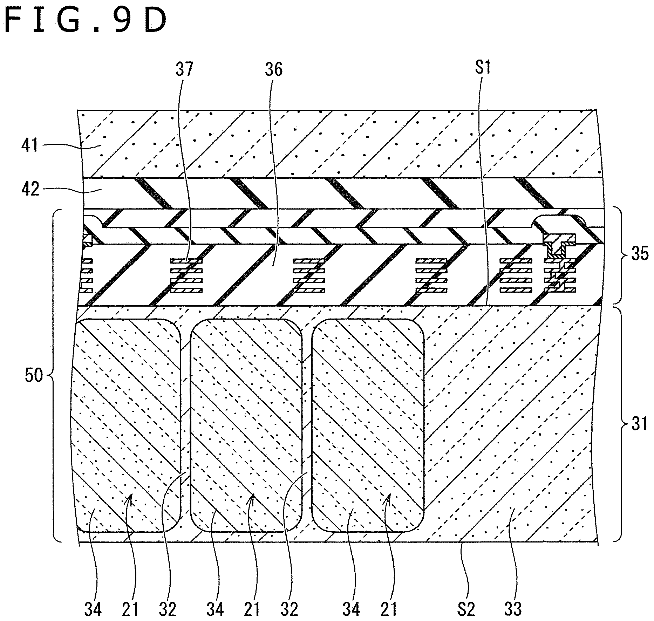

FIG. 9D is a schematic step vertical cross-sectional view of a step subsequent to the step in FIG. 9C.
[FIG. 9E]

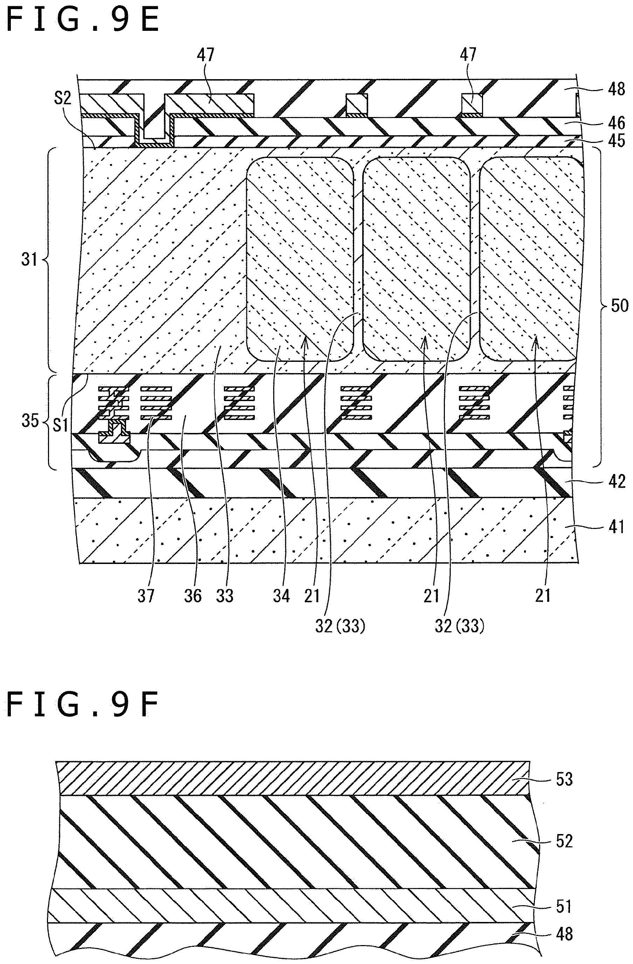

FIG. 9E is a schematic step vertical cross-sectional view of a step subsequent to the step in FIG. 9D.
[FIG. 9F]
FIG. 9F is a schematic step vertical cross-sectional view of a step subsequent to the step in FIG. 9E.
[FIG. 9G]

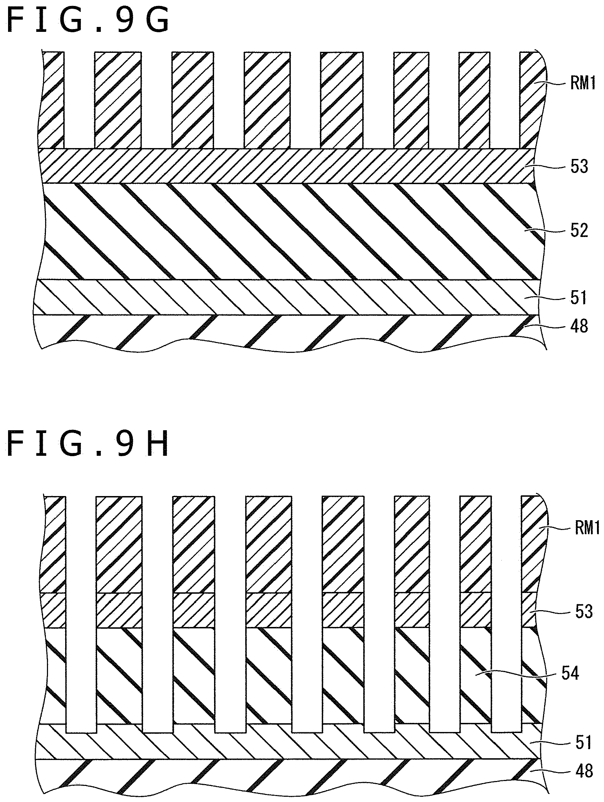

FIG. 9G is a schematic step vertical cross-sectional view of a step subsequent to the step in FIG. 9F.
[FIG. 9H]
FIG. 9H is a schematic step vertical cross-sectional view of a step subsequent to the step in FIG. 9G.
[FIG. 9I]

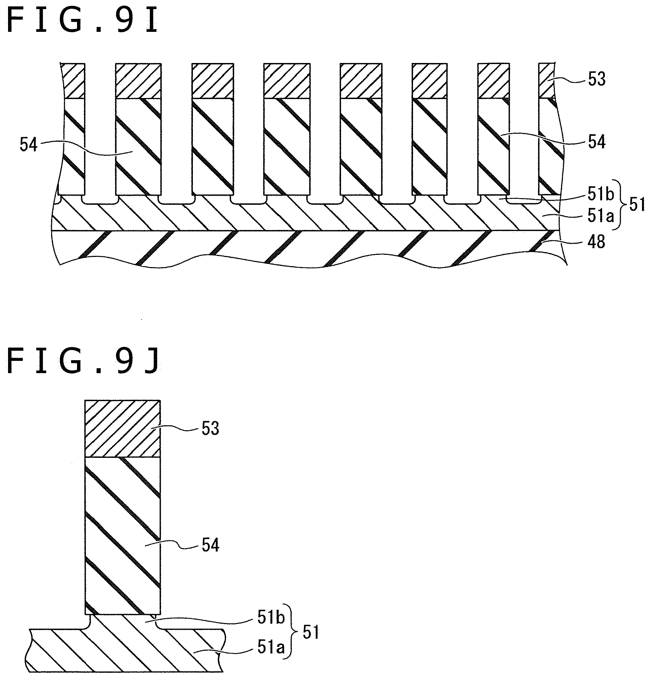

FIG. 9I is a schematic step vertical cross-sectional view of a step subsequent to the step in FIG. 9H.
[FIG. 9J]
FIG. 9J is an enlarged schematic vertical cross-sectional view of a part in FIG. 9I.
[FIG. 9K]

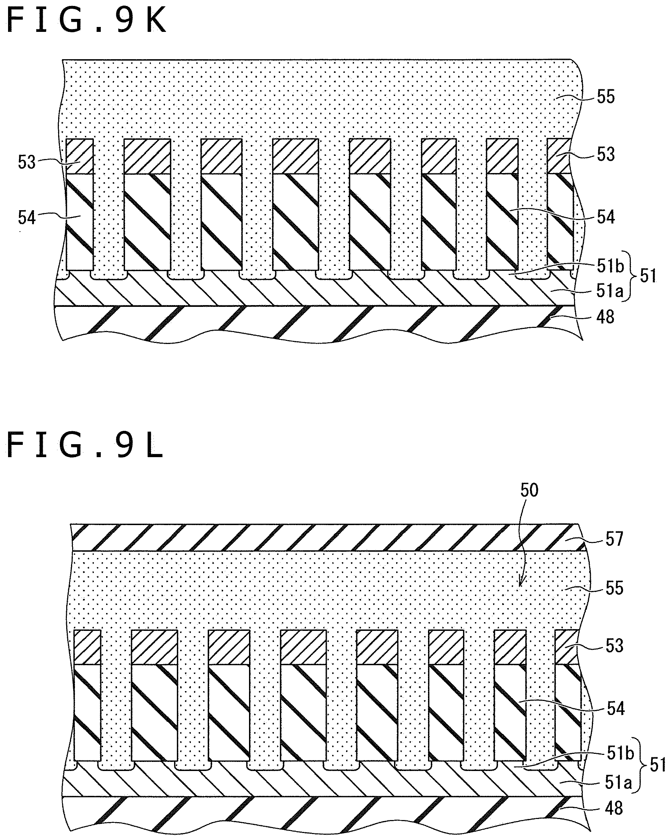

FIG. 9K is a schematic step vertical cross-sectional view of a step subsequent to the step in FIG. 9J.
[FIG. 9L]
FIG. 9L is a schematic step vertical cross-sectional view of a step subsequent to the step in FIG. 9K.

[FIG. 10]

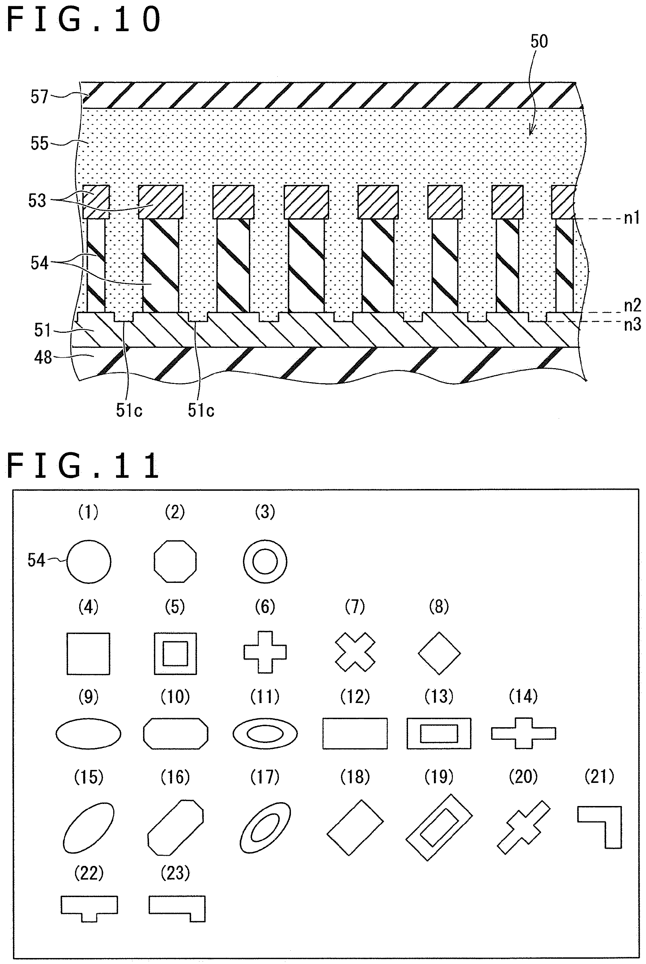

FIG. 10 is a schematic vertical cross-sectional view depicting a part of a metasurface structure according to a modification example of the first embodiment.

[FIG. 11]
FIG. 11 is a figure depicting types of the planar shape of pillars.

[FIG. 12]

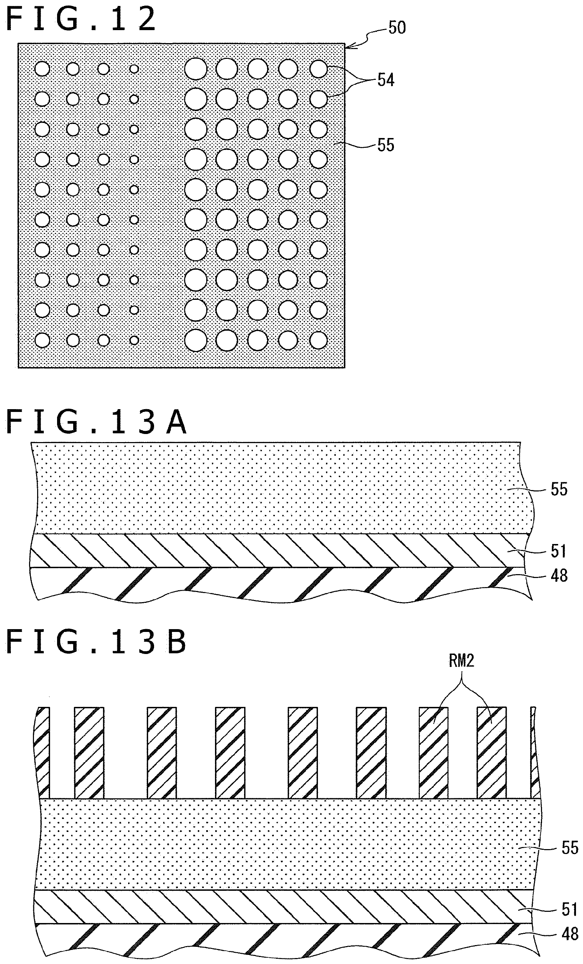

FIG. 12 is a figure depicting another example of the plane layout pattern of pillars.

[FIG. 13A]
FIG. 13A is a schematic step vertical cross-sectional view depicting a metasurface-structure formation step included in a solid-state image-capturing-device manufacturing method according to a second embodiment of the present technology.

[FIG. 13B]
FIG. 13B is a schematic step vertical cross-sectional view of a step subsequent to the step in FIG. 13A.

[FIG. 13C]

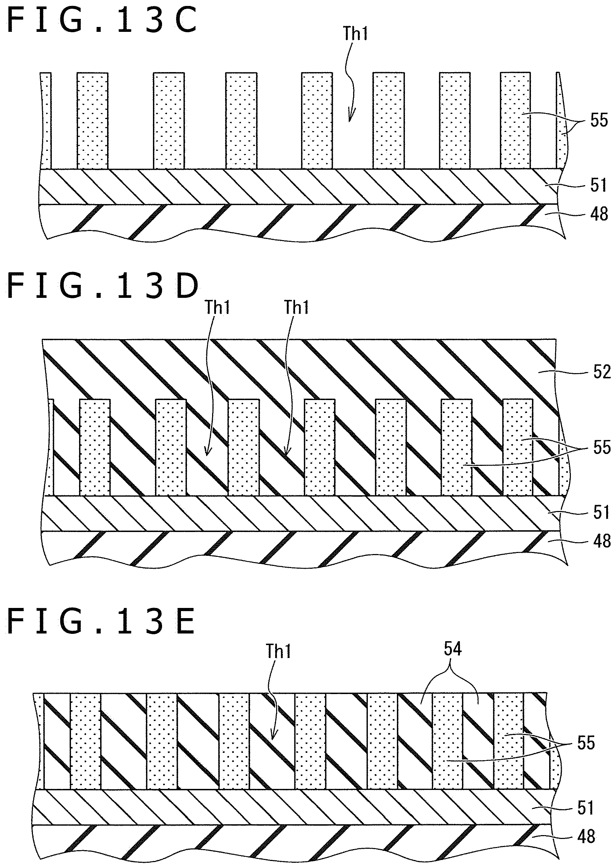

FIG. 13C is a schematic step vertical cross-sectional view of a step subsequent to the step in FIG. 13B.

[FIG. 13D]
FIG. 13D is a schematic step vertical cross-sectional view of a step subsequent to the step in FIG. 13C.

[FIG. 13E]
FIG. 13E is a schematic step vertical cross-sectional view of a step subsequent to the step in FIG. 13D.

[FIG. 13F]

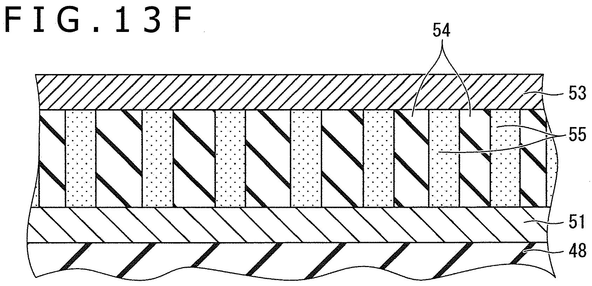

FIG. 13F is a schematic step vertical cross-sectional view of a step subsequent to the step in FIG. 13E.

[FIG. 14]

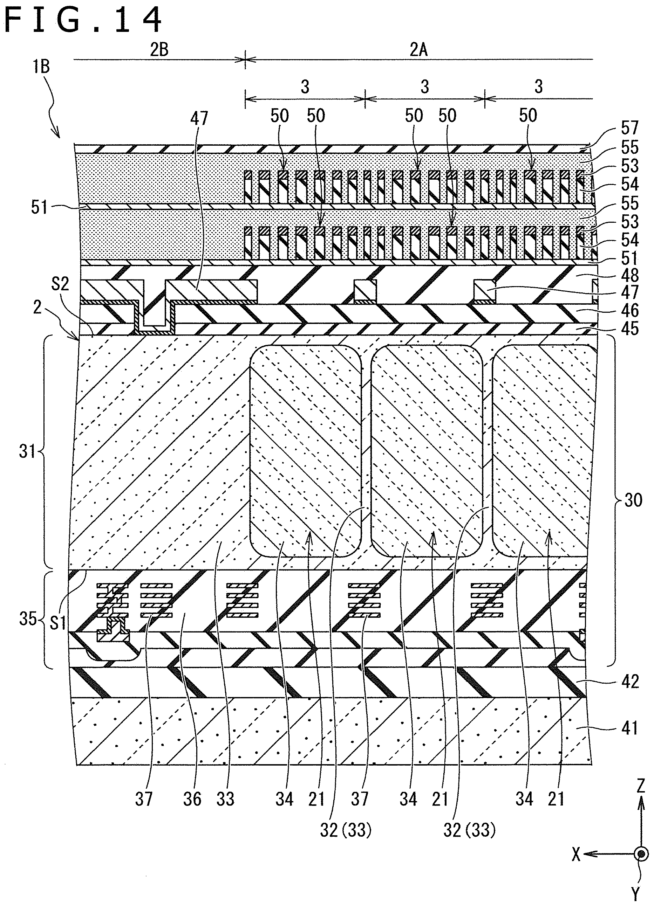

FIG. 14 is a schematic vertical cross-sectional view depicting a configuration example of a solid-state image capturing device according to a third embodiment of the present technology.

[FIG. 15]

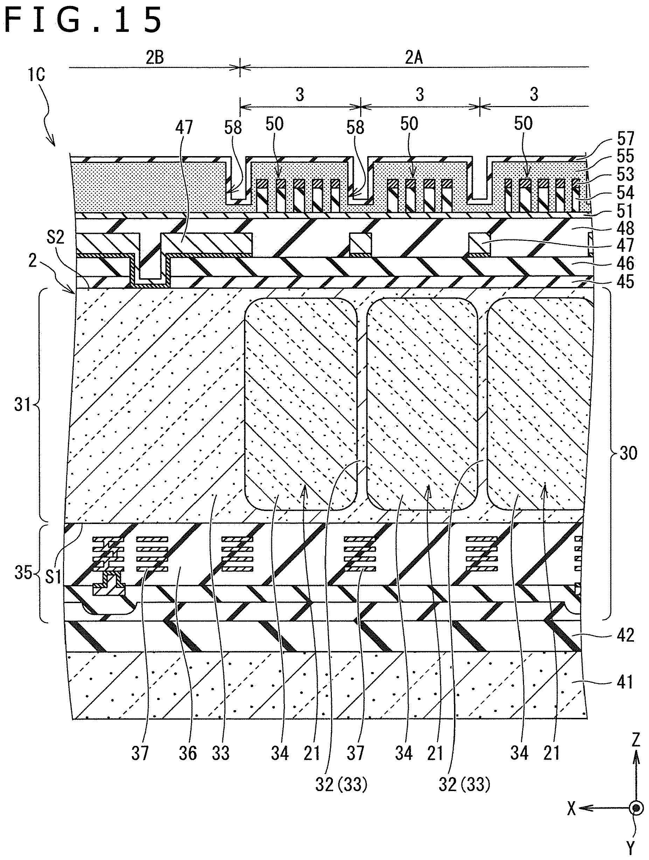

FIG. 15 is a schematic vertical cross-sectional view depicting a configuration example of a solid-state image capturing device according to a fourth embodiment of the present technology.

[FIG. 16]

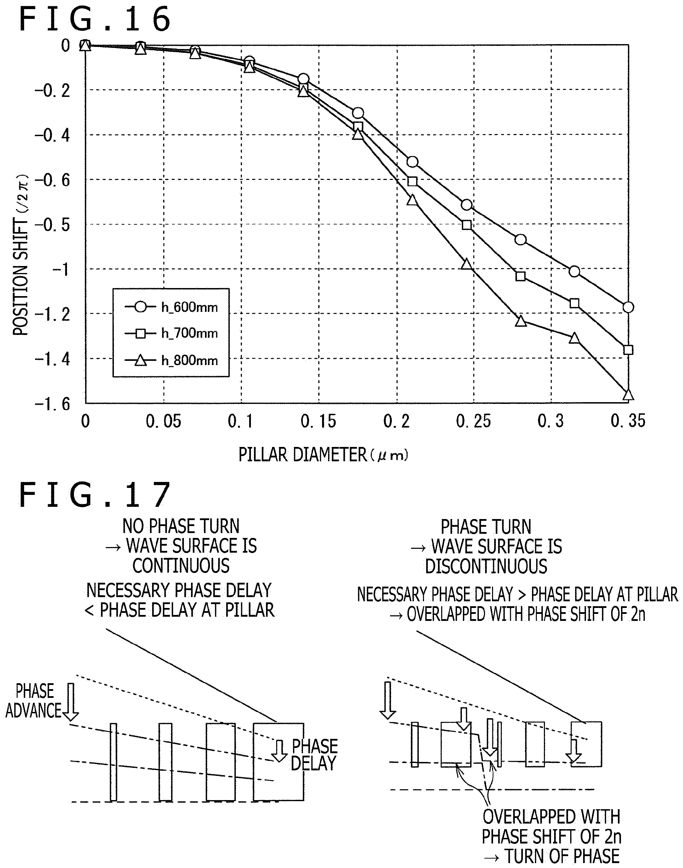

FIG. 16 is a diagram depicting the correlation between pillar diameters and phase shifts.

[FIG. 17]
FIG. 17 is a figure for explaining a turn of phases.

[FIG. 18]

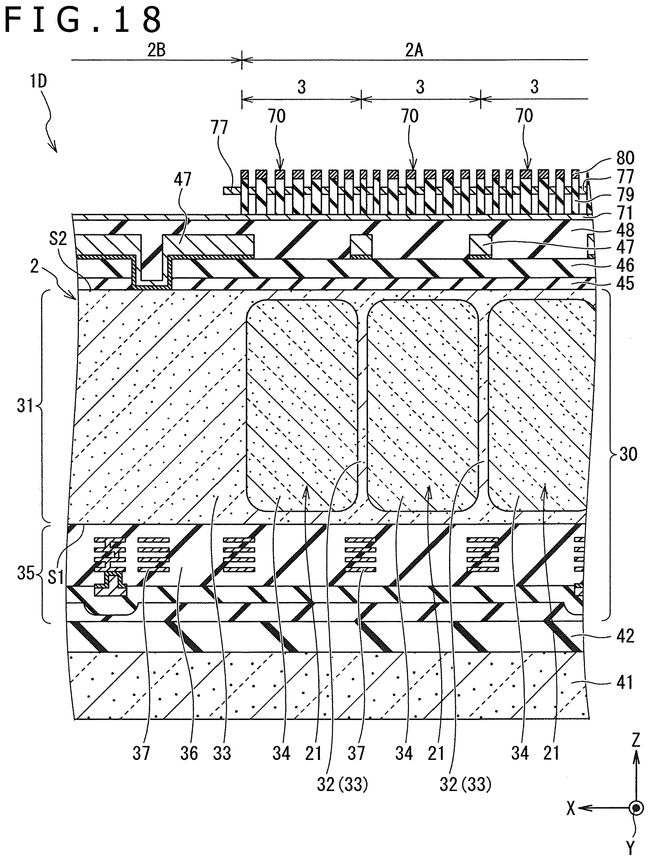

FIG. 18 is a schematic vertical cross-sectional view depicting a configuration example of the pixel array section and the periphery of a solid-state image capturing device according to a fifth embodiment of the present technology.

[FIG. 19]

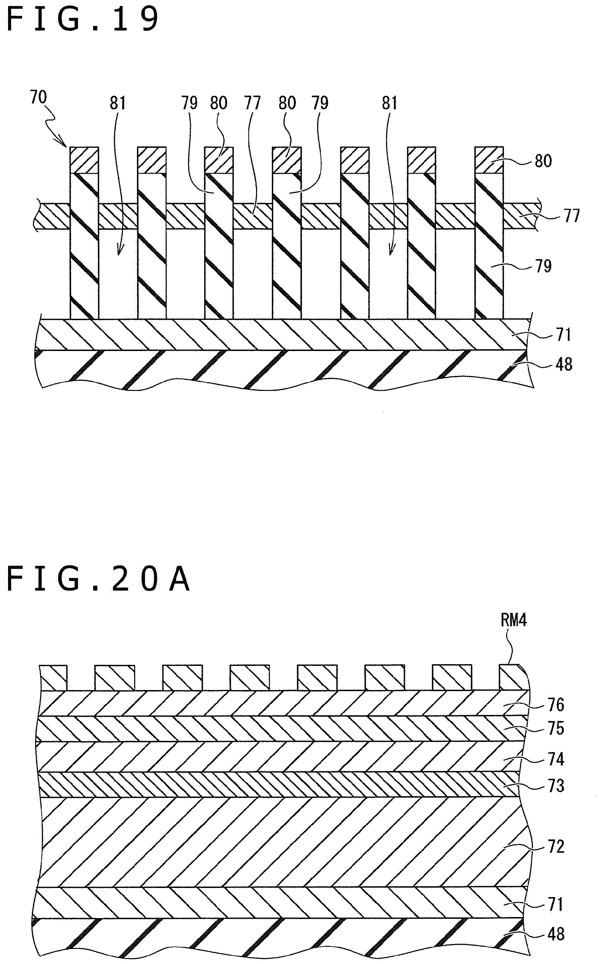

FIG. 19 is a main-section enlarged schematic vertical cross-sectional view of the portion of a metasurface structure in FIG. 18.

[FIG. 20A]
FIG. 20A is a schematic step vertical cross-sectional view depicting a metasurface-structure formation step in a solid-state image-capturing-device manufacturing method according to the fifth embodiment of the present technology.

[FIG. 20B]

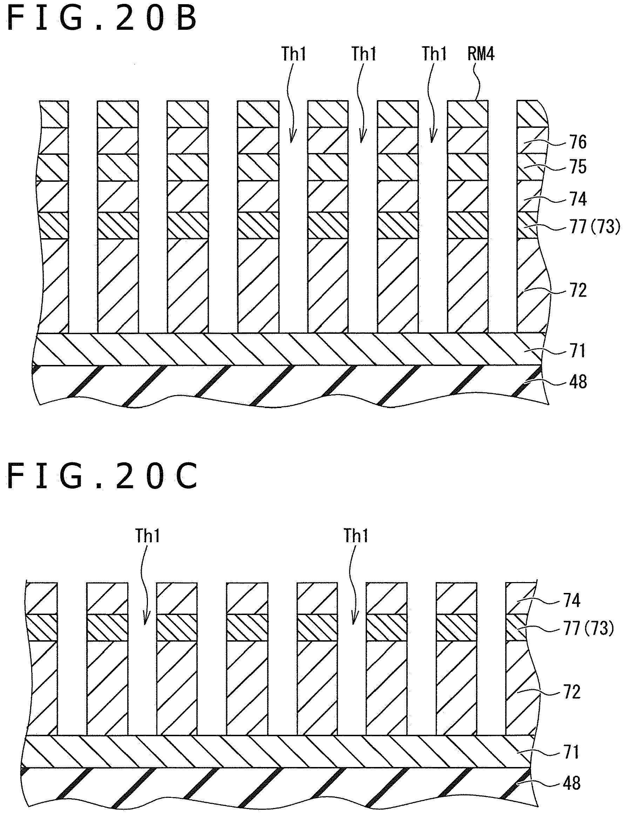

FIG. 20B is a schematic step vertical cross-sectional view of a step subsequent to the step in FIG. 20A.

[FIG. 20C]
FIG. 20C is a schematic step vertical cross-sectional view of a step subsequent to the step in FIG. 20B.

[FIG. 20D]

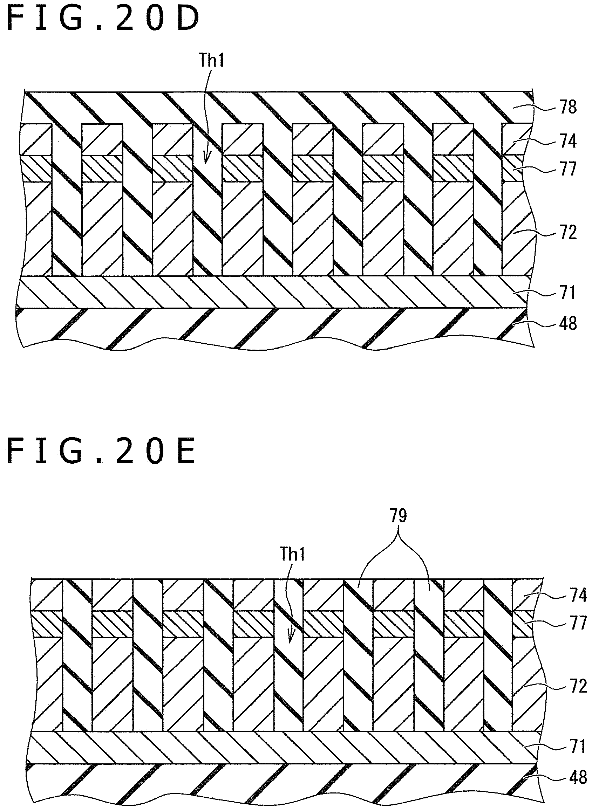

FIG. 20D is a schematic step vertical cross-sectional view of a step subsequent to the step in FIG. 20C.

[FIG. 20E]
FIG. 20E is a schematic step vertical cross-sectional view of a step subsequent to the step in FIG. 20D.

[FIG. 20F]

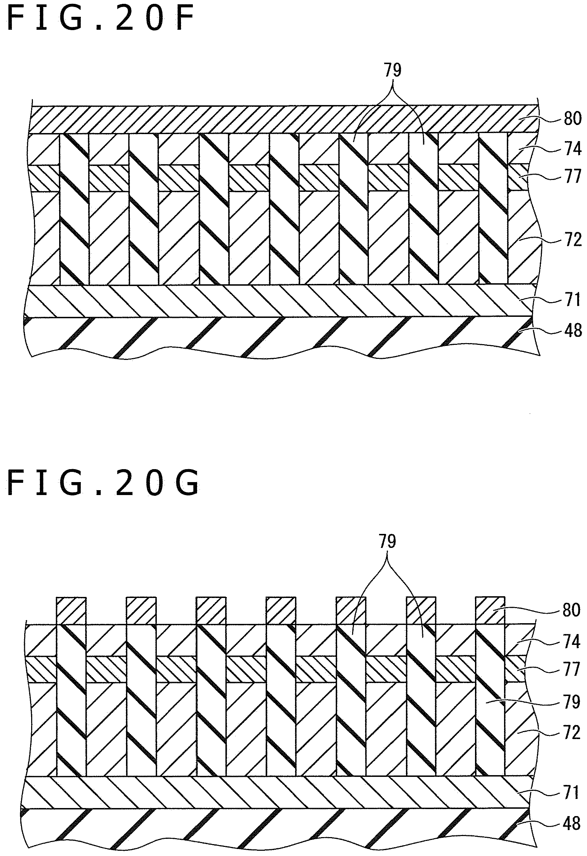

FIG. 20F is a schematic step vertical cross-sectional view of a step subsequent to the step in FIG. 20E.

[FIG. 20G]
FIG. 20G is a schematic step vertical cross-sectional view of a step subsequent to the step in FIG. 20F.

[FIG. 20H]

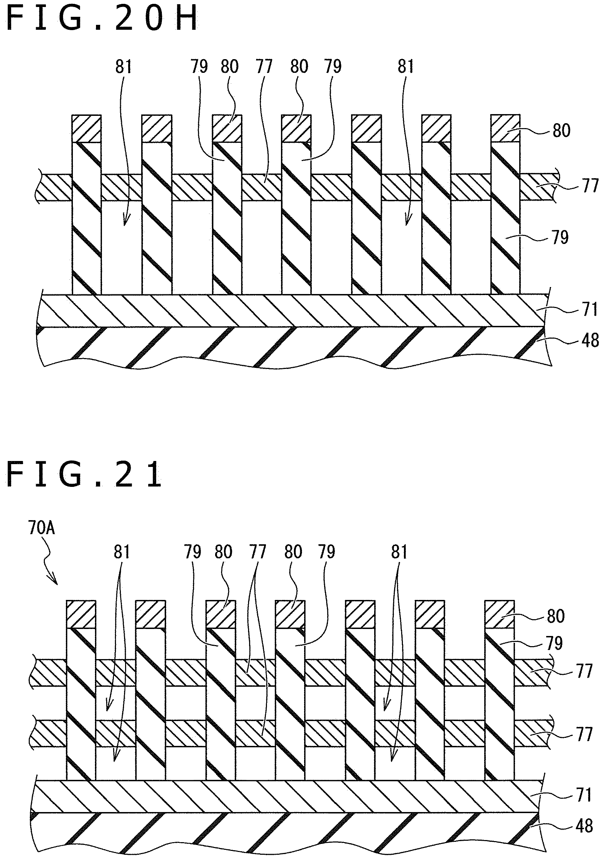

FIG. 20H is a schematic step vertical cross-sectional view of a step subsequent to the step in FIG. 20G.

[FIG. 21]
FIG. 21 is a main-section schematic vertical cross-sectional view depicting a configuration example of metasurface structures of a solid-state image capturing device according to a sixth embodiment of the present technology.

[FIG. 22A]

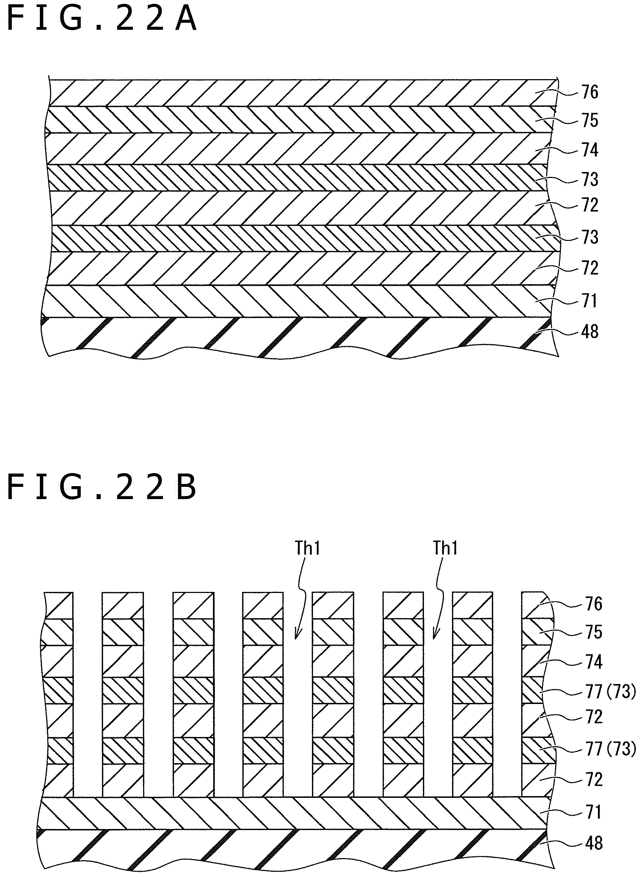

FIG. 22A is a schematic step vertical cross-sectional view depicting a metasurface-structure formation step in a solid-state image-capturing-device manufacturing method according to the sixth embodiment of the present technology.

[FIG. 22B]

FIG. 22B is a schematic step vertical cross-sectional view of a step subsequent to the step in FIG. 22A.

[FIG. 22C]

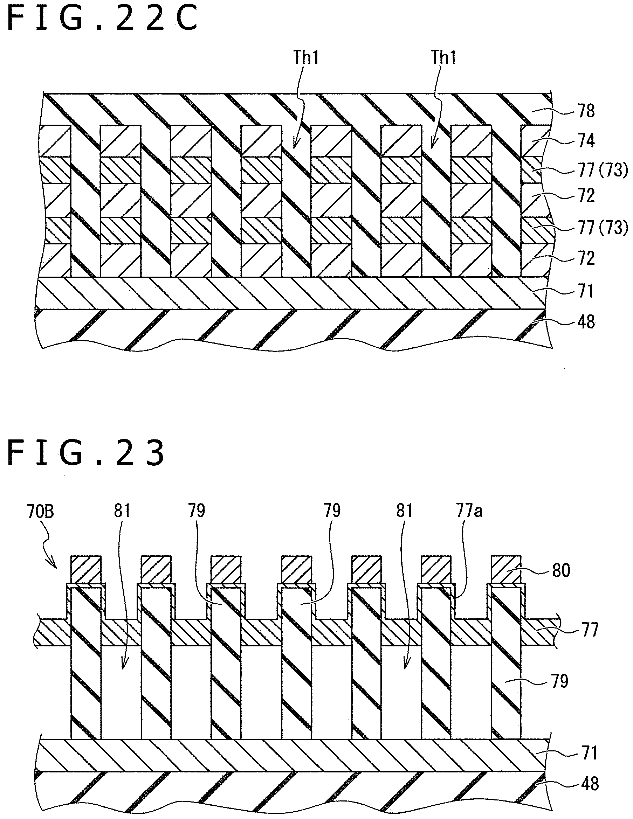

FIG. 22C is a schematic step vertical cross-sectional view of a step subsequent to the step in FIG. 22B.

[FIG. 23]

FIG. 23 is a main-section schematic vertical cross-sectional view depicting a configuration example of metasurface structures of a solid-state image capturing device according to a seventh embodiment of the present technology.

[FIG. 24A]

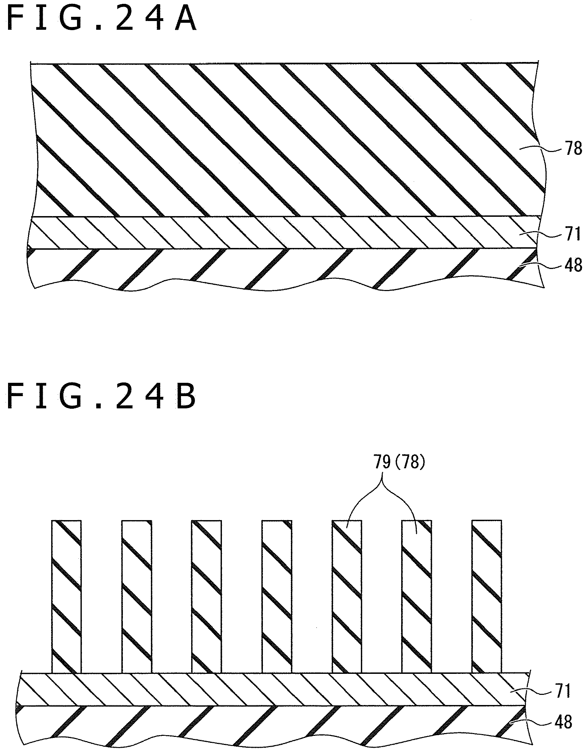

FIG. 24A is a schematic step vertical cross-sectional view depicting a metasurface-structure formation step in a solid-state image-capturing-device manufacturing method according to the seventh embodiment of the present technology.

[FIG. 24B]

FIG. 24B is a schematic step vertical cross-sectional view of a step subsequent to the step in FIG. 24A.

[FIG. 24C]

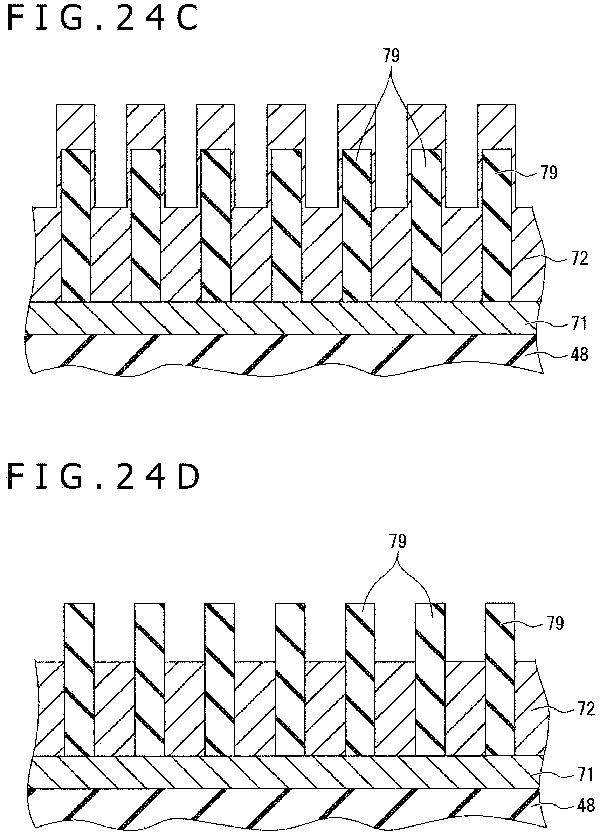

FIG. 24C is a schematic step vertical cross-sectional view of a step subsequent to the step in FIG. 24B.

[FIG. 24D]

FIG. 24D is a schematic step vertical cross-sectional view of a step subsequent to the step in FIG. 24C.

[FIG. 24E]

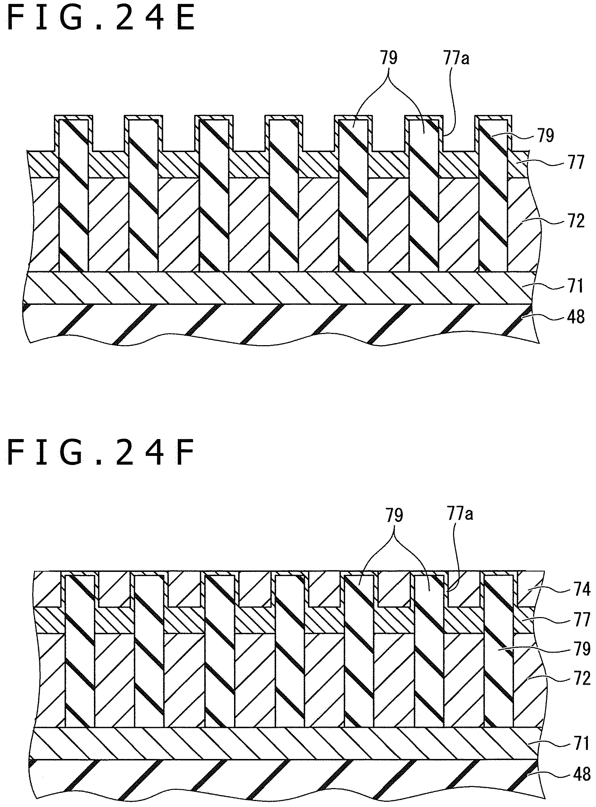

FIG. 24E is a schematic step vertical cross-sectional view of a step subsequent to the step in FIG. 24D.

[FIG. 24F]

FIG. 24F is a schematic step vertical cross-sectional view of a step subsequent to the step in FIG. 24E.

[FIG. 24G]

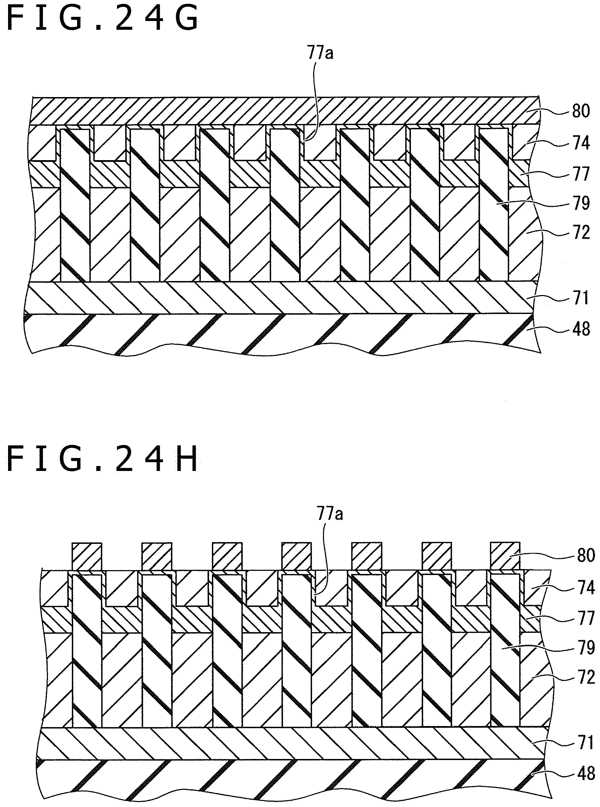

FIG. 24G is a schematic step vertical cross-sectional view of a step subsequent to the step in FIG. 24F.

[FIG. 24H]

FIG. 24H is a schematic step vertical cross-sectional view of a step subsequent to the step in FIG. 24G.

[FIG. 25]

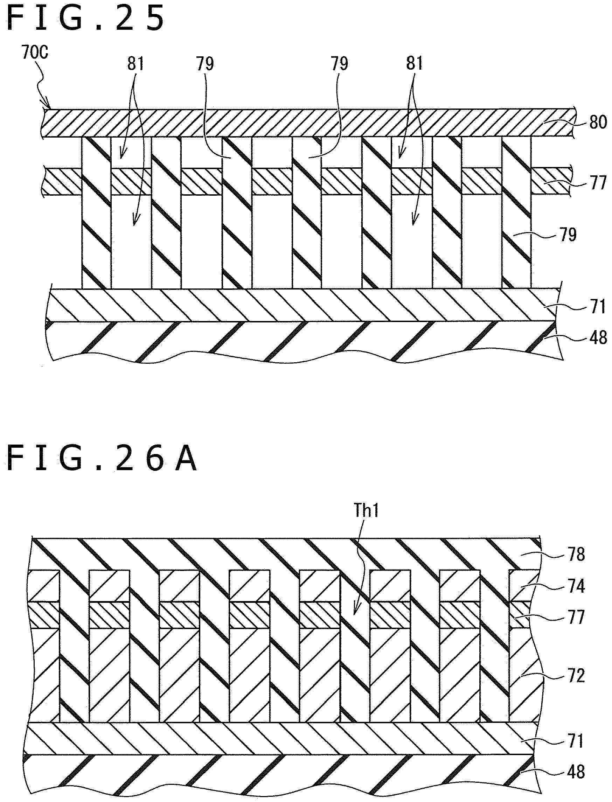

FIG. 25 is a main-section schematic vertical cross-sectional view depicting a configuration example of metasurface structures in a solid-state image capturing device according to an eighth embodiment of the present technology.

[FIG. 26A]

FIG. 26A is a schematic step vertical cross-sectional view depicting a metasurface-structure formation step in a solid-state image-capturing-device manufacturing method according to the eighth embodiment of the present technology.

[FIG. 26B]

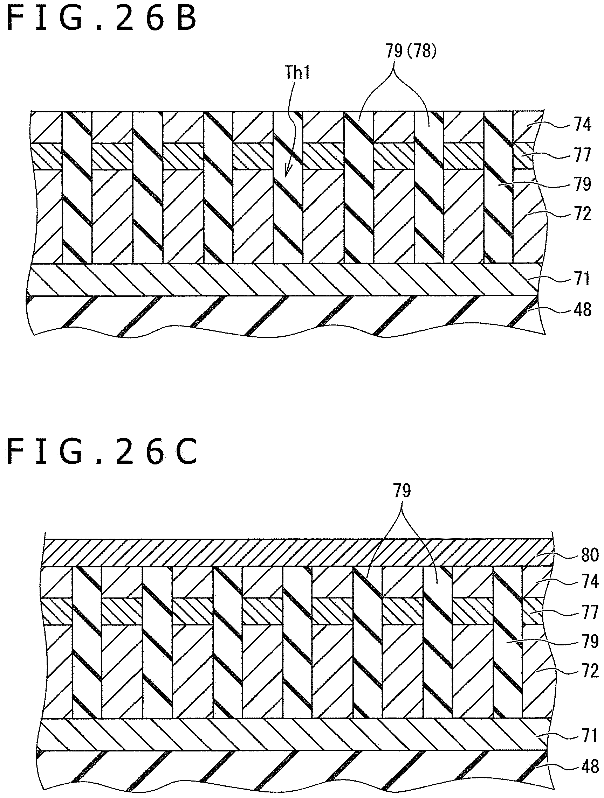

FIG. 26B is a schematic step vertical cross-sectional view of a step subsequent to the step in FIG. 26A.

[FIG. 26C]

FIG. 26C is a schematic step vertical cross-sectional view of a step subsequent to the step in FIG. 26B.

[FIG. 27A]

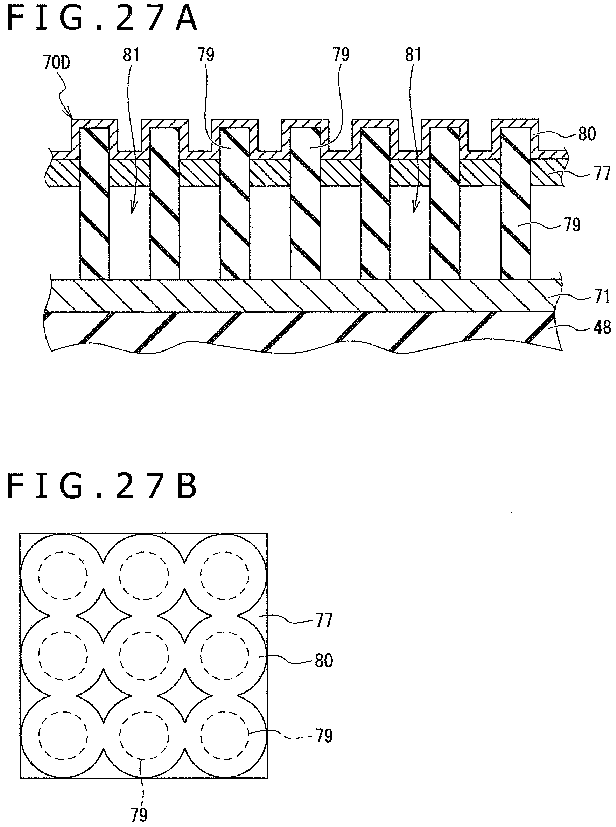

FIG. 27A is a main-section schematic vertical cross-sectional view depicting a configuration example of metasurface structures in a solid-state image capturing device according to a ninth embodiment of the present technology.

[FIG. 27B]

FIG. 27B is a main-section schematic plan view of a metasurface structure in FIG. 27A.

[FIG. 28A]

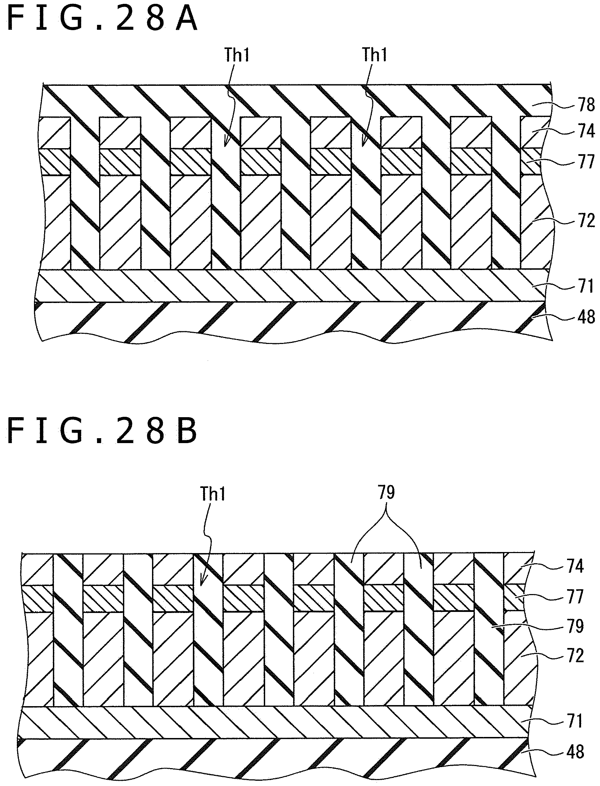

FIG. 28A is a schematic step vertical cross-sectional view depicting a metasurface-structure formation step in a solid-state image-capturing-device manufacturing method according to the ninth embodiment of the present technology.

[FIG. 28B]

FIG. 28B is a schematic step vertical cross-sectional view of a step subsequent to the step in FIG. 28A.

[FIG. 28C]

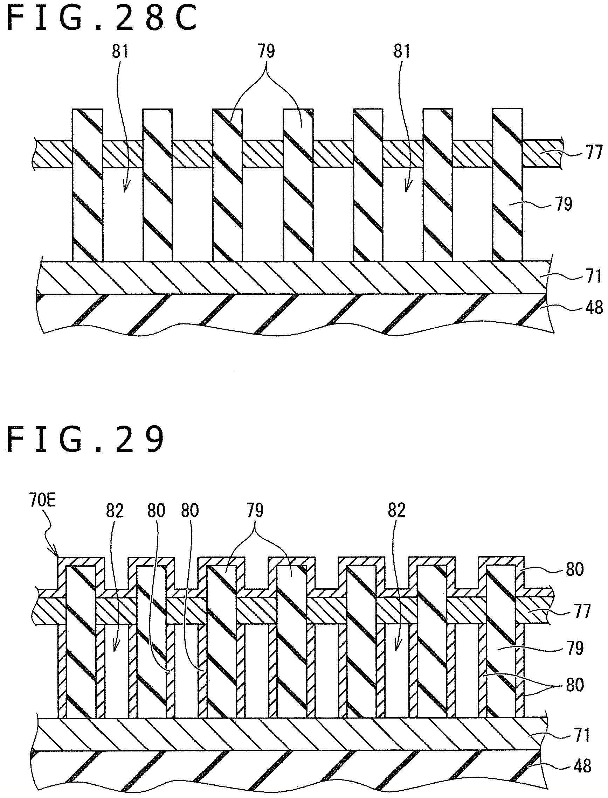

FIG. 28C is a schematic step vertical cross-sectional view of a step subsequent to the step in FIG. 28B.

[FIG. 29]

FIG. 29 is a main-section schematic vertical cross-sectional view depicting a configuration example of metasurface structures in a solid-state image capturing device according to a first modification example of the ninth embodiment of the present technology.

[FIG. 30A]

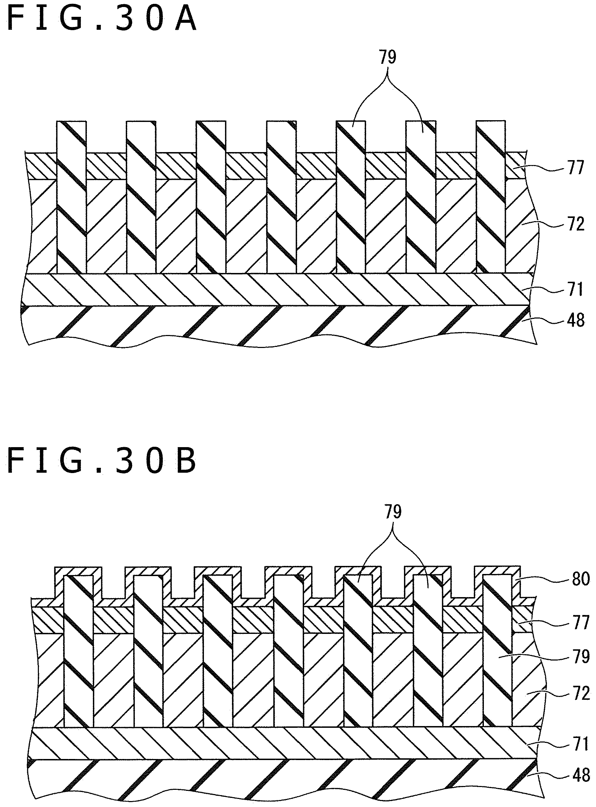

FIG. 30A is a schematic step vertical cross-sectional view depicting a metasurface-structure formation step in a solid-state image-capturing-device manufacturing method according to a second modification example of the ninth embodiment of the present technology.

[FIG. 30B]

FIG. 30B is a schematic step vertical cross-sectional view of a step subsequent to the step in FIG. 30A.

[FIG. 30C]

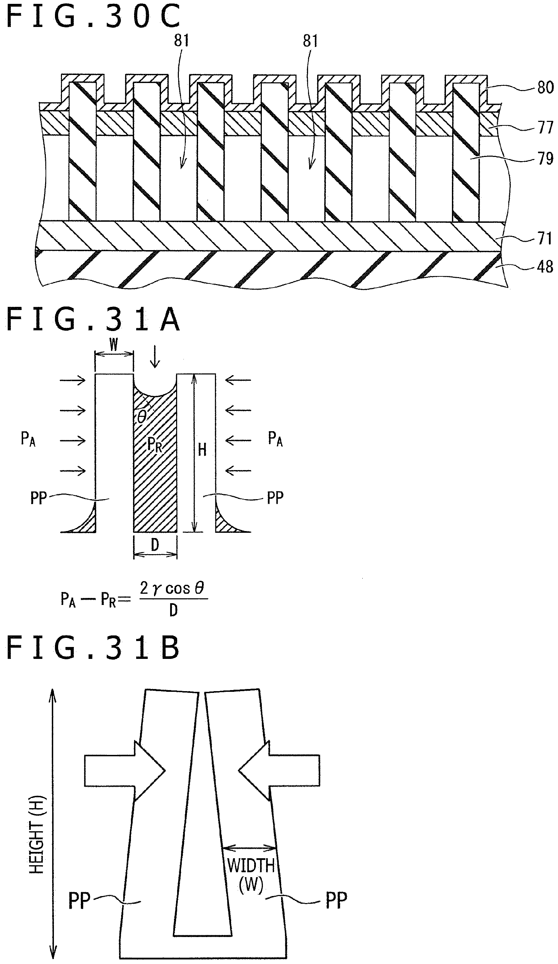

FIG. 30C is a schematic step vertical cross-sectional view of a step subsequent to the step in FIG. 30B.

[FIG. 31A]

FIG. 31A is a figure for explaining collapses of pillars.

[FIG. 31B]

FIG. 31B is a figure for explaining the collapses of the pillars.

[FIG. 32]

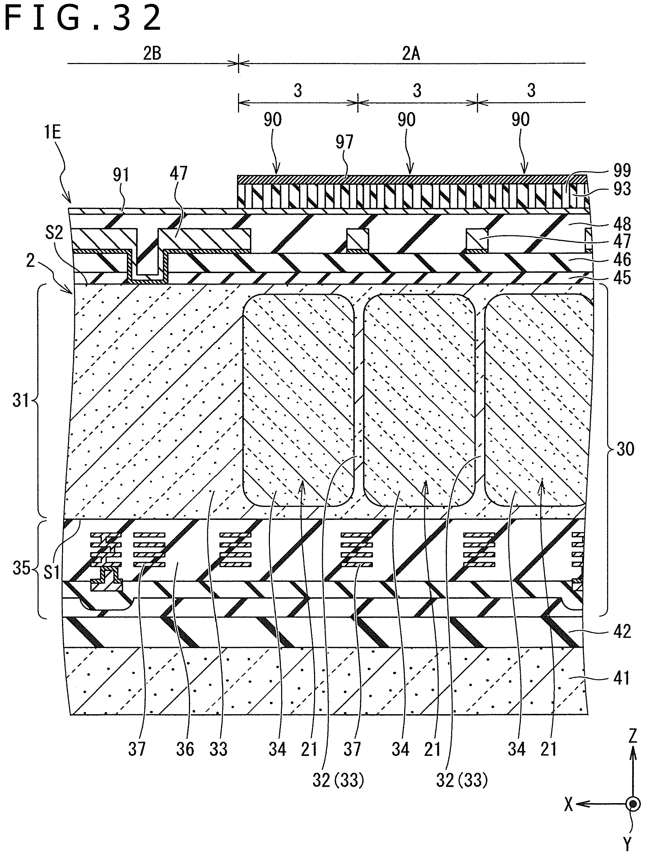

FIG. 32 is a schematic vertical cross-sectional view depicting a schematic configuration of the pixel array section and the periphery of a solid-state image capturing device according to a tenth embodiment of the present technology.

[FIG. 33]

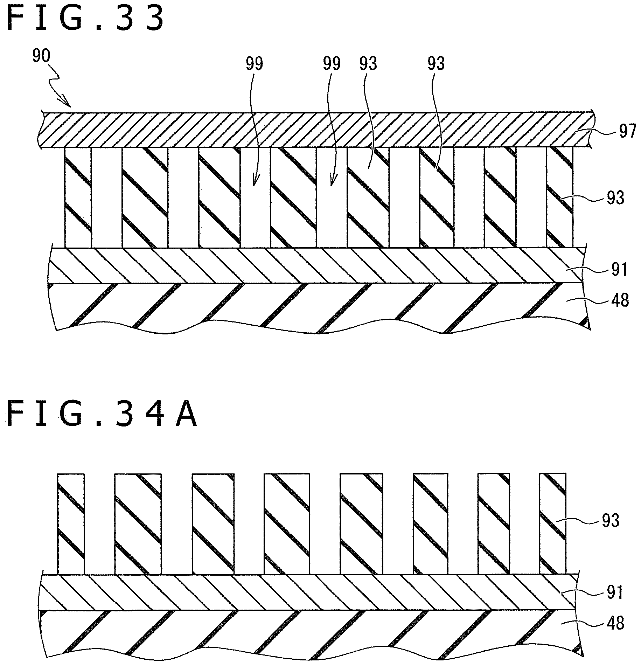

FIG. 33 is a main-section enlarged schematic vertical cross-sectional view of the portion of a metasurface structure in FIG. 32.

[FIG. 34A]

FIG. 34A is a schematic step vertical cross-sectional view depicting a metasurface-structure formation step in a solid-state image-capturing-device manufacturing method according to the tenth embodiment of the present technology.

[FIG. 34B]

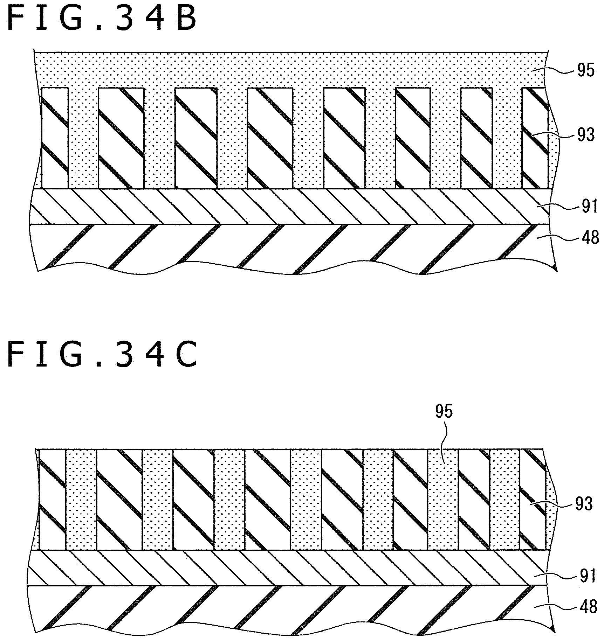

FIG. 34B is a schematic step vertical cross-sectional view of a step subsequent to the step in FIG. 34A.

[FIG. 34C]

FIG. 34C is a schematic step vertical cross-sectional view of a step subsequent to the step in FIG. 34B.

[FIG. 34D]

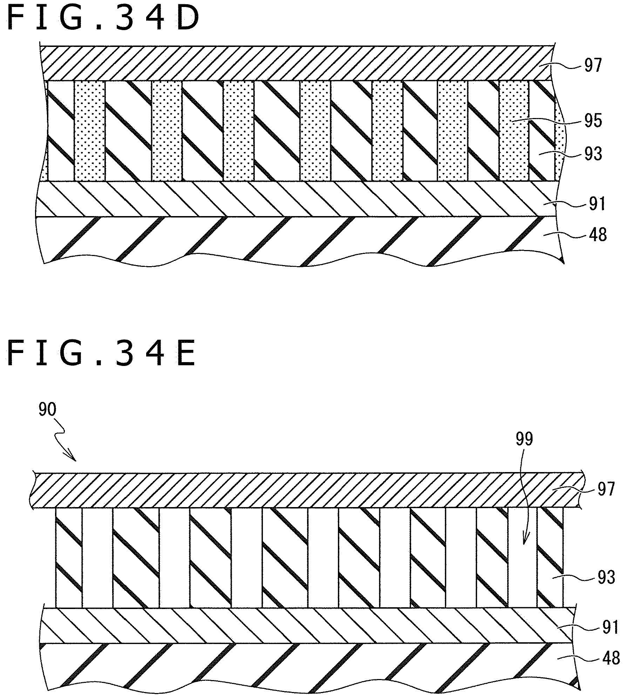

FIG. 34D is a schematic step vertical cross-sectional view of a step subsequent to the step in FIG. 34C.

[FIG. 34E]

FIG. 34E is a schematic step vertical cross-sectional view of a step subsequent to the step in FIG. 34D.

[FIG. 35A]

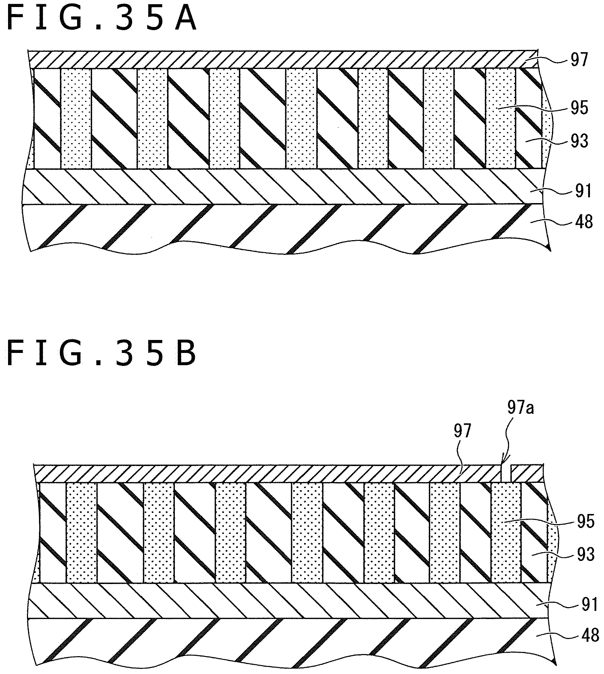

FIG. 35A is a schematic step vertical cross-sectional view depicting a metasurface-structure formation step in a solid-state image-capturing-device manufacturing method according to an eleventh embodiment of the present technology.

[FIG. 35B]

FIG. 35B is a schematic step vertical cross-sectional view of a step subsequent to the step in FIG. 35A.

[FIG. 35C]

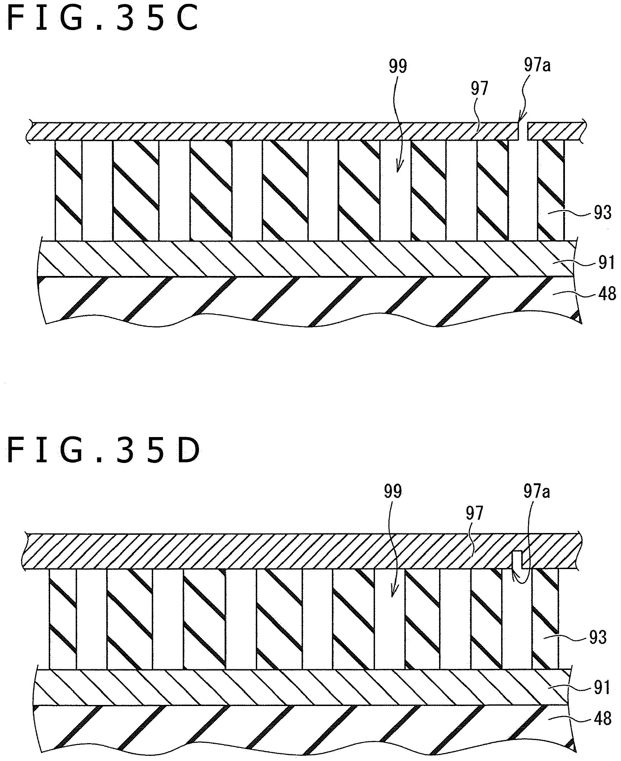

FIG. 35C is a schematic step vertical cross-sectional view of a step subsequent to the step in FIG. 35B.

[FIG. 35D]

FIG. 35D is a schematic step vertical cross-sectional view of a step subsequent to the step in FIG. 35C.

[FIG. 36A]

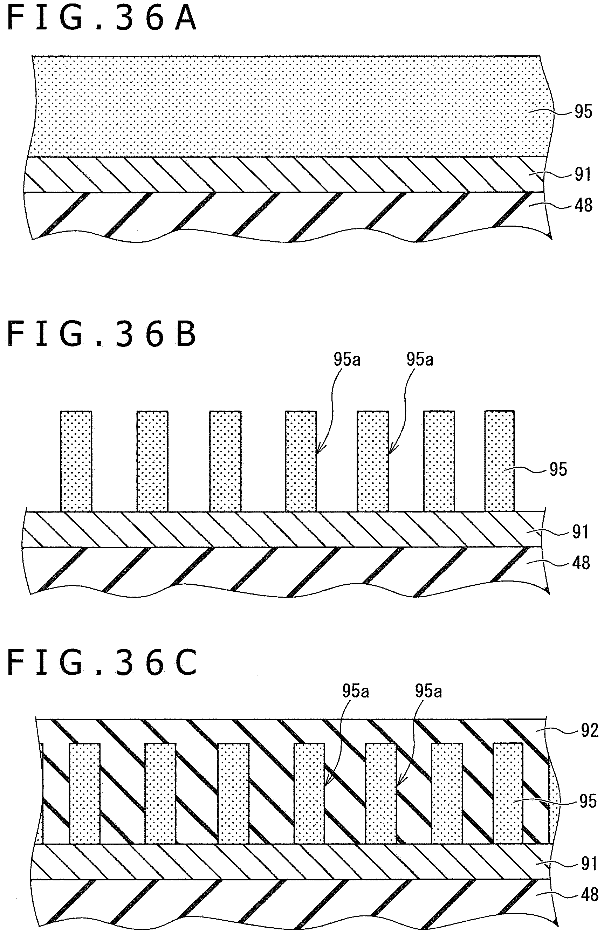

FIG. 36A is a schematic step vertical cross-sectional view depicting a metasurface-structure formation step in a solid-state image-capturing-device manufacturing method according to a twelfth embodiment of the present technology.

[FIG. 36B]

FIG. 36B is a schematic step vertical cross-sectional view of a step subsequent to the step in FIG. 36A.

[FIG. 36C]

FIG. 36C is a schematic step vertical cross-sectional view of a step subsequent to the step in FIG. 36B.

[FIG. 36D]

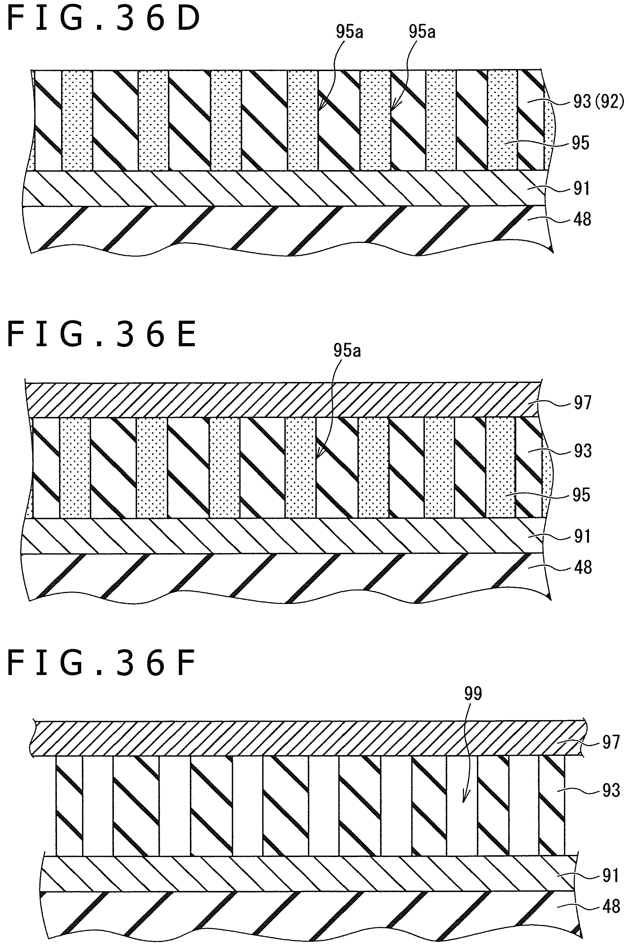

FIG. 36D is a schematic step vertical cross-sectional view of a step subsequent to the step in FIG. 36C.

[FIG. 36E]

FIG. 36E is a schematic step vertical cross-sectional view of a step subsequent to the step in FIG. 36D.

[FIG. 36F]

FIG. 36F is a schematic step vertical cross-sectional view of a step subsequent to the step in FIG. 36E.

[FIG. 37A]

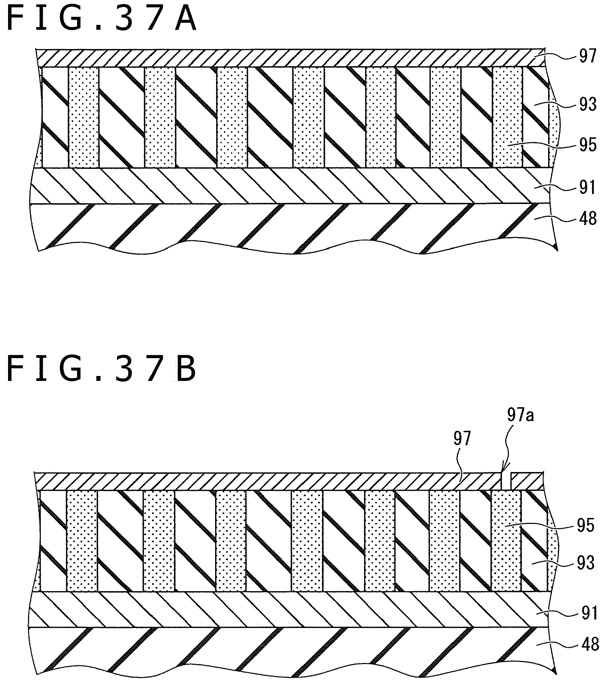

FIG. 37A is a schematic step vertical cross-sectional view depicting a metasurface-structure formation step in a solid-state image-capturing-device manufacturing method according to a thirteenth embodiment of the present technology.

[FIG. 37B]

FIG. 37B is a schematic step vertical cross-sectional view of a step subsequent to the step in FIG. 37A.
[FIG. 37C]

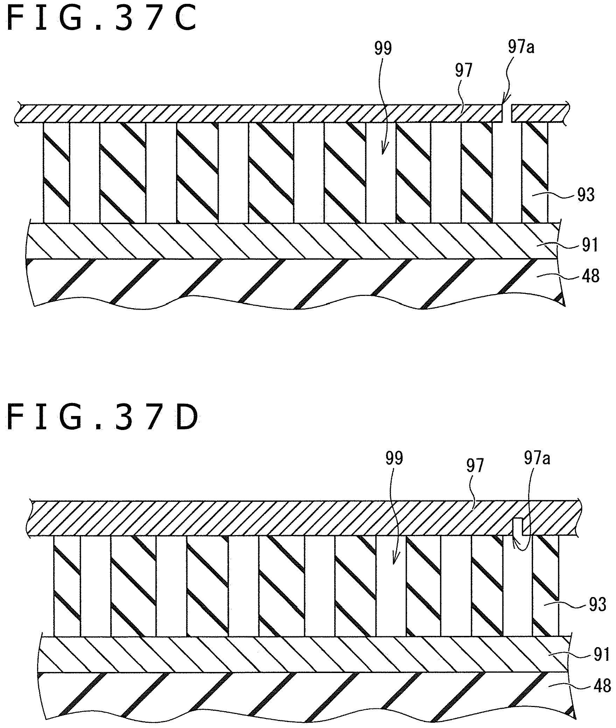

FIG. 37C is a schematic step vertical cross-sectional view of a step subsequent to the step in FIG. 37B.
[FIG. 37D]
FIG. 37D is a schematic step vertical cross-sectional view of a step subsequent to the step in FIG. 37C.
[FIG. 38A]

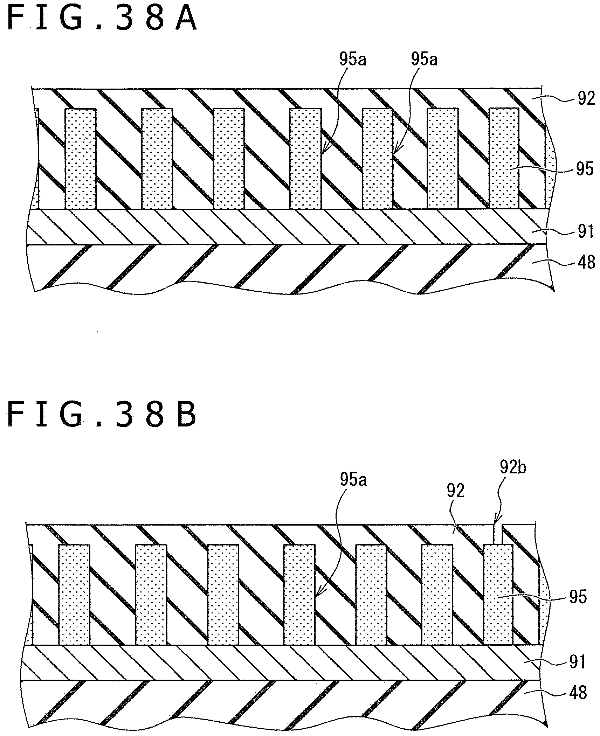

FIG. 38A is a schematic step vertical cross-sectional view depicting a metasurface-structure formation step in a solid-state image-capturing-device manufacturing method according to a fourteenth embodiment of the present technology.
[FIG. 38B]
FIG. 38B is a schematic step vertical cross-sectional view of a step subsequent to the step in FIG. 38A.
[FIG. 38C]

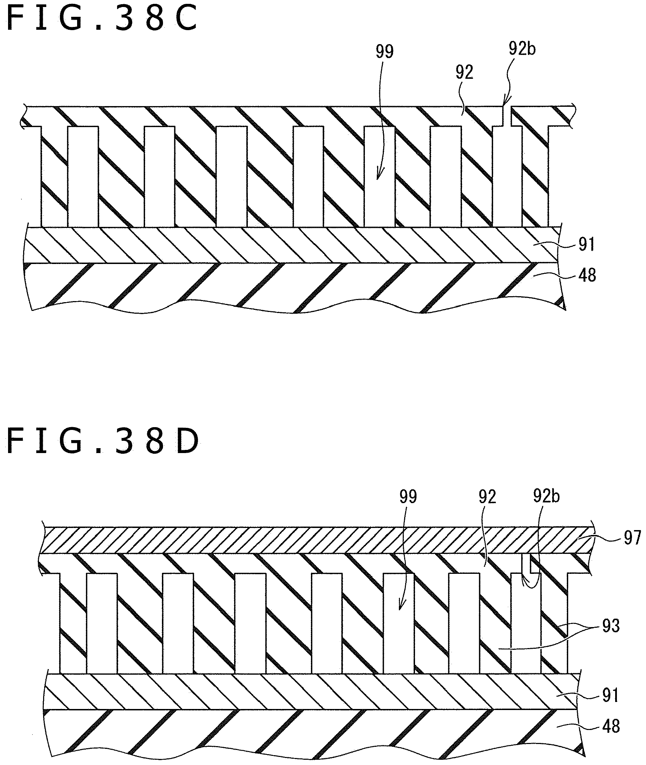

FIG. 38C is a schematic step vertical cross-sectional view of a step subsequent to the step in FIG. 38B.
[FIG. 38D]
FIG. 38D is a schematic step vertical cross-sectional view of a step subsequent to the step in FIG. 38C.
[FIG. 39]

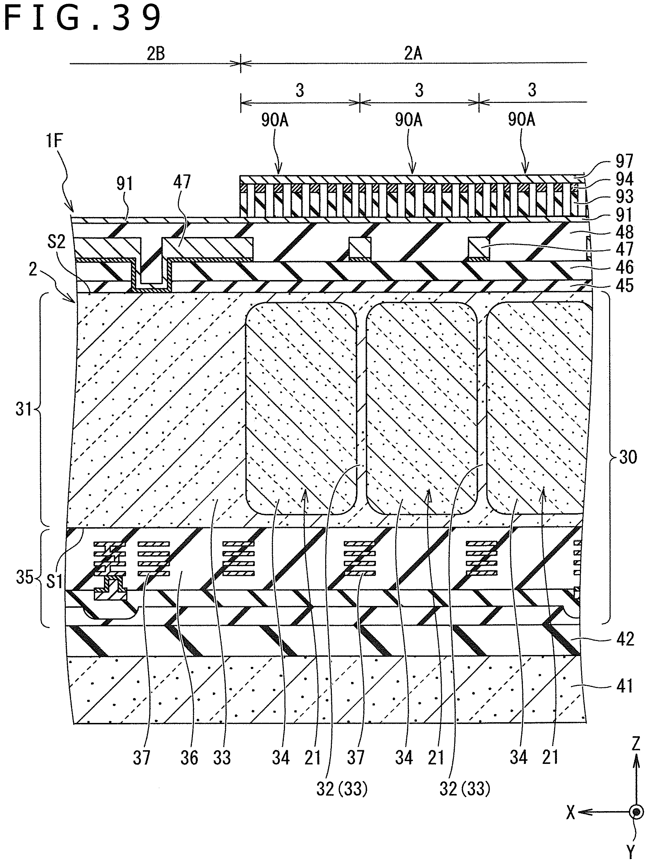

FIG. 39 is a schematic vertical cross-sectional view depicting a schematic configuration of the pixel array section and the periphery of a solid-state image capturing device according to a fifteenth embodiment of the present technology.
[FIG. 40]

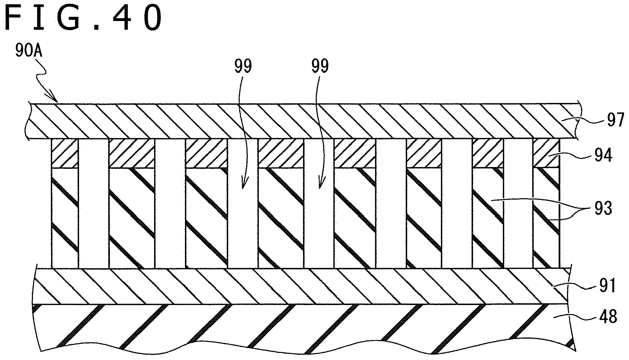

FIG. 40 is a main-section enlarged schematic vertical cross-sectional view of a metasurface structure in FIG. 39.
[FIG. 41]

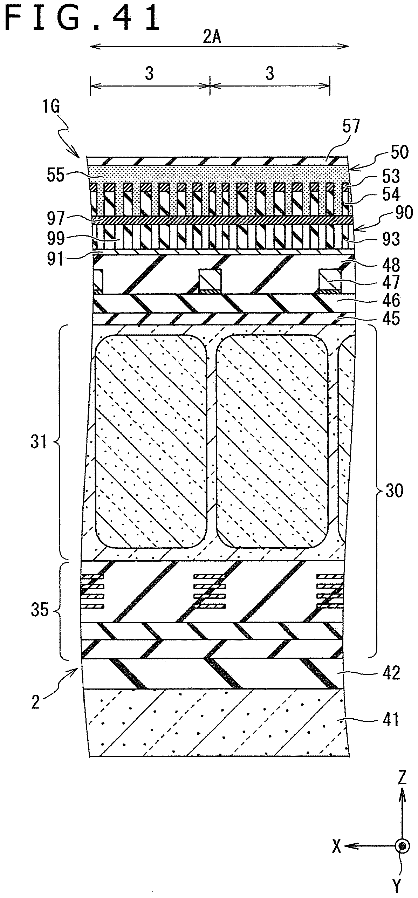

FIG. 41 is a schematic vertical cross-sectional view depicting a schematic configuration of the pixel array section and the periphery of a solid-state image capturing device according to a sixteenth embodiment of the present technology.
[FIG. 42]

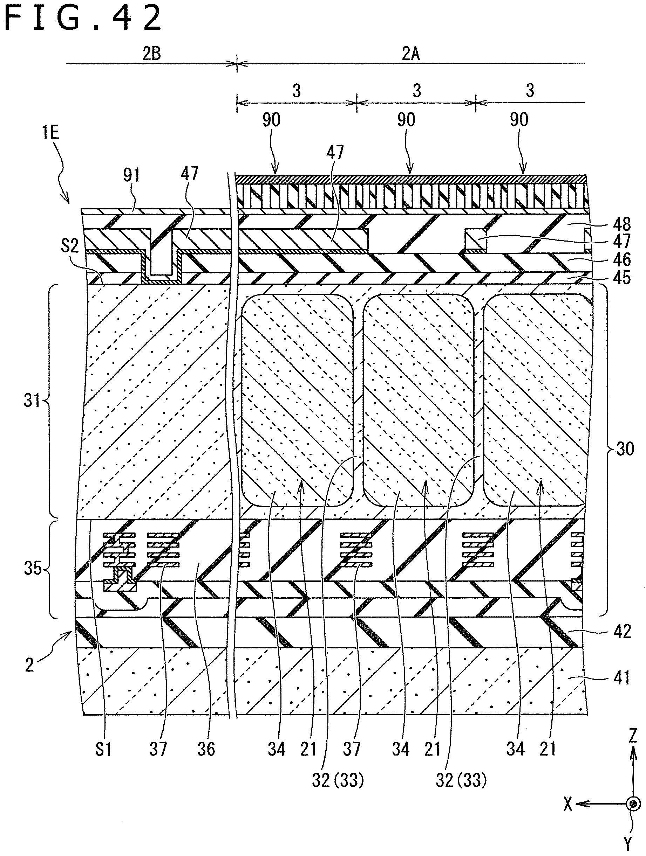

FIG. 42 is a schematic vertical cross-sectional view depicting a schematic configuration of a pixel array section and the periphery of the solid-state image capturing device according to a seventeenth embodiment of the present technology.
[FIG. 43]

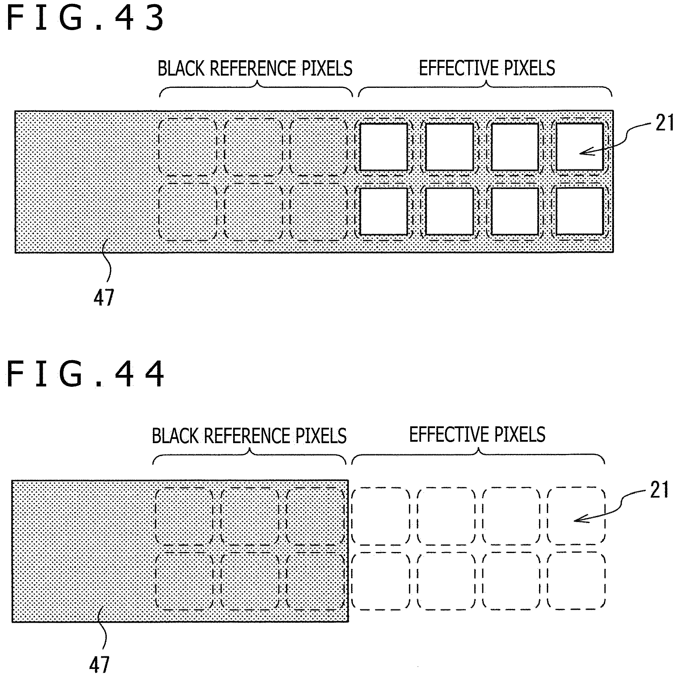

FIG. 43 is a plan view depicting a configuration example of a light blocking film in FIG. 42.
[FIG. 44]
FIG. 44 is a plan view (No. 1) depicting a modification example of the light blocking film.
[FIG. 45]

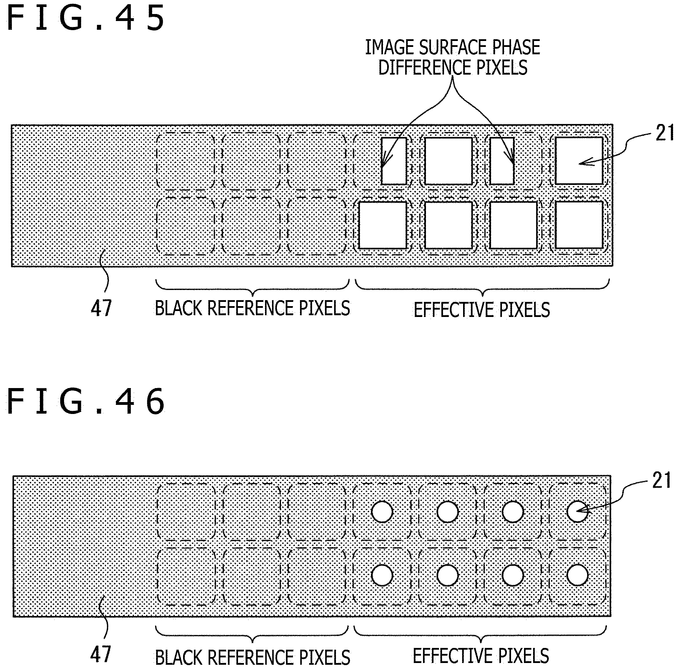

FIG. 45 is a plan view (No. 2) depicting a modification example of the light blocking film.
[FIG. 46]
FIG. 46 is a plan view (No. 3) depicting a modification example of the light blocking film.
[FIG. 47]

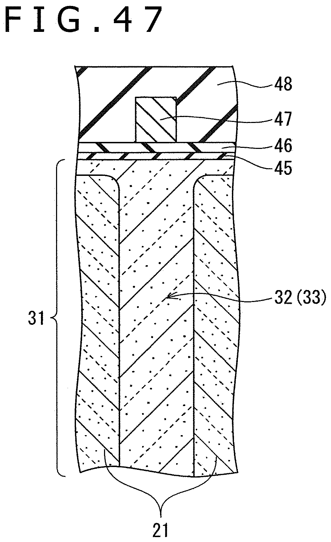

FIG. 47 is a vertical cross-sectional view depicting a configuration example of separation regions in FIG. 42.
[FIG. 48]

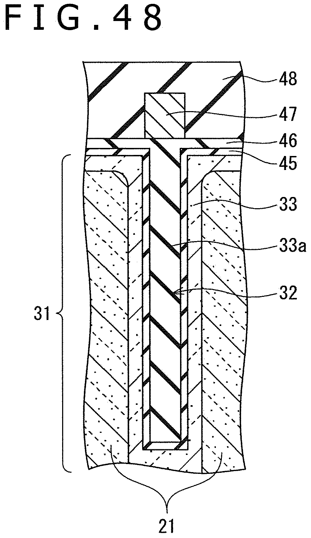

FIG. 48 is a vertical cross-sectional view (No. 1) depicting a modification example of the separation regions.
[FIG. 49]

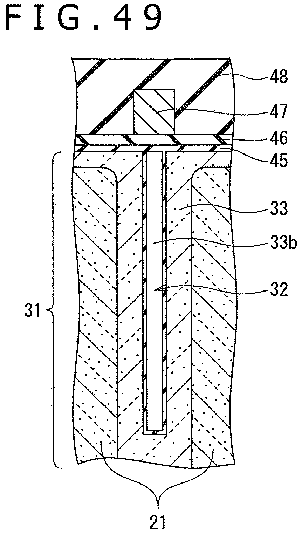

FIG. 49 is a vertical cross-sectional view (No. 2) depicting a modification example of the separation regions.
[FIG. 50]

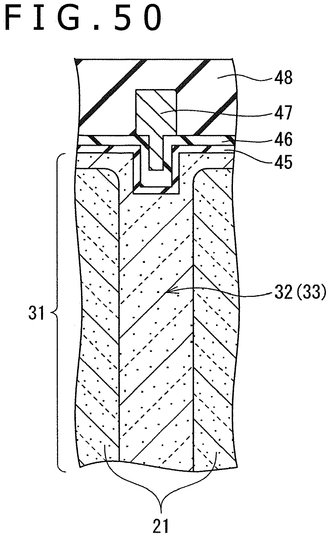

FIG. 50 is a vertical cross-sectional view (No. 3) depicting a modification example of the separation regions.
[FIG. 51]

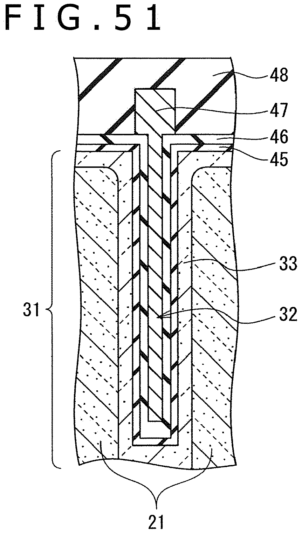

FIG. 51 is a vertical cross-sectional view (No. 4) depicting a modification example of the separation regions.
[FIG. 52]

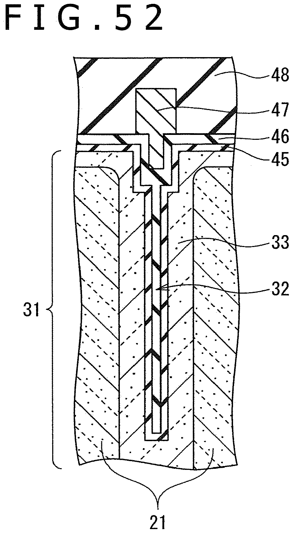

FIG. 52 is a vertical cross-sectional view (No. 5) depicting a modification example of the separation regions.
[FIG. 53]

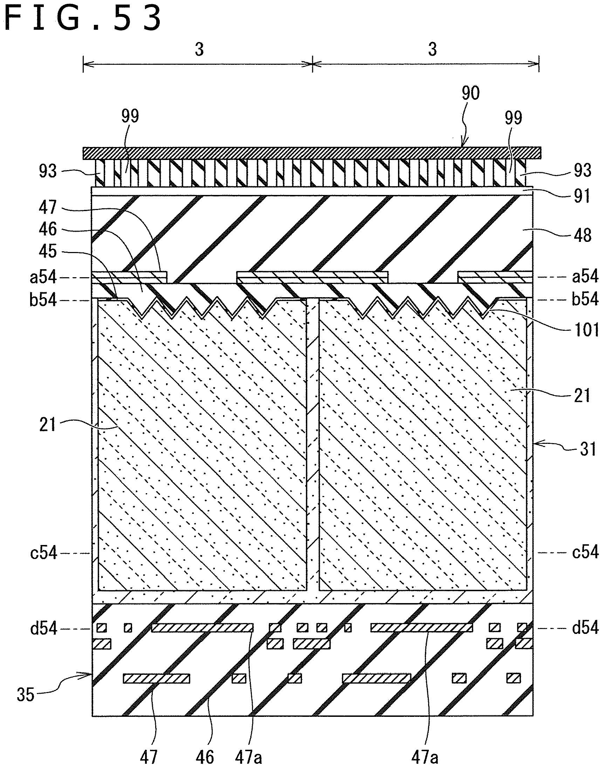

FIG. 53 is a schematic vertical cross-sectional view depicting a schematic configuration of a pixel array section of the solid-state image capturing device according to an eighteenth embodiment of the present technology.
[FIG. 54A]

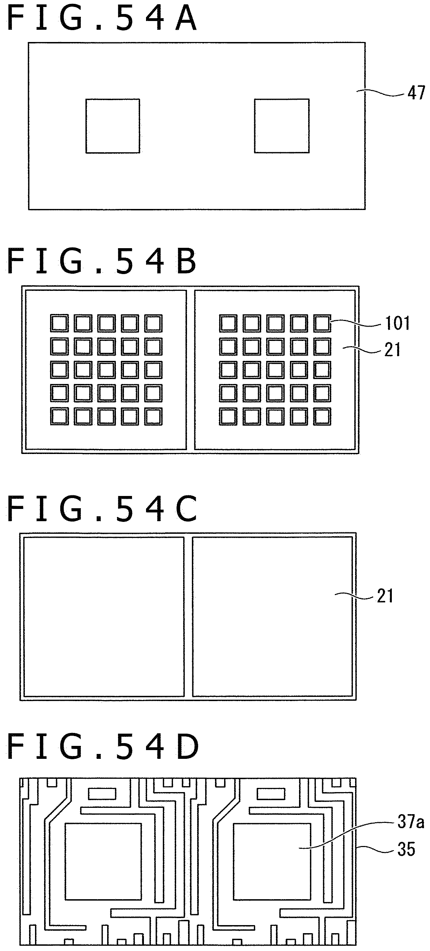

FIG. 54A is a figure depicting a horizontal cross-sectional structure along a line a54-a54 in FIG. 53.
[FIG. 54B]
FIG. 54B is a figure depicting a horizontal cross-sectional structure along a line b54-b54 in FIG. 53.
[FIG. 54C]
FIG. 54C is a figure depicting a horizontal cross-sectional structure along a line c54-c54 in FIG. 53.

[FIG. 54D]
FIG. 54D is a figure depicting a horizontal cross-sectional structure along a line d54-d54 in FIG. 53.
[FIG. 55]

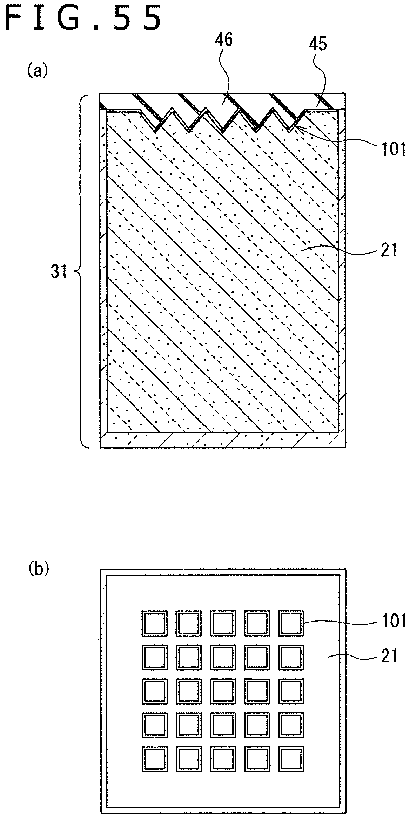

FIG. 55 depicts figures depicting a diffraction/scattering element provided on an interface on the light incidence surface side of a semiconductor layer.
[FIG. 56]

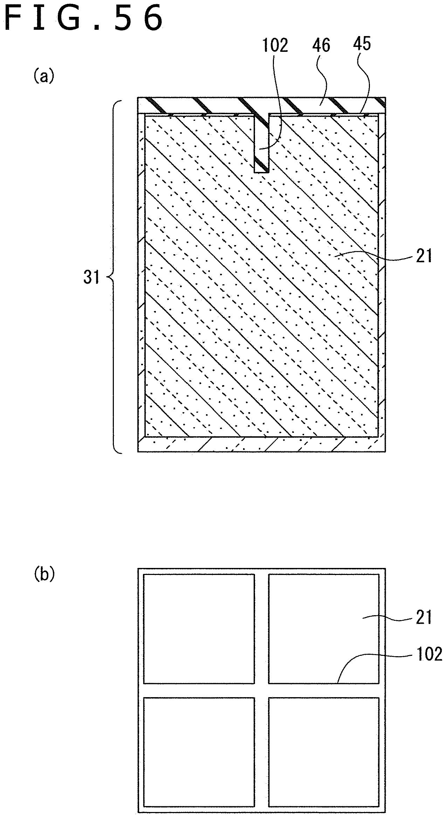

FIG. 56 depicts figures (No. 1) depicting a light splitting section provided on the interface on the light incidence surface side of the semiconductor layer.
[FIG. 57]

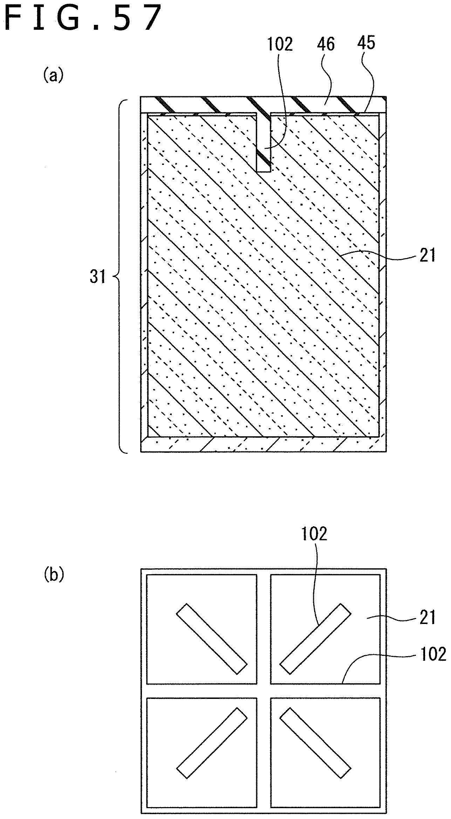

FIG. 57 depicts figures (No. 2) depicting the light splitting section provided on the interface on the light incidence surface side of the semiconductor layer.
[FIG. 58]

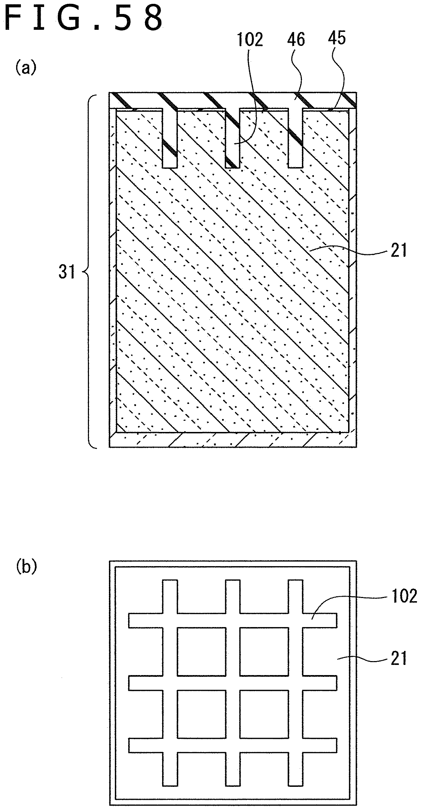

FIG. 58 depicts figures (No. 3) depicting the light splitting section provided on the interface on the light incidence surface side of the semiconductor layer.
[FIG. 59]

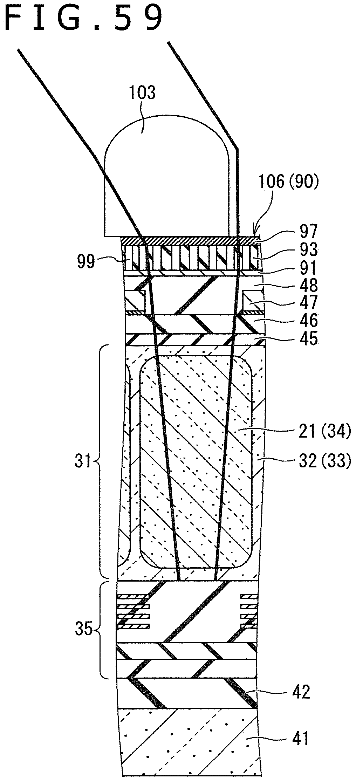

FIG. 59 is a main-section schematic vertical cross-sectional view depicting a combination of a deflecting section with a prism functionality (metasurface structure) and an on-chip lens in an optical detecting device according to a nineteenth embodiment of the present technology.
[FIG. 60]

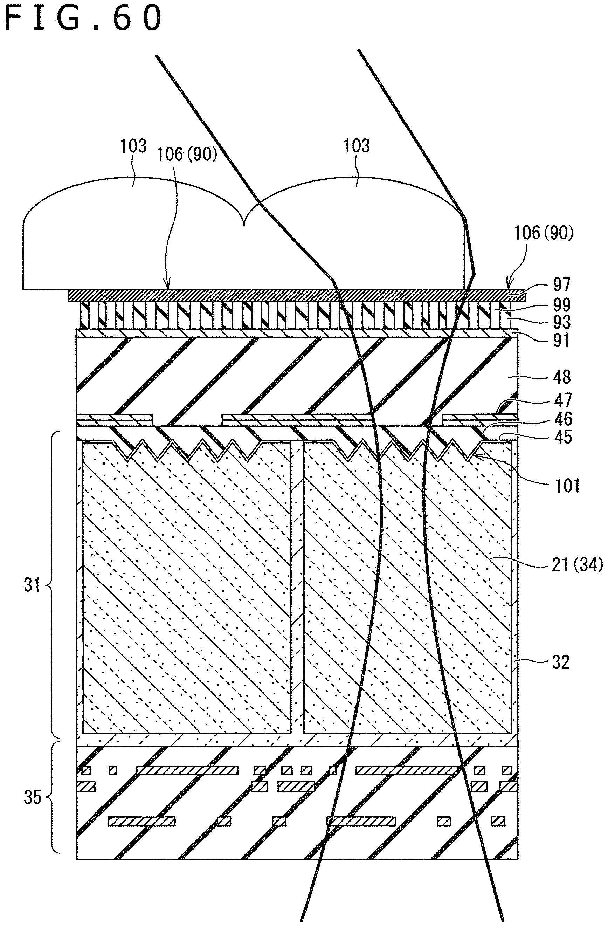

FIG. 60 is a main-section schematic vertical cross-sectional view depicting a combination of the deflecting section combining the prism functionality and a lens functionality and the on-chip lens.
[FIG. 61]

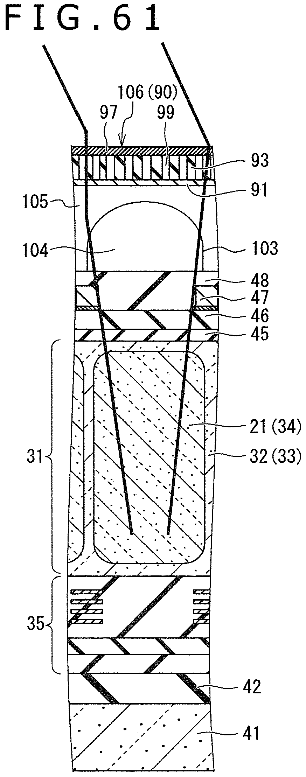

FIG. 61 is a main-section schematic vertical cross-sectional view depicting a combination of the deflecting section with the prism functionality (metasurface structure) and an inner lens.
[FIG. 62]

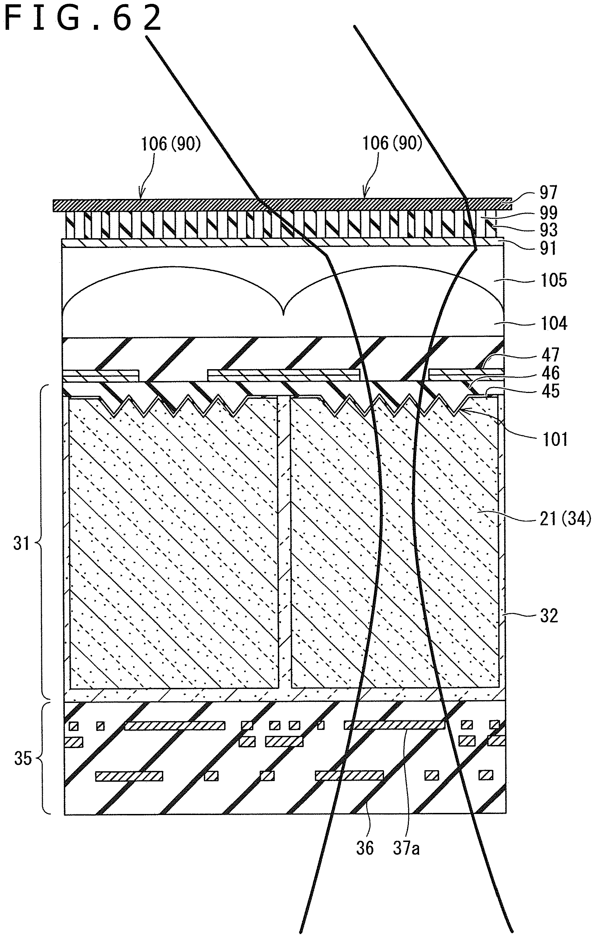

FIG. 62 is a main-section schematic vertical cross-sectional view depicting a combination of the deflecting section combining the prism functionality (metasurface structure) and the lens functionality and the inner lens.
[FIG. 63]

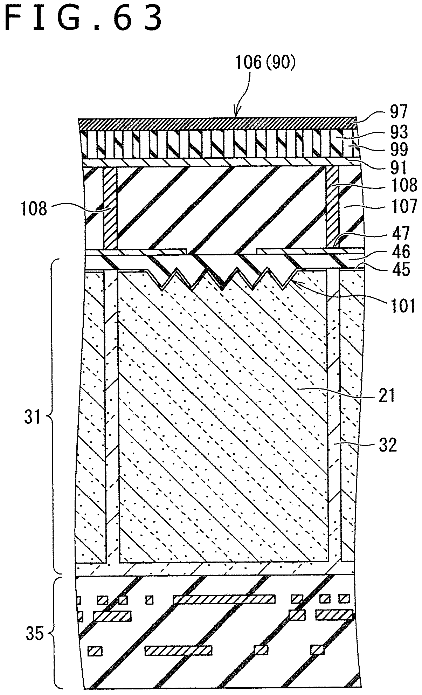

FIG. 63 is a main-section schematic vertical cross-sectional view (No. 1) depicting a configuration of light blocking walls in an optical detecting device according to a twentieth embodiment of the present technology.
[FIG. 64]

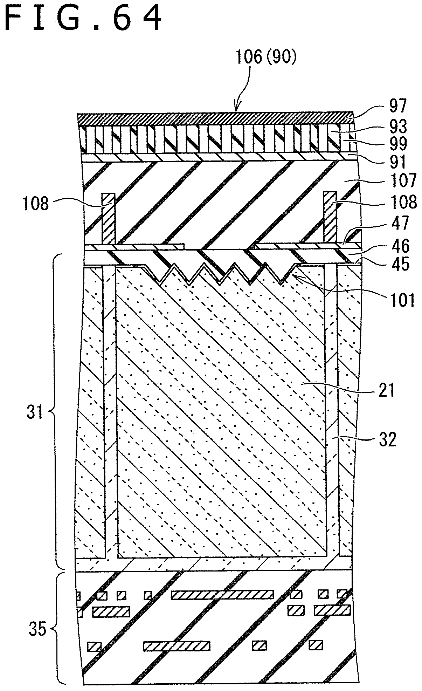

FIG. 64 is a main-section schematic vertical cross-sectional view (No. 2) depicting the configuration of the light blocking walls.
[FIG. 65]

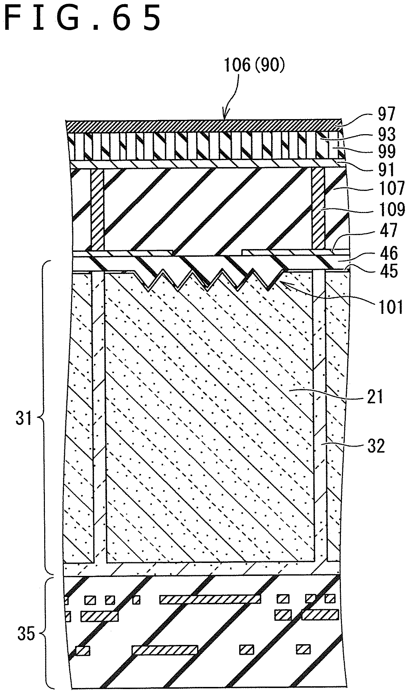

FIG. 65 is a main-section schematic vertical cross-sectional view (No. 3) depicting the configuration of the light blocking walls.
[FIG. 66]

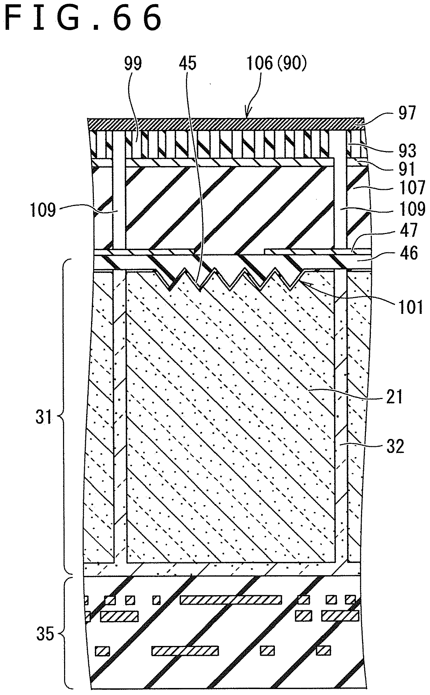

FIG. 66 is a main-section schematic vertical cross-sectional view (No. 4) depicting the configuration of the light blocking walls.
[FIG. 67]

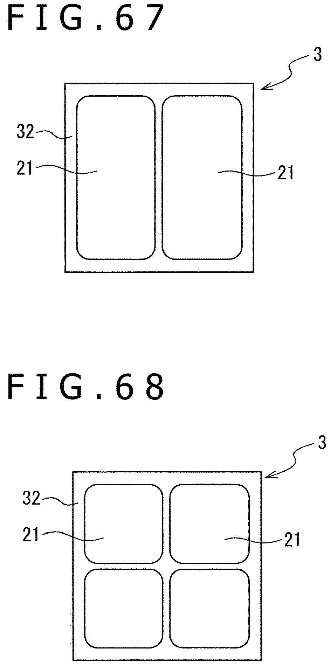

FIG. 67 is a plan view (No. 1) depicting a configuration of division of a photoelectric converting section in an optical detecting device according to a twenty-first embodiment of the present technology.
[FIG. 68]
FIG. 68 is a plan view (No. 2) depicting the configuration of division of the photoelectric converting section.
[FIG. 69]

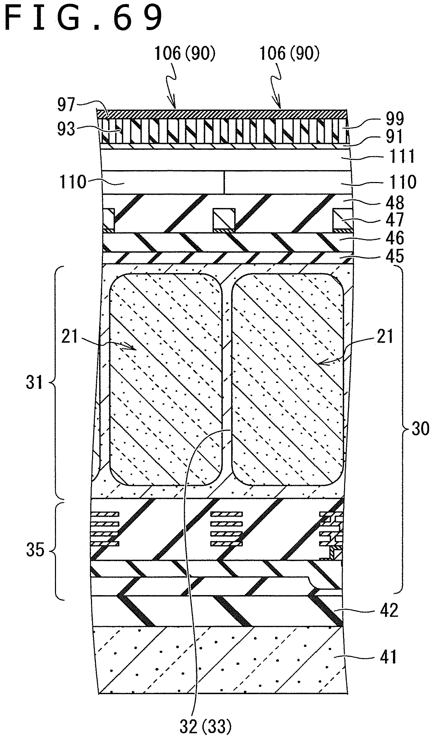

FIG. 69 is a main-section schematic vertical cross-sectional view depicting an example of a configuration in which color filters including generally used pigments or dyes are provided on deflecting sections in an optical detecting device according to a twenty-second embodiment of the present technology.
[FIG. 70]

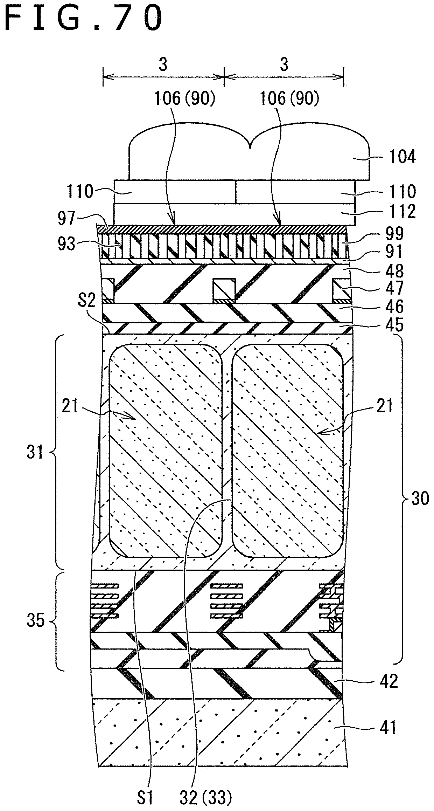

FIG. 70 is a main-section schematic vertical cross-sectional view depicting an example of a configuration in which the color filters are provided on the deflecting sections.
[FIG. 71]

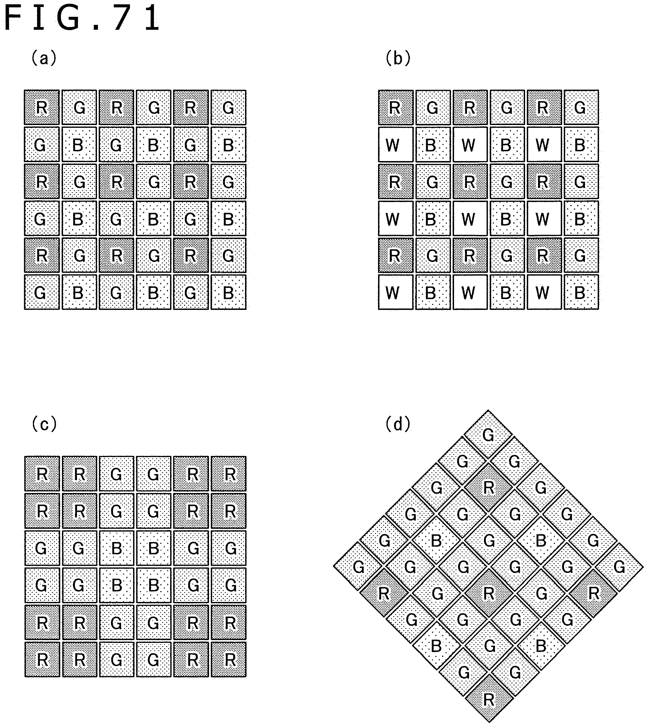

FIG. 71 depicts plan views depicting array examples of color filters.
[FIG. 72]

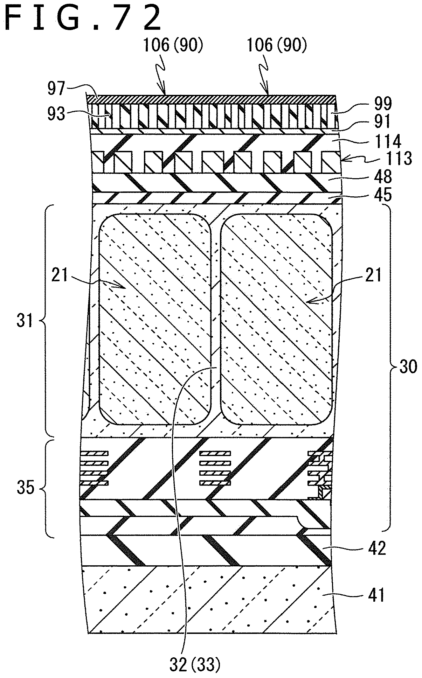

FIG. 72 is a main-section schematic vertical cross-sectional view depicting a combination with a plasmon filter.
[FIG. 73]

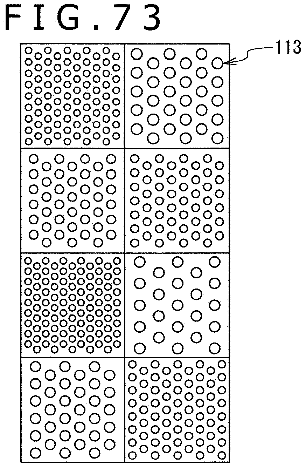

FIG. 73 is a schematic plan view of the plasmon filter.
[FIG. 74]

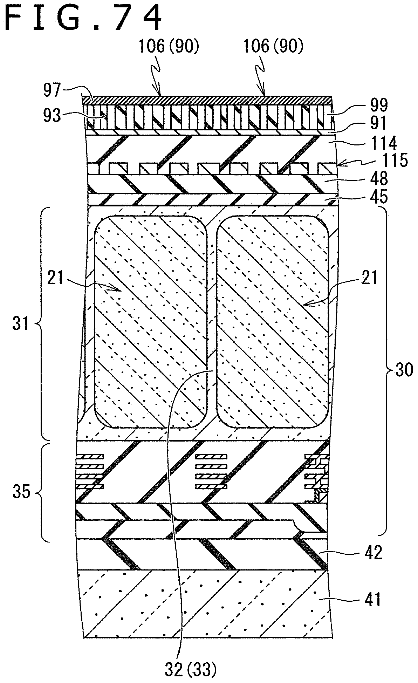

FIG. 74 is a main-section schematic vertical cross-sectional view depicting a combination with a GMR filter.

[FIG. 75]

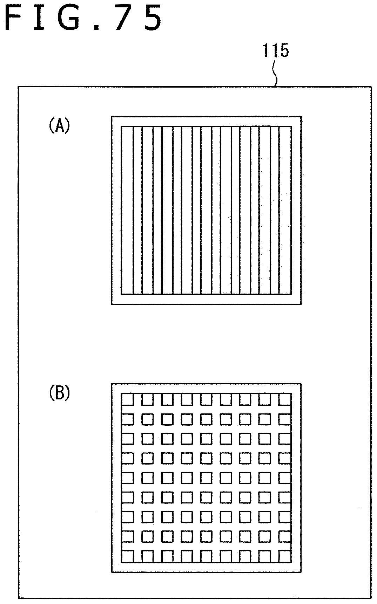

FIG. 75 is a schematic plan view depicting a diffraction grating of the GMR filter and a clad-core structure.

[FIG. 76]

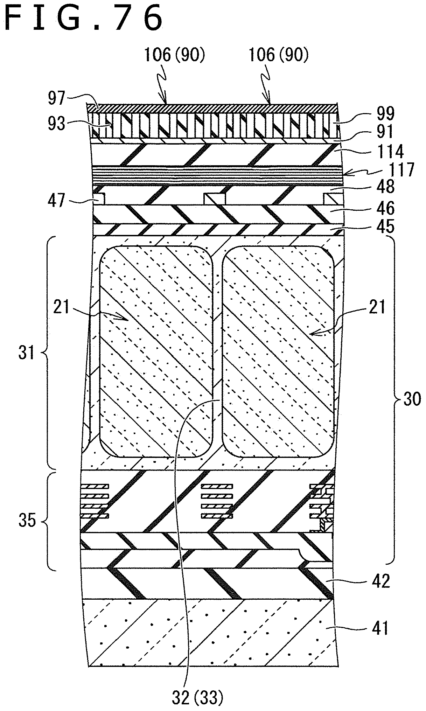

FIG. 76 is a main-section schematic vertical cross-sectional view depicting a combination with a stacked filter having different refractive indices.

[FIG. 77]

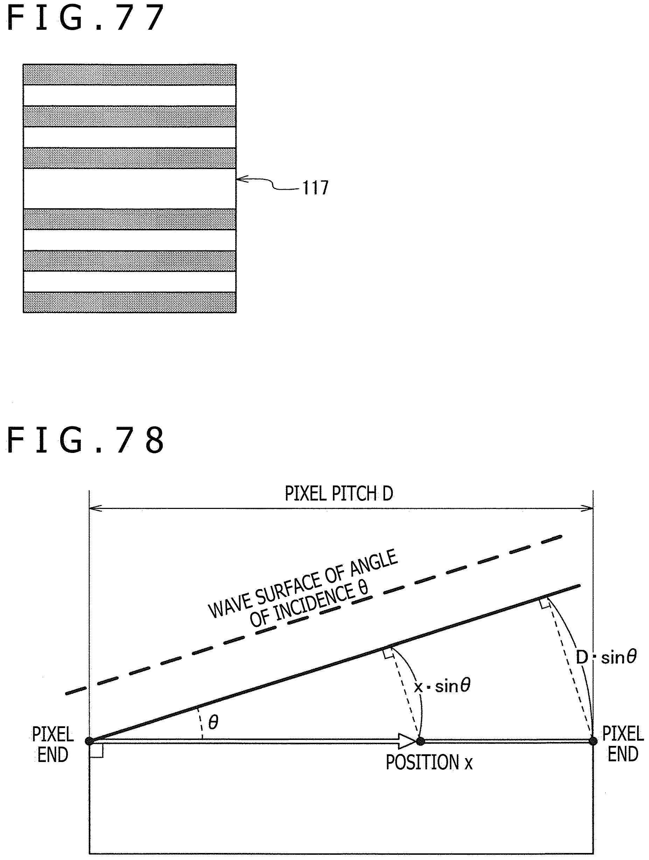

FIG. 77 is an enlarged view of a part of the stacked filter having the different refractive indices.

[FIG. 78]

FIG. 78 is a figure depicted for explaining a phase difference necessary for vertical input.

[FIG. 79]

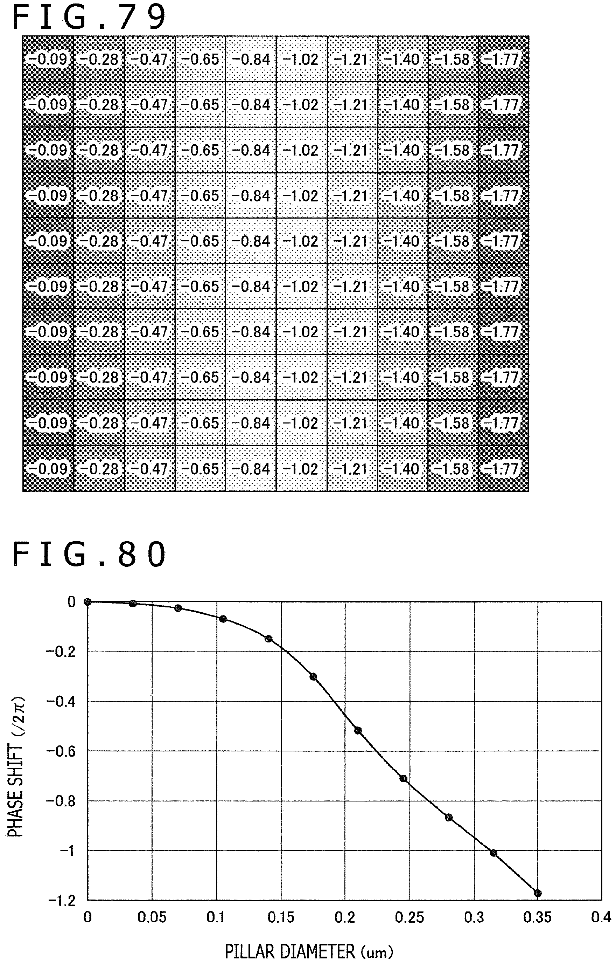

FIG. 79 is a figure depicting a phase difference map corresponding to prism angles in a certain direction.

[FIG. 80]

FIG. 80 is a characteristics diagram depicting a phase difference library associating phase differences and pillar diameters.

[FIG. 81]

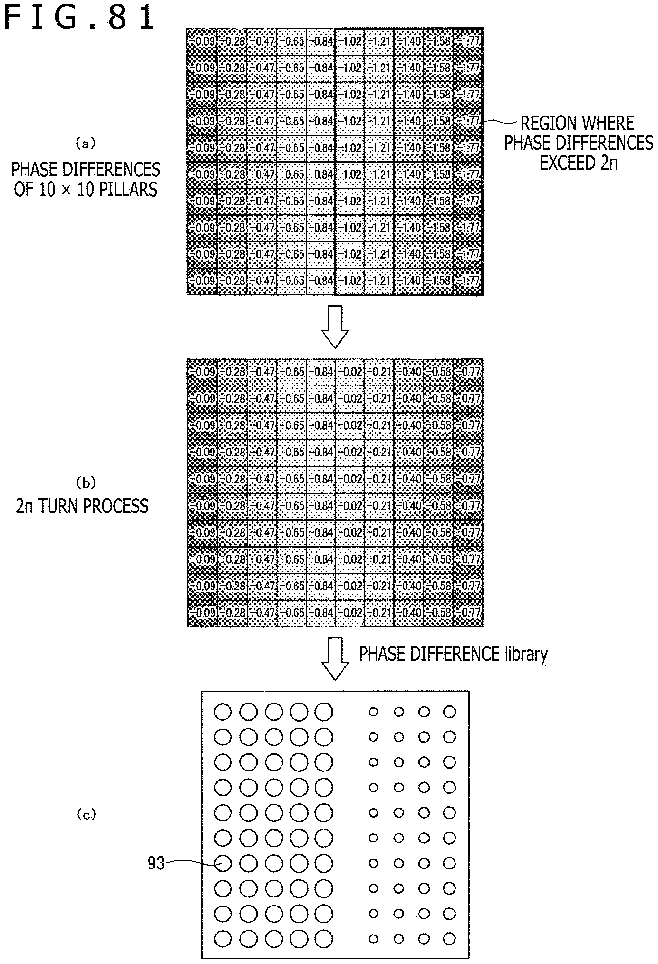

FIG. 81 is a figure depicted for explaining a process of replacing the phase difference of each pillar with a pillar diameter.

[FIG. 82]

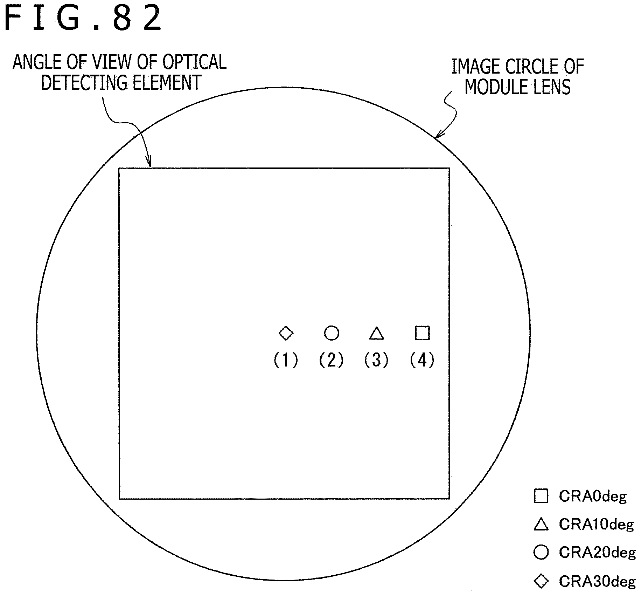

FIG. 82 is a plan view depicting the angle of view of a photodetector.

[FIG. 83]

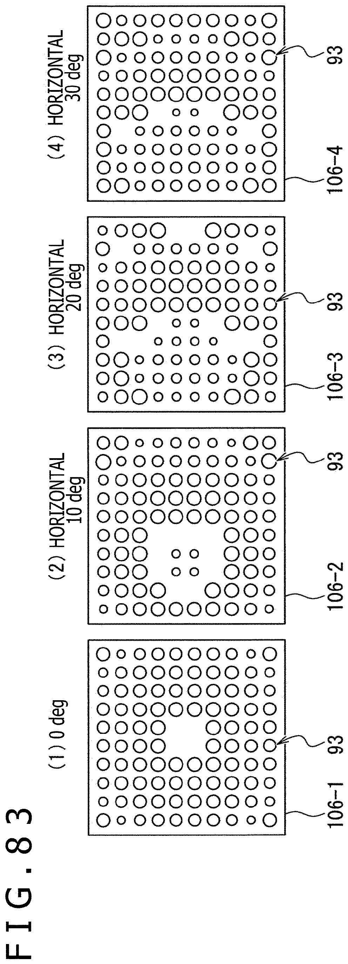

FIG. 83 is a plan view depicting an arrangement example of pillars for each image height.

[FIG. 84]

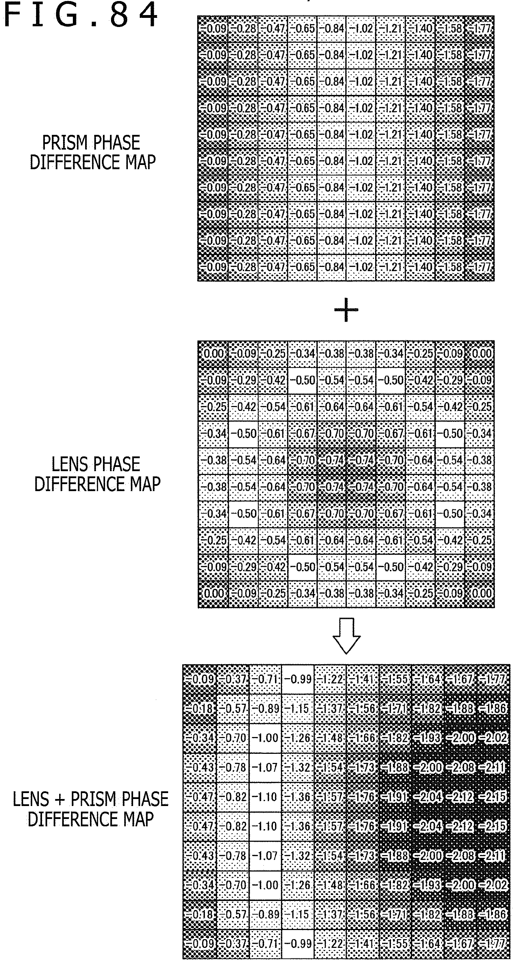

FIG. 84 is a figure depicting a phase difference map combining the lens functionality and the prism functionality.

[FIG. 85]

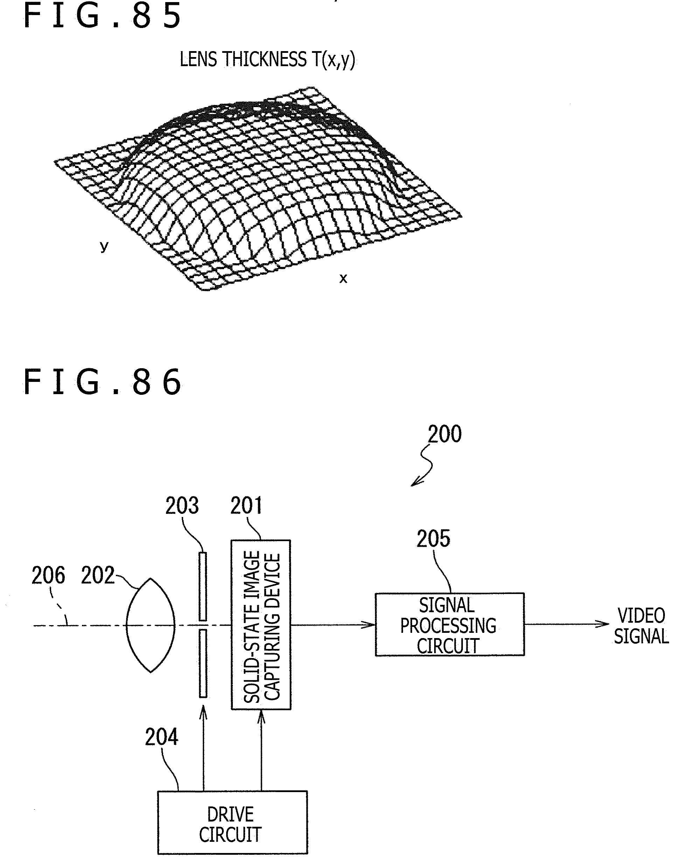

FIG. 85 is a figure depicted for explaining a lens phase difference map.

[FIG. 86]

FIG. 86 is a figure depicting a schematic configuration of electronic equipment according to a twenty-third embodiment of the present technology.

[FIG. 87]

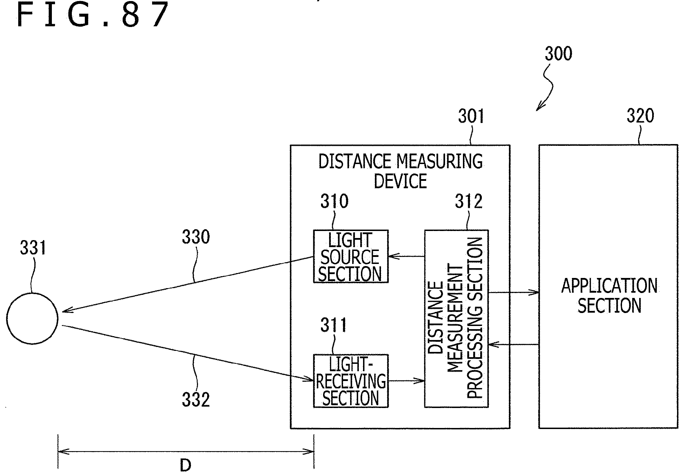

FIG. 87 is a figure depicting a schematic configuration of electronic equipment according to a twenty-fourth embodiment of the present technology.

[Description of Embodiments]

Hereinbelow, embodiments of the present technology are explained in detail with reference to the figures.

Note that, in the descriptions of the figures that are referred to in the explanation below, identical or similar portions are given identical or similar reference signs. However, it should be noted that the figures are schematic figures and that the relations between thicknesses and plane dimensions, the ratios between the thicknesses of respective layers, and the like are different from actual ones. Accordingly, specific thicknesses and dimensions should be decided by taking the explanation below into consideration.

In addition, needless to say, portions depicted in different figures include portions with dimensions having different relations or ratios. In addition, advantages described in the present specification are merely illustrative and not limitative, and there may be other advantages.

In addition, it is assumed that the state of being transparent in the present specification is defined as meaning a state where the transmittance of a subject member for the wavelength region of light that is expected to be received by an optical detecting device is close to 100%. For example, even if a material itself absorbs light in an expected wavelength region, the member is transparent if the member is processed to be very thin and the transmittance is close to 100%. For example, in a case of an optical detecting device used for the near-infrared region, even if a member absorbs a large portion of light in the visible region, the member can be said to be transparent if its transmittance for the near-infrared region is close to 100%. Alternatively, it is assumed that, even if there is a certain amount of absorbed components or reflected components, a member can be regarded as being transparent if the influence of the absorption is only to the extent that can be tolerated in view of sensitivity specifications of the optical detecting device.

In addition, the following embodiments illustrate devices and methods for embodying the technical idea of the present technology, and do not specify their configuration as being the configuration described below. That is, the technical idea of the present technology can be changed in various manners within the technical scope described in claims.

In addition, definitions of directions such as the up-down direction in the explanation below are definitions that are used simply for convenience of explanation, and do not limit the technical idea of the present technology. For example, needless to say, if a subject object is observed after being rotated 90°, the up-down direction described in an explanation of the subject object is interpreted as meaning the left-right direction, and if the subject object is observed after being rotated 180°, the up-down direction described in an explanation of the subject object is interpreted as meaning an inverted direction.

In addition, three directions that are orthogonal to each other in a space are described in the following embodiments. A first direction and a second direction that are orthogonal to each other on the same plane are treated as an X direction and a Y direction, respectively, and a third direction orthogonal to both the first direction and the second direction is treated as a Z direction. Further, in the following embodiments, the thickness direction of a semiconductor layer described later is explained as being the Z direction.

[First Embodiment]

In a first embodiment, an example in which the present technology is applied to a solid-state image capturing device which is a backside illumination CMOS (Complementary Metal Oxide Semiconductor) image sensor as an optical detecting device is explained.

<<Overall Configuration of Solid-State Image Capturing Device>>

First, an overall configuration of a solid-state image capturing device 1A is explained.

As depicted in FIG. 1, the solid-state image capturing device 1A according to the first embodiment of the present technology includes, as its main body, a semiconductor chip 2 whose shape on a two-dimensional plane when seen in a plan view is rectangular. That is, the solid-state image capturing device 1A is mounted on the semiconductor chip 2. As depicted in FIG. 86, the solid-state image capturing device 1A (201) takes in image light (incident light 206) from a subject through an optical lens 202, converts the light amount, at each pixel, of the incident light 206 whose image is formed on the image capturing surface into an electric signal, and outputs the electric signals as pixel signals.

As depicted in FIG. 1, on a two-dimensional plane including the mutually orthogonal X direction and Y direction, the semiconductor chip 2 having the solid-state image capturing device 1A mounted thereon includes a rectangular pixel array section 2A provided at the middle and a periphery 2B provided in such a manner as to surround the pixel array section 2A outside the pixel array section 2A.

The pixel array section 2A is a light reception surface that receives light condensed by the optical lens (optical system) 202 depicted in FIG. 86, for example. Further, the pixel array section 2A includes multiple pixels 3 that are arranged in a matrix (in an array) on the two-dimensional plane including the X direction and the Y direction. Stated differently, the pixels 3 are arranged repetitively in each of the X direction and the Y direction, which are mutually orthogonal on the two-dimensional plane.

As depicted in FIG. 1, multiple bonding pads 14 are arranged in the periphery 2B. Each of the multiple bonding pads 14 is arrayed along each side of the four sides of the semiconductor chip 2 on the two-dimensional plane, for example. Each of the multiple bonding pads 14 is an input/output terminal to be used when the semiconductor chip 2 is electrically connected with an external device.

As depicted in FIG. 2, the semiconductor chip 2 (solid-state image capturing device 1A) includes the pixel array section 2A, a vertical drive section 4, a column signal processing section 5, and a control section 8. The pixel array section 2A includes the pixels 3 that are arranged in a two-dimensional grid. Here, each pixel 3 generates an image signal according to applied light. The pixel 3 has a photoelectric converting section 21 (see FIG. 3) that generates charge according to applied light. In addition, the pixel 3 further has a pixel circuit 29 depicted in FIG. 3. The pixel circuit 29 generates an image signal based on the charge generated by the photoelectric converting section 21. The generation of the image signal is controlled by a control signal generated by the vertical drive section 4 described later.

As depicted in FIG. 2, the pixel array section 2A has signal lines 11 and 12 that are arranged in an XY matrix. The signal lines 11 are signal lines that transmit control signals of the pixel circuits 29 (see FIG. 3) in the pixels 3. Each signal line 11 is arranged for one row of the pixel array section 2A. The signal lines 11 are placed such that pixels 3 arranged in each row share a signal line 11. The signal lines 12 are signal lines that transmit image signals generated by the pixel circuits 29 of the pixels 3. Each signal line 12 is arranged for one column of the pixel array section 2A. The signal lines 12 are placed such that pixels 3 arranged in each column share a signal line 12. The photoelectric converting sections 21 and the pixel circuits 29 are mounted on the semiconductor chip 2.

The vertical drive section 4 generates control signals for the pixel circuits 29 of the pixels 3. The vertical drive section 4 transmits the generated control signals to the pixels 3 through the signal lines 11.

The column signal processing section 5 processes image signals generated by the pixels 3. The column signal processing section 5 performs processes on the image signals transmitted from the pixels 3 through the signal lines 12. One of the processes in the column signal processing section 5 is analog-digital conversion in which analog image signals generated at the pixels 3 are converted into digital image signals, for example. The image signals processed by the column signal processing section 5 are output as image signals of the solid-state image capturing device 1A.

The control section 8 performs the overall control of the solid-state image capturing device 1A. The control section 8 controls the solid-state image capturing device 1A by generating and outputting control signals for controlling the vertical drive section 4 and the column signal processing section 5. The control signals generated by the control section 8 are transmitted to the vertical drive section 4 and the column signal processing section 5 by signal lines 8a and 8b, respectively.

Note that the vertical drive section 4, the column signal processing section 5, and the control section 8 are collectively called a logic circuit in some cases.

As depicted in FIG. 3, each pixel 3 includes the photoelectric converting section 21 and the pixel circuit 29. The pixel circuit 29 includes a charge retaining section 22 and MOS transistors 23 to 26.

An anode of the photoelectric converting section 21 is grounded, and a cathode of the photoelectric converting section 21 is connected to a source of the MOS transistor 23. A drain of the MOS transistor 23 is connected to a source of the MOS transistor 24, a gate electrode of the MOS transistor 25, and one end of the charge retaining section 22. The other end of the charge retaining section 22 is grounded.

Drains of the MOS transistors 25 and 26 share and are connected to a power line Vdd, and a source of the MOS transistor 25 is connected to the drain of the MOS transistor 26. A source of the MOS transistor 26 is connected to an output signal line OUT. Gate electrodes of the MOS transistors 23, 24, and 26 are connected to a transfer signal line TR, a reset signal line RST, and a selection signal line SEL, respectively.

Note that the transfer signal line TR, the reset signal line RST, and the selection signal line SEL are included in the signal line 11. In addition, the output signal line OUT is included in the signal line 12. The photoelectric converting section 21 generates a charge according to applied light as described before. A photodiode can be used as the photoelectric converting section 21, for example. In addition, the charge retaining section 22 and the MOS transistors 23 to 26 are included in the pixel circuit 29.

The MOS transistor 23 is a transistor that transfers the charge generated by the photo-electric conversion by the photoelectric converting section 21 to the charge retaining section 22. The transfer of the charge by the MOS transistor 23 is controlled by a signal transmitted by the transfer signal line TR.

The charge retaining section 22 is a capacitor that retains the charge transferred by the MOS transistor 23. The MOS transistor 25 is a transistor that generates a signal based on the charge retained in the charge retaining section 22. The MOS transistor 26 is a transistor that outputs, as an image signal, the signal generated by the MOS transistor 25 to the output signal line OUT. The MOS transistor 26 is controlled by a signal transmitted by the selection signal line SEL.

The MOS transistor 24 is a transistor that resets the charge retaining section 22 by discharging the charge retained in the charge retaining section 22 to the power line Vdd. The resetting by the MOS transistor 24 is controlled by a signal transmitted by the reset signal line RST, and is executed before the transfer of the charge by the MOS transistor 23.

Note that, by making the MOS transistor 23 conductive at the time of the resetting, the photoelectric converting section 21 can also be reset. In such a manner, the pixel circuit 29 converts the charge generated by the photoelectric converting section 21 into the image signal.

Note that each of the MOS transistors 23 to 26 includes the gate insulating film, the gate electrode, and a pair of main electrode regions that function as a source region and a drain region, and is a field-effect transistor whose gate insulating film is formed by use of a silicon oxide film. Instead of the MOS transistors, MIS transistors may be used.

<<Specific Configuration of Solid-State Image Capturing Device>>

Next, a specific configuration of the solid-state image capturing device 1A is explained.

As depicted in FIG. 4, the semiconductor chip 2 includes a semiconductor base 30 and a support substrate 41 provided on a side opposite to the light incidence surface side of the semiconductor base 30.

<Semiconductor Base>

The semiconductor base 30 includes a semiconductor layer 31 on which multiple photoelectric converting sections 21 are provided and a multilayer wiring layer 35 provided on the side of a first surface S1 among the first surface S1 and a second surface S2 that are positioned opposite to each other in the thickness direction of the semiconductor layer 31.

In addition, the semiconductor base 30 further includes a fixed electric charge film 45, an insulating film 46, a light blocking film 47, and an insulating film 48 that are stacked on the second surface S2 side of the semiconductor layer 31 sequentially from the second surface S2 side.

In addition, the semiconductor base 30 further includes metasurface structures 50 provided on the second surface S2 side of the semiconductor layer 31 and on a side opposite to the semiconductor layer 31 side relative to the second surface S2 side of the semiconductor layer 31.

Here, the first surface S1 of the semiconductor layer 31 is called an element formation surface or a main surface, and the second surface S2 of the semiconductor layer 31 is called a light incidence surface or a back surface, in some cases. The solid-state image capturing device 1A of the first embodiment photoelectrically converts, at the photoelectric converting sections 21 provided on the semiconductor layer 31, light incident from the second surface S2 side (the light incidence surface side, the back surface side) of the semiconductor layer 31.

In addition, the plan view means a view as seen in a direction along the thickness direction (Z direction) of the semiconductor layer 31.

<Semiconductor Layer>

As depicted in FIG. 4, a first-conductivity-type, p-type in the first embodiment, semiconductor region 33 and second-conductivity-type, n-type in the first embodiment, semiconductor regions 34 are provided on the semiconductor layer 31. For example, an Si substrate, an SiGe substrate, an InGaAs substrate, or the like can be used as the semiconductor layer 31. For example, an Si substrate is used in the first embodiment. The semiconductor layer 31 is provided over the pixel array section 2A and the periphery 2B.

As depicted in FIG. 4, the p-type semiconductor region 33 is provided over the entire region in the thickness direction (Z direction) of the semiconductor layer 31, stated differently, over the second surface S2 and the first surface S1 of the semiconductor layer 31. Further, in the plan view, the p-type semiconductor region 33 is provided over the entire region of the pixel array section 2A and is provided over the pixel array section 2A and the periphery 2B.

An n-type semiconductor region 34 is provided for each pixel 3 in the p-type semiconductor region 33 and is provided over the second surface S2 side and the first surface S1 side of the semiconductor layer 31. That is, at its top surface on the second surface S2 side of the semiconductor layer 31, its bottom surface on the first surface S1 side of the semiconductor layer 31, and its side surface, the n-type semiconductor region 34 is surrounded by the p-type semiconductor region 33.

Here, the photoelectric converting sections 21 described above mainly include the n-type semiconductor regions 34, and are formed as pn-junction photodiodes including the p-type semiconductor region 33 and the n-type semiconductor regions 34.

The p-type semiconductor region 33 positioned on the top surface side and the bottom surface side of the n-type semiconductor regions 34 (photoelectric converting sections 21), stated differently, the p-type semiconductor region 33 facing the front and back surfaces of the semiconductor layer 31, doubles as a hole charge accumulating region for dark current reduction.

The p-type semiconductor region 33 positioned on the side surfaces of the n-type semiconductor regions 34 functions as separation regions 32 that electrically separate mutually adjacent n-type semiconductor regions 34. That is, the separation regions 32 of the first embodiment include the p-type semiconductor region 33. Further, the photoelectric converting sections 21 including the n-type semiconductor regions 34 are divided by the separation regions 32, and mutually adjacent photoelectric converting sections 21 are electrically separated. For example, a ground potential of 0 V is applied as a reference potential to the separation regions 32.

Here, although not depicted in FIG. 4, the MOS transistors 23 to 26 included in the pixel circuits 29 described above are formed on the first surface S1 side of the semiconductor layer 31. Whereas the MOS transistors 23 to 26 are provided for each pixel 3 in the first embodiment, they can also be shared by multiple pixels.

<Multilayer Wiring Layer>

As depicted in FIG. 4, the multilayer wiring layer 35 is provided on the first surface S1 side opposite to the light incidence surface side (second surface S2 side) of the semiconductor layer 31, and is formed by stacking wiring layers including wires 37 at multiple stages with an interlayer dielectric film 36 being interposed therebetween.

The multilayer wiring layer 35 transmits image signals generated by the pixels 3. In addition, the multilayer wiring layer 35 further transmits signals to be applied to the pixel circuits 29. Specifically, the multilayer wiring layer 35 is included in the signal lines explained with reference to FIG. 3 (the output signal lines OUT, the transfer signal lines TR, the reset signal lines RST, and the selection signal lines SEL) and the power lines Vdd. The multilayer wiring layer 35 and the pixel circuits 29 are connected to each other by via plugs. In addition, the wiring layers of the multilayer wiring layer 35 are also connected to each other by via plugs. The multilayer wiring layer 35 can be formed by use of metal such as aluminum (Al) or copper (Cu), for example. The via plugs can be formed by use of metal such as tungsten (W) or Cu, for example. For example, a silicon oxide film or the like can be used for the interlayer dielectric film 36 of the multilayer wiring layer 35.

The pixel transistors of each pixel 3 are driven via the wires 37 of the multilayer wiring layer 35. Since the multilayer wiring layer 35 is arranged on a side opposite to the light incidence surface side (the second surface S2 side)

of the semiconductor layer 31, the degree of freedom of placement of the wires 37 is improved. The multilayer wiring layer 35 is provided over the pixel array section 2A and the periphery 2B.

<Fixed Electric Charge Film>

As depicted in FIG. 4, the fixed electric charge film 45 is provided over the pixel array section 2A and the periphery 2B. The fixed electric charge film 45 has a negative fixed electric charge attained by an oxygen dipole, and plays a role of ensuring pinning. For example, the fixed electric charge film 45 can be formed by use of an oxide or a nitride including at least one of Hf, Al, zirconium, Ta, and Ti. In addition, the fixed electric charge film 45 can also be formed by use of an oxide or a nitride including at least one of lanthanum, cerium, neodymium, promethium, samarium, europium, gadolinium, terbium, dysprosium, holmium, thulium, ytterbium, lutetium, and yttrium. In addition, the fixed electric charge film 45 can also be formed by use of hafnium oxynitride or aluminum oxynitride. In addition, the fixed electric charge film 45 can also be doped with silicon or nitrogen in an amount that does not impair the insulation property. As a result, the heat-resistant property or the like can be improved. It is preferable that, by controlling the film thickness or stacking multiple layers, the fixed electric charge film 45 double as a reflection preventing film for the Si substrate having a high refractive index.

<Insulating Film>

As depicted in FIG. 4, the insulating film 46 is a film that is provided adjacent to the second surface S2 of the semiconductor layer 31, and insulates the semiconductor layer 31. For example, the insulating film 46 includes $SiO_2$, and insulates and also protects the back surface side (the second surface S2 side) of the semiconductor layer 31. The insulating film 46 is provided over the entire region of the pixel array section 2A, and further, may be provided over the pixel array section 2A and the periphery 2B.

<Light Blocking Film>

As depicted in FIG. 4, the light blocking film 47 is arranged on the semiconductor layer 31 side of the metasurface structures 50, is also arranged in regions overlapping the boundaries between pixels 3 in the plan view, and blocks stray light leaking from adjacent pixels 3. It is sufficient if the light blocking film 47 is a material that blocks light. For example, preferably, the light blocking film 47 is formed by use of a metal film of Al, W, copper, or the like as a material that has a high light blocking property and can be processed precisely by microprocessing, for example, etching. Other than these, the light blocking film 47 can be formed by use of silver, gold, platinum, Mo, Cr, Ti, nickel, iron, tellurium, or the like or an alloy including any of these pieces of metal. In addition, the light blocking film 47 can also be formed by stacking two or more of these materials. In order to enhance the adhesion with the underlying insulating film 46, a barrier metal, for example, Ti, Ta, W, Co, or Mo or an alloy, nitride, oxide, or carbide of any of these, may be provided under the light blocking film 47. In addition, the light blocking film 47 may double as light blocking barriers of pixels that determine the optical black level, and may double as light blocking barriers for preventing noise to peripheral circuit regions. Preferably, the light blocking film 47 is grounded in such a manner as not to be destroyed by plasma damage due to an accumulated charge during processing. The grounding structure may be formed in the pixel array, but the grounding structure may be provided in a region outside the effective region depicted in FIG. 4, after all conductors are electrically connected to each other. That is, as depicted in FIG. 4, the light blocking film 47 in the periphery 2B may be electrically connected with the p-type semiconductor region 33 in the semiconductor layer 31, in another possible manner of configuration. The light blocking film 47 is positioned between the light incidence surface side (the second surface S2 side) of the semiconductor layer 31 and the metasurface structures 50, and has openings at at least parts in the pixels 3.

<Insulating Film>

As depicted in FIG. 4, the insulating film 48 is a film arranged adjacent to the insulating film 46 and the light blocking film 47. The insulating film 48 insulates and also flattens the second surface S2 side (the back surface side, the light incidence surface side) of the semiconductor layer 31. For example, the insulating film 46 is formed by use of a silicon oxide film that excels in optical transmittance. The insulating film 48 is provided over the entire region of the pixel array section 2A, and may further be provided over the pixel array section 2A and the periphery 2B.

<Support Substrate>

As depicted in FIG. 4, the support substrate 41 is provided over the pixel array section 2A and the periphery 2B. The support substrate 41 is a substrate that reinforces and supports the semiconductor layer 31 and the like in steps of manufacturing the solid-state image capturing device 1A, and is formed by use of a silicon substrate or the like, for example. The support substrate 41 is bonded together with the semiconductor base 30 by plasma joining or by use of an adhesive material, and supports the semiconductor layer 31 and the like. The support substrate 41 may include the logic circuit, and it becomes possible to reduce the chip size by forming connection vias between the substrates and by vertically stacking various peripheral circuit functionalities.

<Warp Correction Film>

As depicted in FIG. 4, a warp correction film 42 for reducing warping of wafers when the semiconductor base 30 and the support substrate 41 are bonded together is provided on a side opposite to the semiconductor layer 31 side of the multilayer wiring layer 35. The warp correction film 42 covers the entire wafers.

<Metasurface Structures>

As depicted in FIG. 4, a metasurface structure 50 is provided for each pixel 3 on the light incidence surface side (the second surface S2 side) of the semiconductor layer 31, and guides incident light to the photoelectric converting section 21. That is, each pixel 3 includes the photoelectric converting section 21 provided on the semiconductor layer 31 and the metasurface structure 50 that is arranged on the light incidence surface side of the semiconductor layer 31 and that guides incident light to the photoelectric converting section 21. Further, the photoelectric converting section 21 photoelectrically converts the incident light guided by the metasurface structure 50.
As depicted in FIG. 4 and FIG. 5, the metasurface structures 50 of the first embodiment are provided on the light incidence surface side on a side opposite to the semiconductor layer 31 side relative to the second surface S2 side of the semiconductor layer 31. The metasurface structures 50 of the first embodiment include multiple pillars 54 that are arranged at distances therebetween which are shorter than the wavelength of incident light to be treated, on the light incidence surface side of the insulating film 48 and a transparent material 55 filling the spaces between mutually adjacent pillars 54. In addition, the metasurface structures 50 of the first embodiment may further include a reflection preventing film 51 provided on the semiconductor layer 31 side of the pillars 54, a reflection preventing film 53 provided on a side opposite to the semiconductor layer 31 side of the pillars 54, and a transparent protective film 57 provided on a side opposite to the semiconductor layer 31 side of the transparent material 55.
The metasurface structures 50 can be provided not only in the pixel array section 2A, but also in the periphery 2B. The purpose of the metasurface structures 50 in the periphery 2B is reflection prevention in such a manner as to avoid a situation where incident light from a module lens, stray light from a set housing, or the like is reflected by the periphery 2B, becomes flares or ghosts, and causes image quality deterioration. That is, this is done for a design principle which is different from the design principle of the pixel array section 2A for enhancing the pixel characteristics, and the layouts are determined in different manners, desirably. For example, in a case where an absorber such as carbon black is to be provided under the metasurface structures 50 in the periphery 2B, the metasurface structures 50 may be designed such that optical path lengths in the absorber for oblique incidence are increased and the absorption efficiency is enhanced. Alternatively, the metasurface structures 50 may be provided taking the whole of the set housing or the like into consideration such that the angle of reflection light from the periphery 2B becomes such an angle that the reflection light does not re-enter the pixel array section 2A.

<Reflection Preventing Film>

As depicted in FIG. 4 and FIG. 5, the reflection preventing film 51 is provided over the entire region of the pixel array section 2A, and may further be provided over the periphery 2B. In order to suppress reflection of light at a refractive index interface at the bottoms (the semiconductor layer 31 side) of the pillars 54, the reflection preventing film 51 has a film thickness taking into consideration what is generally called a $\lambda/(4n)$ rule where the expected wavelength of optical detection is $\lambda$ and the refractive index of the reflection preventing film is n. Further, a film having a different refractive index may be stacked in order to enhance the reflection preventing effect. Note that the reflection preventing film 51 may function as an etching stopper layer when a pillar forming film is processed by dry etching to form the pillars 54. The reflection preventing film 51 is formed by use of a material that can attain etching selectivity relative to the pillars 54.

<Pillars>

As depicted in FIG. 4 and FIG. 5, each of the multiple pillars 54 is processed into a columnar form, and extends upward from the top surface side of the reflection preventing film 51. Further, the multiple pillars 54 include pillars 54 having different thicknesses, array pitches, or shapes. FIG. 7 depicts an example of a plane layout pattern of multiple pillars 54 (a pillar group including multiple pillars 54). By including such a plane layout pattern (pillar group) of multiple pillars 54, the phase difference of light varies locally, and it becomes possible to control the direction of light according to the layout (arrangement pattern) of the pillars 54.

Note that the plane layout pattern of pillars 54 may be set for each pixel 3 and also multiple pixels 3 may share one plane layout pattern. In addition, a common plane layout pattern of pillars 54 may be used by all the pixels 3, and also different plane layout patterns may be mixedly present at predetermined pixels 3. FIG. 12 depicts another example of the plane layout pattern of multiple pillars 54.

<Reflection Preventing Film>

As depicted in FIG. 4 and FIG. 5, the reflection preventing film 53 is provided on ends on a side opposite to the semiconductor layer 31 side of the pillars 54. In order to suppress reflection of light (incident light) at a refractive index interface at the tops of the pillars 54, the reflection preventing film 53 has a film thickness taking into consideration what is generally called the $\lambda/(4n)$ rule. Further, a film having a different refractive index may be stacked in order to enhance the reflection preventing effect. The film may be provided only at the portions of pillars 54 having a high refractive index, by forming the reflection preventing film 53 before processing the pillars 54.

<Transparent Material>

As depicted in FIG. 4 and FIG. 5, as a transparent support that connects and supports pillars, the transparent material 55 fills the spaces between mutually adjacent pillars 54, and may further cover each of the multiple pillars 54 and the reflection preventing film 53. For example, the transparent material 55 is provided over the entire region of the pixel array section 2A, and may further be provided over the pixel array section 2A and the periphery 2B. The transparent material 55 can suppress collapses of pillars 54 and defects due to adhesive residues of a protection tape at the time of assembly. The transparent material 55 and the pillars 54 have different refractive indices.

The thickness dimension of the transparent material 55 from the reflection preventing film 51 is the same as or greater than a dimension which is the total of the height of the pillars 54 from the reflection preventing film 51 and the thickness of the reflection preventing film 53.

<Transparent Protective Film>

As depicted in FIG. 4, the transparent protective film 57 is provided over the entire region of the pixel array section 2A, and may further be provided over the pixel array section 2A and the periphery 2B. The transparent protective film 57 is formed by use of an inorganic material. In the first embodiment, the transparent protective film 57 is formed by use of a silicon oxide film, for example.

<Material of Pillars>

As a material of the pillars 54, in a case of the use for NIR (near-infrared light) mainly, it is preferable to use any material selected from amorphous silicon (a-Si), polysilicon, and germanium (Ge) .

In addition, in a case of the use for the visible region mainly, it is preferable to use any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure in which at least two or more materials selected from the titanium oxide, the niobium oxide, the tantalum oxide, the aluminum oxide, the hafnium oxide, the silicon nitride, the silicon oxide, the silicon oxynitride, the silicon carbide, the silicon oxycarbide, the silicon carbonitride, and the zirconium oxide are stacked.

<Planar Shapes of Pillars>

The planar shapes of pillars 54 of the metasurface structures 50 are determined from the viewpoint of anisotropic control of polarized components, reflected components dependent on area rates, processability, and pattern collapse resistance, in addition to control of effective refractive indices. FIG. 11 depicts varied examples of the planar shapes of pillars.

(1) to (3) of FIG. 11 excel in isotropy of polarization control. Alternatively, from the viewpoint of polarization, (4) to (8) have 4-fold symmetry or mirror symmetry about a horizontal axis, a vertical axis, or an axis in the direction of 45 degrees or 135 degrees. Alternatively, from the viewpoint of polarization, (9) to (21) exhibit uniaxial characteristics. Further, in a case where a pattern collapse occurs when control is performed by making the shorter sides in (12) shorter, an auxiliary pattern for collapse prevention like (22) or (23) is desirably arranged. If comparisons are made assuming that the cross-sectional areas are the same, (3), (5), (11), (13), (17), and (19) can avoid the risk of pattern collapses, and allow small effective refractive index differences to be set. Further, if comparisons are made assuming that pitches are identical, (4) and (5) enhance pillar filling rates in cases of square arrays, (1) to (3) enhance pillar filling rates in cases of honeycomb structures, and these are advantageous in a case where phase differences are set.

<Heights of Pillars>

Preferably, the heights of pillars 54 are set such that phases of 2n or more described later can be attained within the range of pillar diameters that can be attained with processing, for a phase difference library specified by a wavelength, the refractive indices of the pillars and the transparent material, pillar shapes and heights, and the like.

FIG. 16 depicts an example of a phase difference library of circular amorphous Si pillars at pitches of 350 nm. In a case where processing limits specify that the pillar diameter be 250 nm, the pillar height is suitably set to 800 nm.

<Refractive Index and Thickness of Reflection Preventing Film>

Preferably, reflection preventing films 51 and 53 having different refractive indices and having such film thicknesses that the phases of reflected waves cancel out each other are provided to the tops of pillars 54 and/or the bottoms of the pillars 54. Specifically, the thicknesses of the reflection preventing films 51 and 53 are preferably set to approximately X/(4n). In practice, it is necessary to take into consideration multilayer film interference effects and oblique incidence characteristics, and the thicknesses are preferably optimized by optical simulation or actual measurement.

<How to Make Phases Turn>

As depicted in FIG. 17, a phase turn portion causes scattering, and generates stray light, undesirably. Further, if the area rate of each pixel 3 is different, reflected components (sensitivity loss) vary undesirably. Accordingly, phases preferably have a turn in accordance with the rules (a) and (b) described below.

 (a) There are turns in units of pixels.
 (b) A turn in a pixel is near the pixel center.

According to the rule (a), the area rates of pixels positioned nearby are made identical to each other, and it becomes possible to suppress reflectance variation. According to the rule (b), if stray light from a turn portion crosses a pixel boundary, crosstalk occurs, leading to characteristics deterioration undesirably. Accordingly, it is desirable that a sufficient distance be ensured between a turn and each pixel boundary. That is, suitably, in terms of symmetry, an intra-pixel turn is set in such a manner as to pass near the pixel center.

<Shape of Reflection Preventing Film>

As depicted in FIG. 6, the reflection preventing film 51 includes a main section 51a that two-dimensionally extends immediately below and around the pillars 54 and protrusions 51b that protrude from the main section 51a immediately below the pillars 54 and that have widths narrower than the widths of the bottoms of the pillars 54. Further, the pillars 54 and the protrusions 51b of the reflection preventing film 51 are surrounded by the transparent material 55. That is, the transparent material 55 also fills the spaces that are outside the protrusions 51b of the reflection preventing film 51 and between the end surfaces (bottom surfaces) on the reflection preventing film 51 side of the pillars 54 and the main section 51a of the reflection preventing film 51. In such a manner, by making the pillars 54 and the protrusions 51b of the reflection preventing film 51 surrounded by the transparent material 55, it is possible to suppress peeling of the transparent material 55, owing to the anchor effect. Further, since the protrusions 51b processed into shapes thinner than the widths of the bottoms of the pillars have low rigidity, it is desirable that the protrusions 51b be formed into rounded shapes to reduce stress concentration.

<Effective Refractive Indices>

As depicted in FIG. 5, assuming that the effective refractive index taking into consideration the area rate at the top surfaces on one end side of pillars 54 is n1, the effective refractive index taking into consideration the area rate of the reflection preventing film 51 immediately below the bottom surfaces on the other end side of the pillars 54 is n2, and the refractive index of the reflection preventing film 51 is n3, it is desirable that the effective refractive indices satisfy n1 > n2 and n3 > n2 from the viewpoint of reflection suppression and less influence of interfaces with discontinuous refractive indices. Additionally, it is preferable that n2 and n3 be set such that the phases of reflected waves from respective interfaces cancel out each other.

<Material of Transparent Material>

Preferably, the refractive index difference between the pillars 54 and the transparent material 55 is equal to or greater than 0.3 in order to produce phase differences of light. The transparent material 55 is formed by use of an organic material or an inorganic material. For example, as the organic material, any material selected from siloxane-based resin, styrene-based resin, acrylic resin, and styrene-acrylic copolymer resin, a material containing fluorine in any material selected from the siloxane-based resin, the styrene-based resin, the acrylic resin, and the styrene-acrylic copolymer resin, or a material including any material selected from the siloxane-based resin, the styrene-based resin, the acrylic resin, the styrene-acrylic copolymer resin, and beads that have a refractive index lower than the refractive indices of the siloxane-based resin, the styrene-based resin, the acrylic resin, and the styrene-acrylic copolymer resin and that internally fill the one selected from the siloxane-based resin, the styrene-based resin, the acrylic resin, and the styrene-acrylic copolymer resin can be used.

As the inorganic material, at least any material selected from silicon oxide, niobium oxide, tantalum oxide, aluminum oxide, hafnium oxide, silicon nitride, silicon oxynitride, silicon carbide, silicon oxycarbide, silicon carbonitride, and zirconium oxide can be used. In addition, the transparent material 55 can be formed by use of a stacked structure in which at least any two or more materials selected from the silicon oxide, the niobium oxide, the tantalum oxide, the aluminum oxide, the hafnium oxide, the silicon nitride, the silicon oxynitride, the silicon carbide, the silicon oxycarbide, the silicon carbonitride, and the zirconium oxide are stacked.

Note that, whereas the solid-state image capturing device 1A disclosed here is a backside illumination solid-state image capturing device, this is not the sole example, and the present technology can be applied to a frontside illumination solid-state image capturing device and further, to a solid-state image capturing device using an organic photoelectric conversion film or the like.

<<Solid-State Image-Capturing-Device Manufacturing Method>>

Next, a method of manufacturing the solid-state image capturing device 1A according to the first embodiment is explained by use of FIG. 8A and FIG. 8B and FIG. 9A to FIG. 9L.

FIG. 8A is a figure depicting a planar configuration of a semiconductor wafer, and FIG. 8B is an enlarged view of a region A in FIG. 8A, and depicts a configuration of a chip formation region.

In addition, FIG. 9A to FIG. 9L are schematic vertical cross-sectional views depicting the method of manufacturing the solid-state image capturing device 1A.

Here, as depicted in FIG. 8A and FIG. 8B, the solid-state image capturing device 1A is fabricated in chip formation regions 62 of a semiconductor wafer 60. The chip formation regions 62 are divided by scribe lines 61, and the multiple chip formation regions 62 are arranged in a matrix. FIG. 8B depicts nine chip formation regions 62, three each in the X direction and the Y direction (3 × 3). Further, the semiconductor chip 2 having the solid-state image capturing device 1A mounted thereon is formed by dicing the multiple chip formation regions 62 individually along the scribe lines 61. The dicing of the chip formation regions 62 is performed after manufacturing steps explained below are implemented and the solid-state image capturing device 1A is formed in each chip formation region 62.

Note that the scribe lines 61 are not ones formed physically.

First, as depicted in FIG. 9A, the multiple photoelectric converting sections 21 divided by the separation regions 32 are formed on the semiconductor layer 31. The separation regions 32 and the photoelectric converting sections 21 can be constructed by forming the p-type semiconductor region 33 in the semiconductor layer 31 and also forming the multiple n-type semiconductor regions 34 that are spaced apart from each other and adjacent to each other in the p-type semiconductor region 33. The p-type semiconductor region 33 positioned on the top surface side and the bottom surface side of the n-type semiconductor regions 34 (photoelectric converting sections 21) doubles as a hole charge accumulating region for dark current reduction. The p-type semiconductor region 33 positioned on the side surfaces of the n-type semiconductor regions 34 functions as separation regions 32 that electrically separate mutually adjacent n-type semiconductor regions 34.

Here, after this step, the process of manufacturing the solid-state image capturing device 1A according to the first embodiment includes a grinding step of grinding the second surface S2 side of the semiconductor layer 31 to make the thickness of the semiconductor layer 31 thinner. Accordingly, the p-type semiconductor region 33 is formed to have a depth which is equal to or greater than the thickness of the semiconductor layer 31 that has undergone the grinding step.

Next, although not depicted in detail, on the first surface S1 of the semiconductor layer 31, the MOS transistors 22 to 26 included in the pixel circuits 29 are formed, and also MOS transistors included in the logic circuit are formed.

Next, as depicted in FIG. 9B, the multilayer wiring layer 35 is formed on the first surface S1 side of the semiconductor layer 31. The multilayer wiring layer 35 is formed by stacking wiring layers including the wires 37 at the multiple stages with the interlayer dielectric film 36 being interposed therebetween.

By this step, the semiconductor base 30 including the semiconductor layer 31 and the multilayer wiring layer 35 is formed.

Next, as depicted in FIG. 9C, the multilayer wiring layer 35 side of the semiconductor base 30 and the main surface side of the support substrate 41 are bonded together with the warp correction film 42 being interposed therebetween. This bonding is performed by plasma joining. This bonding may be performed by use of an adhesive. The warp correction film 42 is provided in advance on the joined surface side of the support substrate 41.

By this step, the semiconductor wafer 60 including the semiconductor base 30 and the support substrate 41 is formed.

Next, as depicted in FIG. 9D, the thickness of the semiconductor layer 31 is made thinner. Specifically, after the second surface S2 side of the semiconductor layer 31 is etched by wet etching or dry etching to make the thickness of the semiconductor layer 31 thinner, further, the second surface S2 side of the semiconductor layer 31 is ground by a CMP method to make the thickness of the semiconductor layer 31 thinner to a predetermined thickness. The thickness of the semiconductor layer 31 is set according to a wavelength region to be treated. For example, this is not the sole example, the thickness is preferably in the range of 2 to 6 $\mu$m in a case where only light in the visible light region is to be sensed, and the thickness is preferably in the range of 3 to 15 $\mu$m in a case where light in the near-infrared region is also to be sensed.

Next, as depicted in FIG. 9E, the fixed electric charge film 45, the insulating film 46, the light blocking film 47, and the insulating film 48 are formed in this order on the second surface S2 side of the semiconductor layer 31.

The fixed electric charge film 45 can be formed by a CVD (Chemical Vapor Deposition) method, a sputtering method, or an atomic layer deposition (ALD: Atomic Layer Deposition) method. In a case where an ALD method is adopted, this is suitable since favorable coverage can be attained at the atomic layer level and it becomes possible to simultaneously form a silicon oxide film that reduces the interface state during the film formation of the fixed electric charge film 45. It is preferable that, by controlling the film thickness or stacking multiple layers, the fixed electric charge film 45 double as a reflection preventing film for the Si semiconductor layer having a high refractive index.

It is desirable that the insulating film 46 have a thickness which is at least equal to or greater than 20 nm, preferably, equal to or greater than 50 nm, since, in a case where, for example, the insulating film 46 is formed by use of a silicon oxide film formed by the ALD method, film peeling due to the blistering phenomenon becomes likely to occur if the thickness is small.

As the light blocking film 47, a film of the material described before is formed by use of a CVD method, a sputtering method, or the like. Note that, since there is a possibility that plasma damage occurs if metal is processed in an electrically floating state, it is preferable that etching patterns of a resist with a width of, for example, several micrometers be transcribed in a region outside the pixel array section 2A, the second surface S2 of the semiconductor layer 31 be exposed by forming grooves by anisotropic etching or wet etching, and then a film of the light blocking material be formed in a state where it is grounded to the semiconductor layer 31. Preferably, a region of the semiconductor layer 31 to which the light blocking material is grounded is given in advance a ground potential as the p-type semiconductor region 33, for example. The light blocking material may be formed by stacking multiple layers, and, for example, formed as layers of titanium, titanium nitride, or stacked films of them that closely contact the insulating film 46. Alternatively, only titanium, titanium nitride, or stacked films of them can also be used as the light blocking film 47. In addition, the light blocking material can also double as a light blocking film of a black-level calculation pixel (not depicted) which is a pixel for calculating the black level of an image signal or a light blocking film for preventing operation errors of peripheral circuits.

For example, the light blocking film 47 can be formed by forming a resist etching pattern of openings for guiding light to the photoelectric converting sections and further pad sections, scribe line sections, or the like on the light blocking material and partially removing the light blocking material by anisotropic etching or the like. Remnants are removed by chemical cleaning as necessary.

The insulating film 48 is formed on the insulating film 46 by forming, for example, a silicon oxide film by use of a CVD method, a sputtering method, or the like such that insulating film 48 covers the light blocking film. After being formed, the insulating film 48 is flattened by CMP.

Next, as depicted in FIG. 9F, the reflection preventing film 51, a pillar forming film 52, and the reflection preventing film 53 are formed in this order on a side (the light incidence surface side of the insulating film 48) opposite to the semiconductor layer 31 side of the insulating film 48. Specifically, for example, the reflection preventing film 51 is formed by forming a silicon nitride ($Si_3N_4$) film with a film thickness of approximately 125 nm by a CVD method. For example, the pillar forming film 52 is formed by forming a film of amorphous silicon with a film thickness of approximately 800 nm by a CVD method. For example, the reflection preventing film 53 is formed by forming silicon nitride with a film thickness of approximately 125 nm by a CVD method. As the pillar forming film 52, other than amorphous silicon, a material described above can be used.

Next, as depicted in FIG. 9G, a resist mask RM1 with a predetermined plane layout pattern is formed on a side (the light incidence surface side of the insulating film 48) opposite to the semiconductor layer 31 side of the reflection preventing film 53. The resist mask RM1 is formed by a well-known photolithography technology. The plane layout pattern of the resist mask RM1 specifies the plane layout pattern of the pillars 54.

Next, the reflection preventing film 53 and the pillar forming film 52 outside the resist mask RM1 are etched sequentially by use of the resist mask RM1 as an etching mask, and, as depicted in FIG. 9H, the columnar form pillars 54 and the reflection preventing film 53 are formed. The multiple pillars 54 form a predetermined plane layout pattern for each pixel 3. The reflection preventing film 53 is formed for each pillar 54 at one end of the pillar 54 on a side opposite to the semiconductor layer 31 side.

In this step, the etching of the reflection preventing film 53 and the pillar forming film 52 is performed using anisotropic dry etching, for example. Further, the etching of the pillar forming film 52 is performed under etching conditions having selectivity relative to the reflection preventing films 53 and 51.

In a case where the selectivity of the resist mask RM1 is insufficient, hard mask processing in which the resist pattern is transcribed once onto a hard mask, for example, a silicon oxide film, and etching is performed through the hard mask may be performed.

Note that the reflection preventing film 51 under the pillars 54 may be provided for the purpose of optical reflection prevention, and, in addition to this functionality, may serve as an etching stopper layer at the time of the etching. Alternatively, the reflection preventing film 51 may not be designed for reflection prevention, but may function only as an etching stopper layer. This increases reflection, and causes deterioration of sensitivity, but it becomes possible to reduce the number of steps of film formation.

Next, wet chemical cleaning is performed. As depicted in FIG. 9I, the resist mask RM1 is removed, and processing remnants are also removed. After the chemical cleaning, typical spin drying undesirably increases the risk of pattern collapses due to imbalanced surface tension at the time of the chemical drying. As a measure against this, drying may be performed after replacement with IPA having low surface tension, or supercritical cleaning may further be used.

In this step, the reflection preventing film 51 is etched isotropically. As depicted in FIG. 9J, the reflection preventing film 51 including: the main section 51a that two-dimensionally extends immediately below and around the pillars 54 and the rounded protrusions 51b that protrude from the main section 51a immediately below the pillars 54 and that have widths narrower than the widths of the bottoms of the pillars 54 is formed. The rounded shapes with flaring ends reduce stress concentration, and pattern collapses starting from the protrusions 51b of the reflection preventing film 51 can be suppressed.

Next, as depicted in FIG. 9K, the transparent material 55 is formed between mutually adjacent pillars 54. The transparent material 55 is transparent, and a material having a large refractive index difference from the pillars 54 is used. For example, the transparent material 55 is formed by a spin-coating method using a fluorine-containing siloxane-based resin. As the transparent material 55, an organic material and an inorganic material described above can be used. The transparent material 55 is formed to have a film thickness thicker than the height of the pillars 54.

In this step, since the pillars 54 are supported by the transparent material 55, it becomes possible to avoid damage to the pillars when a protection tape is peeled at the time of assembly or defects related to adhesive residues having entered the spaces between the pillars and avoid malfunction modes due to drop impacts when on the market.

In addition, in this step, the transparent material 55 fills also the spaces between end surfaces (bottom surfaces) on the reflection preventing film 51 side of the pillars 54 and the main section 51a of the reflection preventing film 51 outside the protrusions 51b of the reflection preventing film 51, the pillars 54 and the protrusions 51b of the reflection preventing film 51 are surrounded by the transparent material 55, and hence, peeling of the transparent material 55 can be suppressed owing to the anchor effect.

Next, as depicted in FIG. 9L, the transparent protective film 57 including, for example, a silicon oxide film as an inorganic material is formed by a CVD method on a side (the light incidence surface side of the transparent material 55) opposite to the semiconductor layer side of the transparent material 55.

By this step, the metasurface structures 50 of the first embodiment are almost completed.

Thereafter, the solid-state image capturing device 1A depicted in FIG. 4 is almost completed by forming bonding openings through which the bonding pads 14 depicted in FIG. 1 are exposed. The formation of the bonding openings is performed using a resist mask. Since, at the time of removal of the resist mask, the transparent material 55 is covered with the transparent protective film 57 including the inorganic material, it becomes possible to avoid damage to the transparent material 55 caused by the removal of the resist mask.

In addition, by this step, the semiconductor wafer 60 depicted in FIG. 8A and FIG. 8B is almost completed. The solid-state image capturing device 1A is formed in each of the multiple chip formation regions 62 of the semiconductor wafer 60.

Thereafter, the semiconductor chip 2 having the solid-state image capturing device 1A mounted thereon is formed by dicing the multiple chip formation regions 62 of the semiconductor wafer 60 individually along the scribe lines 61.

<<Major Advantages of First Embodiment>>

Next, major advantages of the first embodiment are explained.

The solid-state image capturing device 1A according to the first embodiment includes the metasurface structures 50. Further, the metasurface structures 50 include the transparent material 55 filling the spaces between mutually adjacent pillars 54. Because of this, since the pillars 54 are supported by the transparent material 55, it becomes possible to suppress collapses of the pillars 54.

In addition, the metasurface structures 50 include the reflection preventing film 51. Further, the reflection preventing film 51 includes the main section 51a that two-dimensionally extends immediately below and around the pillars 54 and the rounded protrusions 51b that protrude from the main section 51a immediately below the pillars 54 and that have widths narrower than the widths of the bottoms of the pillars 54. Further, the pillars 54 and the protrusions 51b of the reflection preventing film 51 are surrounded by the transparent material 55. Because of this, it becomes possible to suppress peeling of the transparent material 55 owing to the anchor effect. Moreover, the rounded shapes with flaring ends reduce stress concentration, and pattern collapses starting from the protrusions 51b of the reflection preventing film 51 can be suppressed.

The solid-state image capturing device 1A according to the first embodiment includes a filling step of filling the spaces between mutually adjacent pillars 54 with the transparent material 55. Because of this, it becomes possible to provide the solid-state image capturing device 1A having the metasurface structures 50 in which the pillars 54 are supported by the transparent material 55.

<<Modification Example of First Embodiment>>

The reflection preventing film 51 as the underlying layer of the pillars 54 includes the main section 51a and the protrusions 51b in the case explained in the first embodiment described above. In contrast to this, in this modification example, as depicted in FIG. 10, the reflection preventing film 51 as the underlying layer of the pillars 54 has recesses 51c at portions between mutually adjacent pillars 54 in the plan view.

In this case, assuming that the refractive index at the top surfaces on the one end side of pillars 54 is n1, the refractive index at the bottom surfaces on the other end side of the pillars 54 is n2, and the refractive index at the bottom surfaces of the recesses 51c of the reflection preventing film 51 is n3, a configuration with stepwise high refraction can be attained when the effective refractive indices satisfy n1 > n2 and n3 > n2. As compared to shapes without the recesses 51c, the influence of interfaces with discontinuous refractive indices is reduced, and this is preferable from the viewpoint of reflection suppression. Such shapes may be formed by controlling a gas type such that portions to be etched in processing of the bottoms dwindle, or the recesses 51c may be formed in advance on the reflection preventing film 51 by a lithography step and anisotropic etching.

[Second Embodiment]

A solid-state image-capturing-device manufacturing method according to a second embodiment of the present technology is explained by use of FIG. 13A to FIG. 13J.

First, after steps similar to the steps depicted in FIG. 9A to FIG. 9E of the first embodiment are implemented, as depicted in FIG. 13A, the reflection preventing film 51 and the transparent material 55 are formed in this order on a side (the light incidence surface side of the insulating film 48) opposite to the semiconductor layer 31 side of the insulating film 48. For example, the reflection preventing film 51 is formed by forming a silicon nitride film with a film thickness of approximately 125 nm by a CVD method. The transparent material 55 is transparent, and a material having a large refractive index difference from the pillar forming film 52 (pillars 54) described later is used. As the transparent material 55, for example, a silicon oxide film is formed by CVD. The transparent material 55 is not limited to a silicon oxide film, and an inorganic material and an organic material described above can be used. The transparent material 55 is formed to have a film thickness slightly thicker than the pillars 54 described later.

Next, as depicted in FIG. 13B, a resist mask RM2 with a predetermined plane layout pattern is formed on a side (the light incidence surface side of the transparent material 55) opposite to the semiconductor layer 31 side of the transparent material 55. The resist mask RM2 is formed by a well-known photolithography technology. The plane layout pattern of the resist mask RM2 specifies the plane layout pattern of the pillars 54 described later.

Next, the transparent material 55 outside the resist mask RM2 is etched using the resist mask RM2 as an etching mask, through-holes Th1 for forming the pillars 54 are formed through the transparent material 55, and thereafter, the resist mask RM2 is removed as depicted in FIG. 13C.

Next, as depicted in FIG. 13D, the pillar forming film 52 is formed in the through-holes Th1 of the transparent material 55. The pillar forming film 52 is formed by forming a film of, for example, amorphous silicon by use of an approach that attains high coverability, for example, by use of a CVD method, so as to prevent generation of voids in the through-holes Th1. Since the pillar forming film 52 fills the through-holes Th1 of the transparent material 55 with the approach that attains high coverability, it is formed up to a position higher than the upper end of the transparent material 55. As the pillar forming film 52, other than amorphous silicon, a material described above can be used.

Next, the light incidence surface side of the pillar forming film 52 is ground by etching or a CMP method, and, as depicted in FIG. 13E, the thickness of the pillar forming film 52 is made approximately the same as the thickness of the transparent material 55.

In this step, the multiple pillars 54 that include the pillar forming film 52 and that are arranged being spaced apart from each other are formed, and also the transparent material 55 is formed in a predetermined plane layout pattern between mutually adjacent pillars 54. The plane layout pattern of the pillar group is formed for each pixel 3, for example.

Next, as depicted in FIG. 13F, the reflection preventing film 53 that extends two-dimensionally (planarly) over the pillars 54 and the transparent material 55 is formed on a side (the light incidence surface side of each of the pillars 54 and the transparent material 55) opposite to the reflection preventing film 51 side of each of the pillars 54 and the transparent material 55. For example, the reflection preventing film 53 is formed by forming a silicon nitride film with a film thickness of approximately 125 nm by a CVD method.

By this step, metasurface structures in which the transparent material 55 fills the spaces between mutually adjacent pillars 54 can be formed.

The solid-state image-capturing-device manufacturing method according to the second embodiment can also provide advantages similar to those of the method of manufacturing the solid-state image capturing device 1A according to the first embodiment described above.

[Third Embodiment]

A solid-state image capturing device 1B according to a third embodiment of the present technology basically has a configuration similar to that of the solid-state image capturing device 1A according to the first embodiment described above, but is different in the following respects.

That is, as depicted in FIG. 14, the solid-state image capturing device 1B according to the third embodiment includes the metasurface structures 50 that are stacked at two stages.

The metasurface structures 50 on the lower stage in the two stages include the multiple pillars 54 that are arranged, on the light incidence surface side of the insulating film 48, at distances therebetween which are shorter than the wavelength of incident light to be treated, the transparent material 55 filling the spaces between mutually adjacent pillars 54, the reflection preventing film 51 provided on the semiconductor layer 31 side of the pillars 54, and the reflection preventing film 53 provided on a side opposite to the semiconductor layer 31 side of the pillars 54.

Further, the metasurface structures 50 on the upper stage of the two stages include the multiple pillars 54 that are arranged, on the light incidence surface side of the insulating film 48, at distances therebetween which are shorter than the wavelength of incident light to be treated, the transparent material 55 filling the spaces between mutually adjacent pillars 54, the reflection preventing film 51 provided on the semiconductor layer 31 side of the pillars 54, the reflection preventing film 53 provided on a side opposite to the semiconductor layer 31 side of the pillars 54, and the transparent protective film 57 provided on a side opposite to the semiconductor layer 31 side of the transparent material 55.

In such a manner, by stacking the metasurface structures 50 at the two stages, it becomes possible to cope with a wide band of wavelengths and multiple spectra by combining varied designs of the metasurface structures 50 at the respective stages. Further, it becomes possible to realize polarization control.

In addition, although it becomes difficult in some cases to increase the height of the pillars 54 due to collapses of the pillars 54 or the like caused by wet chemical cleaning, it is possible to avoid the problem accompanying an increase of the height of the pillars 54, by stacking the metasurface structures 50 at the two stages as in the third embodiment.

Note that, whereas the metasurface structures 50 are stacked at two stages in the case explained in the third embodiment, the metasurface structures 50 may be stacked at two or more stages (multiple stages).

[Fourth Embodiment]

A solid-state image capturing device 1C according to a fourth embodiment of the present technology basically has a configuration similar to that of the solid-state image capturing device 1A according to the first embodiment described above, but is different in the following respects.

That is, as depicted in FIG. 15, in the solid-state image capturing device 1C according to the fourth embodiment, the transparent material 55 is divided by grooves 58 in units of the pixels 3. Further, the transparent protective film 57 may be provided over the side wall surfaces and bottom surfaces of the grooves 58 and the top surface (light incidence surface) of the transparent material 55.

In such a manner, by dividing the transparent material 55 for each pixel 3 by the grooves 58, in addition to being able to control the pillars 54, it becomes possible to guide light (incident light) near the boundary of a pixel 3 to the subject pixel by use of a refractive index difference between the transparent material 55 and the atmospheric air (air).

In addition, by dividing the transparent material 55 for each pixel 3 by the grooves 58, the transparent material 55 is given a lens effect, and advantages in terms of color mixing suppression and sensitivity improvement can be enjoyed. Preferably, the material and the film thickness of the transparent protective film 57 is selected in accordance with the λ/(4n) rule to prevent reflection.

[Fifth Embodiment]

A solid-state image capturing device 1D according to a fifth embodiment of the present technology basically has a configuration similar to that of the solid-state image capturing device 1A according to the first embodiment described above, but is different in the following respects.

That is, as depicted in FIG. 18 and FIG. 19, the solid-state image capturing device 1D according to the fifth embodiment includes metasurface structures 70 instead of the metasurface structures 50 depicted in FIG. 4 and FIG. 5 of the first embodiment described above. Since the configuration is generally similar to that of the first embodiment described above in other respects, explanations thereof here are omitted.

<Metasurface Structures>

As depicted in FIG. 18 and FIG. 19, similarly to the metasurface structures 50 of the first embodiment described above, the metasurface structures 70 in the fifth embodiment are provided on the second surface S2 side of the semiconductor layer 31 and on the light incidence surface side opposite to the semiconductor layer 31 side relative to the second surface S2 side of the semiconductor layer 31. Further, the metasurface structures 70 of the fifth embodiment include multiple pillars 79 that are arranged, on the light incidence surface side of the insulating film 48, at distances therebetween which are shorter than the wavelength of incident light to be treated and transparent reinforcement beams 77 that support the pillars 79 between mutually adjacent pillars 79.

In addition, the metasurface structures 70 of the fifth embodiment may further include a reflection preventing film 71 provided on the insulating film 48 side of the pillars 79 and a reflection preventing film 80 provided on a side opposite to the insulating film 48 side of the pillars 79. A metasurface structure 70 of the fifth embodiment is also provided for each pixel 3 on the light incidence surface side (the second surface S2 side) of the semiconductor layer 31, and guides incident light to the photoelectric converting section 21.

<Reflection Preventing Film>

Similarly to the reflection preventing film 51 of the first embodiment described above, the reflection preventing film 71 is provided over the entire region of the pixel array section 2A and is provided over the pixel array section 2A and the periphery 2B. Similarly to the reflection preventing film 51 of the first embodiment described above, in order to suppress reflection of light at a refractive index interface at the bottoms (the semiconductor layer 31 side) of the pillars 79, the reflection preventing film 71 has a film thickness taking into consideration what is generally called the λ/(4n) rule. Further, a film having a different refractive index may be stacked in order to enhance the reflection preventing effect.

Note that the reflection preventing film 71 functions as an etching stopper layer at the time of dry etching when the pillars 54 are formed or at the time of dry etching when the transparent material 55 for filling spaces in the pillar forming film is formed. The reflection preventing film 71 is formed by use of a material that can attain etching selectivity relative to the pillars 79.

<Pillars>

As depicted in FIG. 18 and FIG. 19, each of the multiple pillars 79 is processed into a columnar form, and extends upward from the top surface side of the reflection preventing film 71. Further, the multiple pillars 79 include pillars 79 having different thicknesses, array pitches, or shapes. The pillar group including the multiple pillars 79 of the fifth embodiment also has a plane layout pattern similar to that of the pillar group including the multiple pillars 54 of the first embodiment described above, for example. By including such a plane layout pattern of the pillar group including the multiple pillars 79, the phase difference of light varies locally, and it becomes possible to control the direction of light according to the layout (arrangement pattern) of the pillars 79.

Note that the plane layout pattern of the pillar group including the multiple pillars 79 may be set for each pixel 3 and also multiple pixels 3 may share one plane layout pattern. In addition, a common plane layout pattern of the pillar group including the multiple pillars 79 may be used by all the pixels 3, and also different plane layout patterns may be mixedly present at predetermined pixels 3.

<Reflection Preventing Film>

As depicted in FIG. 18 and FIG. 19, similarly to the reflection preventing film 53 of the first embodiment described above, the reflection preventing film 80 may be provided for each pillar 79 on one end of the pillar 79 on a side opposite to the semiconductor layer 31 side. In order to suppress reflection of light (incident light) at a refractive index interface at the tops of the pillars 79, the reflection preventing film 80 has a film thickness taking into consideration what is generally called the $\lambda/(4n)$ rule. Further, a film having a different refractive index may be stacked in order to enhance the reflection preventing effect. The film may be provided only at the portions of pillars 79 having a high refractive index, by forming the reflection preventing film 80 before the pillars 79 are processed.

<Transparent Reinforcement Beams>

As depicted in FIG. 18 and FIG. 19, as transparent supports to connect and support pillars, the transparent reinforcement beams 77 support mutually adjacent pillars 79 between the mutually adjacent pillars 79, and are provided being spaced apart from the reflection preventing film 71 such that there are voids 81 between the transparent reinforcement beams 77 and the reflection preventing film 71. Further, the transparent reinforcement beams 77 enhance the overall strength of the pillars by linking the multiple pillars 79 together on the two-dimensional plane including the X direction and the Y direction.

<<Solid-State Image-Capturing-Device Manufacturing Method>>

Next, a method of manufacturing the solid-state image capturing device 1D according to the fifth embodiment is explained. The explanation here focuses on a method of manufacturing the metasurface structures 70, and uses FIG. 20A to FIG. 20H.

First, after steps similar to the steps depicted in FIG. 9A to FIG. 9E of the first embodiment described above are implemented, as depicted in FIG. 20A, the reflection preventing film 71, a first sacrificial film 72, a support forming film (support film, reinforcement beam forming film) 73, a second sacrificial film 74, an amorphous carbon film 75, and a reflection preventing film 76 are formed on a side (the light incidence surface side of the insulating film 48) opposite to the semiconductor layer 31 side of the insulating film 48 in this order from the insulating film 48 side. For example, the reflection preventing film 71 is formed by forming a silicon nitride ($Si_3N_4$) film with a film thickness of approximately 125 nm by a CVD method. For example, the first sacrificial film 72 and the second sacrificial film 74 are formed by forming a silicon oxide film by a CVD method. For example, the support forming film 73 is formed by forming a silicon nitride film by a CVD method. For example, the reflection preventing film 76 is formed by forming a silicon nitride film by a CVD method.

Examples of the support forming film 73 include any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide, a stacked structure of any of these materials, and the like, and desirably does not absorb light in a target wavelength region of the photodetector.

Next, as depicted in FIG. 20A, a resist mask RM4 with a predetermined plane layout pattern is formed on a side (the light incidence surface side of the reflection preventing film) opposite to the amorphous carbon film 75 side of the reflection preventing film 76. The resist mask RM4 is formed by a well-known photolithography technology. The plane layout pattern of the resist mask RM4 specifies the plane layout pattern of the pillars 59.

Next, the reflection preventing film 76, the amorphous carbon film 75, the second sacrificial film 74, the support forming film 73, and the first sacrificial film 72 outside the resist mask RM4 are etched sequentially by dry etching using the resist mask RM4 as an etching mask, and, as depicted in FIG. 20B, the through-holes Th1 for forming the pillars 79 are formed. The through-holes Th1 are formed, from the top surface of the reflection preventing film 76, to a depth that reaches the reflection preventing film 71. Since the sizes or positions of the through-holes Th1 are determined depending on optical characteristics, they are not arrayed at constant intervals necessarily.

In this step, the transparent reinforcement beams 77 including the support forming film 73 are formed around the through-holes Th1.

Next, as depicted in FIG. 20C, the resist mask RM4, the reflection preventing film 76, and the amorphous carbon film 75 are removed selectively.

Next, as depicted in FIG. 20D, a pillar forming film 78 is formed on a side opposite to the transparent reinforcement beam 77 side of the second sacrificial film 74 in such a manner as to fill the through-holes Th1 without generating voids by a film formation method such as ALD or CVD that attains high coverage.

Next, as depicted in FIG. 20E, the pillar forming film 78 on the second sacrificial film 74 side is removed selectively by a CMP method or a full surface etch back method such that the pillar forming film 78 remains in the through-holes Th1, and the second sacrificial film 74 is exposed.

In this step, the pillars 79 including the pillar forming film 78 are formed in the through-holes Th1.

Next, in a case where the reflection preventing film is formed on the tops of the pillars 79, as depicted in FIG. 20F, the reflection preventing film 80 that extends two-dimensionally (planarly) over the pillars 79 and the second sacrificial film 74 is formed on a side opposite to the transparent reinforcement beam 77 side of each of the pillars 79 and the second sacrificial film 74.

The reflection preventing film 80 is formed by forming a film of any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide, a stacked structure of any of these materials, and the like.

Here, preferably, the reflection preventing film 80 is formed since the surfaces of the pillars 79 reflect light significantly. For example, in a case where the pillars 79 are a-Si having a refractive index of approximately 3.5, reflection is desirably suppressed by forming the reflection preventing film 80 as a silicon nitride film having a refractive index of approximately 1.8, which is an approximately intermediate refractive index between the refractive index of the pillars 79 and the refractive index of air, and the reflection preventing film 80 suitably has a film thickness taking into consideration the $\lambda/(4n)$ rule.

Next, patterning of the reflection preventing film 80 is performed, and, as depicted in FIG. 20G, the reflection preventing film 80 arranged on individual ones of the multiple pillars 79 is formed. The patterning of the reflection preventing film 80 is performed by use of a well-known photolithography technology and dry etching technology.

Next, as depicted in FIG. 20H, the second sacrificial film 74 and the first sacrificial film 72 are removed. For the removal of the second sacrificial film 74 and the first sacrificial film 72, a wet etching method using hydrofluoric acid (HF) as an etching chemical solution can be used.

In this step, the transparent reinforcement beams 77 that support mutually adjacent pillars 79 between the mutually adjacent pillars 79 and are spaced apart from the reflection preventing film 71 are formed, and also the voids 81 are formed between the reflection preventing film 71 and the transparent reinforcement beams 77. Since the voids 81 function as air layers and have a refractive index of 1, the refractive index difference from the pillars 79 can be increased further as compared with the case where the transparent material 55 fills the spaces between mutually adjacent pillars 54 in the first embodiment described above.

By this step, the metasurface structures 70 of the fifth embodiment are almost completed.

The solid-state image capturing device 1D according to the fifth embodiment can also provide advantages similar to those of the solid-state image capturing device 1A according to the first embodiment described above.

In addition, the method of manufacturing the solid-state image capturing device 1D according to the fifth embodiment can also provide advantages similar to those of the method of manufacturing the solid-state image capturing device 1A according to the first embodiment described above.

[Sixth Embodiment]

The solid-state image capturing device according to a sixth embodiment of the present technology basically has a configuration similar to that of the solid-state image capturing device 1D according to the fifth embodiment described above, but is different in the following respects.

That is, the solid-state image capturing device according to the sixth embodiment includes metasurface structures 70A depicted in FIG. 21, instead of the metasurface structures 70 depicted in FIG. 18 and FIG. 19 of the fifth embodiment described above. Further, the metasurface structures 70A of the sixth embodiment include the transparent reinforcement beams 77 that are provided, at two stages, being spaced apart from each other in the height direction of the pillars 79 as depicted in FIG. 21, unlike the metasurface structures 70. The configuration is generally similar to that of the fifth embodiment described above in other respects.

The explanation below focuses on a method of manufacturing the metasurface structures 70A in the solid-state image-capturing-device manufacturing method according to the sixth embodiment, and uses FIG. 22A to FIG. 22C.

First, after steps similar to the steps depicted in FIG. 9A to FIG. 9E of the first embodiment described above are implemented, as depicted in FIG. 22A, the reflection preventing film 71, the first sacrificial film 72, the support forming film (support film, reinforcement beam forming film) 73, the first sacrificial film 72, the support forming film (support film) 73, the second sacrificial film 74, the amorphous carbon film 75, and the reflection preventing film 76 are formed on a side (the light incidence surface side of the insulating film 48) opposite to the semiconductor layer 31 side of the insulating film 48 in this order from the insulating film 48 side.

Next, patterning of the reflection preventing film 76, the amorphous carbon film 75, the second sacrificial film 74, the support forming film 73, the first sacrificial film 72, the support forming film 73, and the first sacrificial film 72 is performed sequentially, and, as depicted in FIG. 22B, the through-holes Th1 for forming the pillars 79 are formed. The through-holes Th1 are formed, from the top surface of the reflection preventing film 76, to a depth that reaches the reflection preventing film 71. The patterning of these is performed by use of a photolithography technology and a dry etching technology similar to the ones used in the fifth embodiment described above.

After the reflection preventing film 76 and the amorphous carbon film 75 are removed selectively, as depicted in FIG. 22C, the pillar forming film 78 is formed on a side opposite to the transparent reinforcement beam 77 side of the second sacrificial film 74 in such a manner as to fill the through-holes Th1.

Thereafter, by implementing steps similar to those in the fifth embodiment described above, the metasurface structures 70A of the sixth embodiment can be formed.

The solid-state image capturing device according to the sixth embodiment can also provide advantages similar to those of the solid-state image capturing device 1D according to the fifth embodiment described above.

In addition, the solid-state image-capturing-device manufacturing method according to the sixth embodiment can also provide advantages similar to those of the method of manufacturing the solid-state image capturing device 1D according to the fifth embodiment described above.

In addition, since the solid-state image capturing device according to the sixth embodiment includes the transparent reinforcement beams 77 that are stacked at the two stages and that are spaced apart from each other, deformations of the pillars 79 can be reduced further as compared with the case where the transparent reinforcement beams 77 are provided at one stage. The arrangement of the transparent reinforcement beams 77 at the two stages is useful in particular in a case where the height of the pillars 79 is tall.

Note that, whereas the transparent reinforcement beams 77 are stacked at two stages in the case explained in the sixth embodiment, the transparent reinforcement beams 77 may be stacked at two or more stages (multiple stages).

[Seventh Embodiment]

The solid-state image capturing device according to a seventh embodiment of the present technology basically has a configuration similar to that of the solid-state image capturing device 1D according to the fifth embodiment described above, but is different in the following respects.

That is, the solid-state image capturing device according to the seventh embodiment includes metasurface structures 70B depicted in FIG. 23, instead of the metasurface structures 70 depicted in FIG. 18 and FIG. 19 of the fifth embodiment described above. Further, in the metasurface structures 70B of the seventh embodiment, the one end side of the pillars 79 is covered with thin film sections 77a of the transparent reinforcement beams 77 as depicted in FIG. 23, unlike the metasurface structures 70A. The configuration is generally similar to that of the fifth embodiment described above in other respects.

The explanation below focuses on a method of manufacturing the metasurface structures 70B in the solid-state image-capturing-device manufacturing method according to the seventh embodiment, and uses FIG. 24A to FIG. 24H.

First, after steps similar to the steps depicted in FIG. 9A to FIG. 9E of the first embodiment described above are implemented, as depicted in FIG. 24A, the reflection preventing film 71 and the pillar forming film 78 are formed on a side (the light incidence surface side of the insulating film 48) opposite to the semiconductor layer 31 side of the insulating film 48 in this order from the insulating film 48 side. As explained later, the reflection preventing film 71 functions as a stopper film when the pillars are formed, and also functions as a reflection preventing film of the interface between the insulating film 48 as an underlying film and the pillars 79. As the reflection preventing film 71, for example, a silicon oxide film is used. As the pillar forming film 78, for example, amorphous silicon, polysilicon, germanium, or the like is used.

Next, patterning of the pillar forming film 78 is performed to form a predetermined plane layout pattern, and, as depicted in FIG. 24B, the pillars 79 including the pillar forming film 78 are formed. The patterning of the pillar forming film 78 is performed by use of a well-known photolithography technology and dry etching technology.

Next, as depicted in FIG. 24C, the first sacrificial film 72 is formed between mutually adjacent pillars 79 such that its thickness is smaller than the height of the pillars 79. The first sacrificial film 72 is formed by film formation by a coating method, a CVD method, or the like.

Next, as depicted in FIG. 24D, the first sacrificial film 72 on the one end side of the pillars 79 is removed selectively by an etch back method, and the top surfaces and the side surfaces on the one end side of the pillars 79 are exposed.

Next, as depicted in FIG. 24E, a film of the transparent reinforcement beams 77 is formed on the first sacrificial film 72 between mutually adjacent pillars 79. The transparent reinforcement beams 77 are formed to have a film thickness thinner than the height of exposed portions on the one end side of the pillars 79.

In this step, the transparent reinforcement beams 77 support the pillars 79 between mutually adjacent pillars 79.

In addition, in this step, the one end side of the pillars 79 is covered with the thin film sections 77a of the transparent reinforcement beams 77.

Next, after the second sacrificial film 74 is formed on the transparent reinforcement beams 77 between mutually adjacent pillars 79, as depicted in FIG. 24F, the second sacrificial film 74 is removed by, for example, a CMP method, until the thin film section 77a is exposed by use of the thin film sections 77a of the transparent reinforcement beams 77 as stopper films.

Next, as depicted in FIG. 24G, the reflection preventing film 80 that extends two-dimensionally over the pillars 79 and the second sacrificial film 74 is formed on a side opposite to the transparent reinforcement beam 77 side of each of the pillars 79 and the second sacrificial film 74.

Next, patterning of the reflection preventing film 80 is performed, and, as depicted in FIG. 24H, the reflection preventing film 80 arranged on individual ones of the multiple pillars 79 is formed. The patterning of the reflection preventing film 80 is performed by use of a well-known photolithography technology and dry etching technology.

Next, similarly to the fifth embodiment described above, the second sacrificial film 74 and the first sacrificial film 72 are removed. For the removal of the second sacrificial film 74 and the first sacrificial film 72, a wet etching method using hydrofluoric acid (HF) as an etching chemical solution can be used.

In this step, as depicted in FIG. 23, the transparent reinforcement beams 77 that support the pillars 79 between mutually adjacent pillars 79, are spaced apart from the reflection preventing film 71, and cover the one end side of the pillars 79 with thin film sections 79a are formed, and also the voids 81 are formed between the reflection preventing film 71 and the transparent reinforcement beams 77.

As a result, the metasurface structures 70B in which the pillars 79 are supported by the transparent reinforcement beams 77 between mutually adjacent pillars 79 and the voids 81 are provided between a reflection preventing film 91 and the transparent reinforcement beams 77 can be formed.

The solid-state image capturing device according to the seventh embodiment can also provide advantages similar to those of the solid-state image capturing device 1D according to the fifth embodiment described above.

In addition, the solid-state image-capturing-device manufacturing method according to the seventh embodiment can also provide advantages similar to those of the method of manufacturing the solid-state image capturing device 1D according to the fifth embodiment described above.

[Eighth Embodiment]

The solid-state image capturing device according to an eighth embodiment of the present technology basically has a configuration similar to that of the solid-state image capturing device 1D according to the fifth embodiment described above, but is different in the following respects.

That is, the solid-state image capturing device according to the eighth embodiment includes metasurface structures 70C depicted in FIG. 25, instead of the metasurface structures 70 depicted in FIG. 18 and FIG. 19 of the fifth embodiment described above. Further, in the metasurface structures 70C of the eighth embodiment, the reflection preventing film 80 is formed to extend two-dimensionally over mutually adjacent pillars 79 as depicted in FIG. 25, unlike the metasurface structures 70A. The configuration is generally similar to that of the fifth embodiment described above in other respects.

The explanation below focuses on a method of manufacturing the metasurface structures 70C in the solid-state image-capturing-device manufacturing method according to the eighth embodiment, and uses FIG. 26A to FIG. 26C.

First, after steps similar to the steps depicted in FIG. 9A to FIG. 9E of the first embodiment described above are implemented, steps similar to the steps depicted in FIG. 20A to FIG. 20D of the fifth embodiment described above are implemented, and, as depicted in FIG. 26A, the pillar forming film 78 is formed on a side opposite to the reinforcement beam 77 side of the second sacrificial film 74 in such a manner as to fill the through-holes Th1.

Next, as depicted in FIG. 26B, the pillar forming film 78 on the second sacrificial film 74 side is removed selectively by a CMP method or an etch back method such that the pillar forming film 78 remains in the through-holes Th1, and the second sacrificial film 74 is exposed.

In this step, the pillars 79 including the pillar forming film 78 are formed in the through-holes Th1.

Next, as depicted in FIG. 26C, the reflection preventing film 80 that extends two-dimensionally (planarly) over the pillars 79 and the second sacrificial film 74 is formed on a side opposite to the transparent reinforcement beam 77 side of each of the pillars 79 and the second sacrificial film 74.

Next, as depicted in FIG. 25, the second sacrificial film 74 and the first sacrificial film 72 are removed selectively.

By this step, the metasurface structures 70C in which the pillars 79 are supported by the transparent reinforcement beams 77 between mutually adjacent pillars 79 and the voids 81 are provided between the reflection preventing film 91 and the transparent reinforcement beams 77 can be formed.

The solid-state image capturing device according to the eighth embodiment can also provide advantages similar to those of the solid-state image capturing device 1D according to the fifth embodiment described above.

In addition, the solid-state image-capturing-device manufacturing method according to the eighth embodiment can also provide advantages similar to those of the method of manufacturing the solid-state image capturing device 1D according to the fifth embodiment described above.

[Ninth Embodiment]

The solid-state image capturing device according to a ninth embodiment of the present technology basically has a configuration similar to that of the solid-state image capturing device 1D according to the fifth embodiment described above, but is different in the following respects.

That is, the solid-state image capturing device according to the ninth embodiment includes metasurface structures 70D depicted in FIG. 27A and FIG. 27B, instead of the metasurface structures 70 depicted in FIG. 18 and FIG. 19 of the fifth embodiment described above. Further, in the metasurface structures 70D of the ninth embodiment, as depicted in FIG. 27A and FIG. 27B, the reflection preventing film 80 is formed to extend two-dimensionally over mutually adjacent pillars 79 and have a projection/recess shape reflecting the steps formed by the one end side of the pillars 79 and the transparent reinforcement beams 77, unlike the metasurface structures 70A. The configuration is generally similar to that of the fifth embodiment described above in other respects.

The explanation below focuses on a method of manufacturing the metasurface structures 70D in the solid-state image-capturing-device manufacturing method according to the ninth embodiment, and uses FIG. 28A to FIG. 28C.

First, after steps similar to the steps depicted in FIG. 9A to FIG. 9E of the first embodiment described above are implemented, steps similar to the steps depicted in FIG. 20A to FIG. 20D of the fifth embodiment described above are implemented, and, as depicted in FIG. 28A, the pillar forming film 78 is formed on a side opposite to the transparent support film 73 side of the second sacrificial film 74 in such a manner as to fill the through-holes Th1.

Next, as depicted in FIG. 28B, the pillar forming film 78 on the second sacrificial film 74 side is removed selectively by a CMP method or an etch back method such that the pillar forming film 78 remains in the through-holes Th1, and the second sacrificial film 74 is exposed.

In this step, the pillars 79 including the pillar forming film 78 are formed in the through-holes Th1.

Next, as depicted in FIG. 28C, the second sacrificial film 74 and the first sacrificial film 72 are removed. For the removal of the second sacrificial film 74 and the first sacrificial film 72, a wet etching method using hydrofluoric acid (HF) as an etching chemical solution can be used, for example.

In this step, the transparent reinforcement beams 77 that support mutually adjacent pillars 79 between the mutually adjacent pillars 79 and are spaced apart from the reflection preventing film 71 are formed, and also the voids 81 are formed between the reflection preventing film 71 and the transparent reinforcement beams 77. Since the voids 81 function as air layers and have a refractive index of 1, the refractive index difference from the pillars 79 can be increased further as compared with the case where the transparent material 55 fills the spaces between mutually adjacent pillars 54 in the first embodiment described above.

Next, as depicted in FIG. 27A and FIG. 27B, the reflection preventing film 80 that extends two-dimensionally over mutually adjacent pillars 79 and has a projection/recess shape reflecting the steps formed by the one end side of the pillars 79 and the transparent reinforcement beams 77 is formed.

As the reflection preventing film 80, a film of any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure of any of these materials is formed by a P-CVD method, a PVD method, a vapor deposition method, or the like.

In this step, preferably, the reflection preventing film 80 is formed only on the top surfaces of the pillars for the sake of optical characteristics, but characteristics deterioration can be suppressed to the minimum by determining optical designs taking into consideration coverage by each film formation approach.

By this step, the metasurface structures 70D in which the pillars 79 are supported by the transparent reinforcement beams 77 between mutually adjacent pillars 79 and the voids 81 are provided between the reflection preventing film 91 and the transparent reinforcement beams 77 can be formed.

The solid-state image capturing device according to the ninth embodiment can also provide advantages similar to those of the solid-state image capturing device 1D according to the fifth embodiment described above.

In addition, the solid-state image-capturing-device manufacturing method according to the ninth embodiment can also provide advantages similar to those of the method of manufacturing the solid-state image capturing device 1D according to the fifth embodiment described above.

Note that, for example, in a case where the pillars are a-Si having a refractive index of approximately 3.5, the reflection preventing film is desirably formed as a silicon nitride film having a target refractive index of approximately 1.8 which is an approximately intermediate refractive index between the refractive index of the pillars and the refractive index of air, and the reflection preventing film suitably has a film thickness taking into consideration the $\lambda/(4n)$ rule.

<<Modification Example>>

Note that, in a case where the reflection preventing film 80 is formed by ALD, CVD, or the like, as depicted in FIG. 29, the reflection preventing film 80 is formed on both the semiconductor layer 31 side of the transparent reinforcement beams 77 and a side opposite to the semiconductor layer 31 side (both the void-81 side and the light incidence surface side of the transparent reinforcement beams 77).

Next, a manufacturing method according to the modification example of the ninth embodiment is explained. The explanation of this modification example also focuses on a method of manufacturing metasurface structures 70E, and uses FIG. 30A to FIG. 30C.

First, after steps similar to the steps depicted in FIG. 9A to FIG. 9E of the first embodiment described above, steps similar to the steps depicted in FIG. 20A to FIG. 20D of the fifth embodiment described above, and then steps similar to the steps depicted in FIG. 28A to FIG. 28B of the ninth embodiment described above are implemented, as depicted in FIG. 30A, the second sacrificial film 74 on the top surface side (a side opposite to the semiconductor layer side of the transparent reinforcement beams 77) of the transparent reinforcement beams 77 is removed selectively.

Next, as depicted in FIG. 30B, the reflection preventing film 80 that extends two-dimensionally over mutually adjacent pillars 79 and has a projection/recess shape reflecting the steps formed by the one end side of the pillars 79 and the transparent reinforcement beams 77 is formed.

In this step, since the pillars 79 are covered with the transparent reinforcement beams 77 and the first sacrificial film 72 except for portions protruding above the transparent reinforcement beams 77, the reflection preventing film 80 is formed selectively on a side (the light incidence surface side of the transparent reinforcement beams 77) opposite to the semiconductor layer 31 side of the transparent reinforcement beams 77.

Next, as depicted in FIG. 30C, the first sacrificial film 72 is removed selectively.

By this step, the metasurface structures 70E in which the pillars 79 are supported by the transparent reinforcement beams 77 between mutually adjacent pillars 79 and the voids 81 are provided between the reflection preventing film 91 and the transparent reinforcement beams 77 can be formed.

The solid-state image capturing device according to the modification example of the ninth embodiment can also provide advantages similar to those of the solid-state image capturing device 1D according to the fifth embodiment described above.

In addition, the solid-state image-capturing-device manufacturing method according to the modification example of the ninth embodiment can also provide advantages similar to those of the method of manufacturing the solid-state image capturing device 1D according to the fifth embodiment described above.

<Aspect Ratio of Pillars>

FIG. 31A and FIG. 31B are figures for explaining collapses of pillars.

In a case where wet cleaning is performed for pillar structures with a high aspect ratio, there is a fear that, due to differences between drying timings of a chemical solution on pillars PP, imbalanced local surface tension is generated and pillars collapse.

A local force applied between pillars PP is known as the Laplace pressure, and is formulated as $\Delta P = 2\gamma \cdot \cos\theta/D$ assuming that the Laplace pressure is $\Delta P$, the surface tension of a chemical solution is $\gamma$, the contact angle is $\theta$, and the inter-pattern distance is D.

The maximum stress $\sigma max$ applied to a pillar pattern is formulated as $\sigma max = 3\Delta P(H/W)^2$ assuming that the pillar height is H and the width is W. The higher the aspect ratio of a pillar is, the greater the force applied to the pattern is.

In a case where the rigidity of a pillar material is insufficient for the maximum stress $\sigma max$, the pillars PP collapse undesirably.

The technology of the present disclosure produces an effect in cases of pillar structures whose heights are increased for giving phase differences in metasurface designs, and providing reinforcement beams makes it possible to prevent pattern collapses due to chemical drying of wet cleaning.

Note that the transparent material 55 and the reinforcement beams 77 may be combined as transparent supports that connect and support pillars. In this case, preferably, the refractive index difference between the reinforcement beams 77 and the transparent material 55 is equal to or smaller than 0.2.

[Tenth Embodiment]

A solid-state image capturing device 1E according to a tenth embodiment of the present technology basically has a configuration similar to that of the solid-state image capturing device 1A according to the first embodiment described above, but is different in the following respects.

That is, as depicted in FIG. 32 and FIG. 33, the solid-state image capturing device 1E according to the tenth embodiment includes metasurface structures 90 instead of the metasurface structures 50 depicted in FIG. 4 and FIG. 5 of the first embodiment described above. Since the configuration is generally similar to that of the first embodiment described above in other respects, explanations thereof here are omitted.

<Metasurface Structures>

As depicted in FIG. 32 and FIG. 33, similarly to the metasurface structures 50 of the first embodiment described above, the metasurface structures 90 in the tenth embodiment are provided on the light incidence surface side on a side opposite to the semiconductor layer 31 side of the insulating film 48 as the underlying layer. Further, the metasurface structures 90 of the tenth embodiment include multiple pillars 93 that are arranged, on the light incidence surface side of the insulating film 48, at distances therebetween which are shorter than the wavelength of incident light to be treated and a transparent protective film 97 that supports a side opposite to the semiconductor layer 31 side of the multiple pillars 93. In addition, the metasurface structures 90 of the tenth embodiment further include voids 99 provided between mutually adjacent pillars 93. Moreover, the metasurface structures 90 may include the reflection preventing film 91 provided on the insulating film 48 side of the pillars 93. A metasurface structure 90 of the tenth embodiment also is provided for each pixel 3 on the light incidence surface side (the second surface S2 side) of the semiconductor layer 31, and guides incident light to the photoelectric converting section 21.

<Reflection Preventing Film>

Similarly to the reflection preventing film 51 of the first embodiment described above, the reflection preventing film 91 is provided over the entire region of the pixel array section 2A and is provided over the pixel array section 2A and the periphery 2B. Similarly to the reflection preventing film 51 of the first embodiment described above, in order to suppress reflection of light at a refractive index interface at the bottoms (the semiconductor layer 31 side) of the pillars 93, the reflection preventing film 91 has a film thickness taking into consideration what is generally called the $\lambda/(4n)$ rule. Further, a film having a different refractive index may be stacked in order to enhance the reflection preventing effect. Note that the reflection preventing film 91 functions as an etching stopper layer when a pillar forming film is processed by dry etching to form the pillars 93. The reflection preventing film 91 is formed by use of a material that can attain etching selectivity relative to the pillars 93.

<Pillars>

As depicted in FIG. 32 and FIG. 33, each of the multiple pillars 93 is processed into a columnar form, and extends upward from the top surface side of the reflection preventing film 91. Further, the multiple pillars 93 include pillars 93 having different thicknesses, array pitches, or shapes. The pillar group including the multiple pillars 93 of the tenth embodiment also has a plane layout pattern similar to that of the pillar group including the multiple pillars 54 of the first embodiment described above, for example. By including such a plane layout pattern of the pillar group including the multiple pillars 93, the phase difference of light varies locally, and it becomes possible to control the direction of light according to the layout (arrangement pattern) of the pillars 93.

<Transparent Protective Film>

As depicted in FIG. 32 and FIG. 33, the transparent protective film 97 is formed to extend two-dimensionally over mutually adjacent pillars 93. Further, the transparent protective film 97 supports the other end side of each of mutually adjacent pillars 93 and is provided being spaced apart from the reflection preventing film 91 such that there are the voids 81 between the transparent protective film 97 and the reflection preventing film 91. That is, one end side of the multiple pillars 93 is supported by the reflection preventing film 91, and the other end side on a side opposite to the one end side is supported by the transparent protective film 97.

Although the transparent protective film 97 may be provided over the entire region of the pixel array section 2A, a transparent protective film 97 may be provided for each one pixel 3 or may be shared by multiple pixels 3. In the tenth embodiment, the transparent protective film 97 is provided over the entire region of the pixel array section 2A.

In order to suppress reflection of light (incident light) at a refractive index interface at the tops of the pillars 93, the transparent protective film 97 may have a film thickness taking into consideration what is generally the called X/(4n) rule. Further, a film having a different refractive index may be stacked in order to enhance the reflection preventing effect. That is, the transparent protective film 97 can support mutually adjacent pillars 93 at end surfaces of the pillars 93 on the other end side, and can also have a reflection preventing functionality.

<<Solid-State Image-Capturing-Device Manufacturing Method>>

Next, a method of manufacturing the solid-state image capturing device 1E according to the tenth embodiment is explained. The explanation here focuses on a method of manufacturing the metasurface structures 90, and uses FIG. 33A to FIG. 33E.

First, after steps similar to the steps depicted in FIG. 9A to FIG. 9E of the first embodiment described above are implemented, as depicted in FIG. 34A, the reflection preventing film 91 and the multiple pillars 93 are formed on a side (the light incidence surface side of the insulating film 48) opposite to the semiconductor layer 31 side of the insulating film 48 in this order from the insulating film 48 side.

For example, the reflection preventing film 91 is formed by forming a silicon nitride ($Si_3N_4$) film with a film thickness of approximately 125 nm by a CVD method. The multiple pillars 93 can be formed by performing patterning of a pillar forming film by use of an etching mask with a predetermined pattern after the pillar forming film is formed on the reflection preventing film 91.

The pillar forming film is formed by forming a film of any material selected from amorphous silicon (a-Si), polycrystalline silicon (Poly Si), titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or forming a film of a stacked structure of any of these materials by use of an ALD (Atomic layer Deposition) method, a CVD (Chemical Vaper Deposition) method, a PVD (Physical Vaper Deposition) method, or a coating method (Spin Coat).

Next, as depicted in FIG. 34B, a sacrificial film 95 is formed on the pillar 93 side of the reflection preventing film 91 in such a manner as to fill the spaces between mutually adjacent pillars 93. For example, the sacrificial film 95 is formed by forming a silicon oxide film by a CVD method. The sacrificial film 95 is formed to have a film thickness thicker than the height of the pillars 93.

Next, as depicted in FIG. 34C, a side (the top surface side of the sacrificial film 95) opposite to the reflection preventing film 91 side of the sacrificial film 95 is removed selectively by a CMP method or a full surface etch back method such that the sacrificial film 95 remains between mutually adjacent pillars 93, and one end side of the pillars 93 is exposed.

Next, as depicted in FIG. 34D, the transparent protective film 97 that extends two-dimensionally (planarly) over the pillars 93 and the sacrificial film 95 is formed on a side opposite to the reflection preventing film 91 side of each of the pillars 93 and the sacrificial film 95.

The transparent protective film 97 is formed by forming a film of any material selected from titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure of any of these materials. In this embodiment, a silicon nitride film is used. Preferably, the transparent protective film 97 is given a reflection functionality, and in a case where the pillars 93 are a-Si having a refractive index of approximately 3.5, for example, the transparent protective film 97 is desirably formed as a silicon nitride film having a refractive index of approximately 1.8 which is an approximately intermediate refractive index between the refractive index of the pillars 93 and the refractive index of air, and the transparent protective film 97 suitably has a film thickness taking into consideration the $\lambda/(4n)$ rule.

Next, as depicted in FIG. 34E, the sacrificial film 95 is removed selectively. The removal of the sacrificial film 95 is performed by use of a wet etching method or a dry etching method that attains high selectivity relative to the reflection preventing film 91, the pillars 93, and the transparent protective film 97. In this embodiment, the sacrificial film 95 is removed by use of a wet etching method using hydrofluoric acid (HF) as an etching chemical solution.

In this step, the other end side of each of mutually adjacent pillars 93 is supported by the transparent protective film, and the voids 99 are formed between the reflection preventing film 91 and the transparent protective film 97. Since the voids 99 function as air layers and have a refractive index of 1, the refractive index difference from the pillars 93 can be increased further as compared with the case where the transparent material 55 fills the spaces between mutually adjacent pillars 54 in the first embodiment described above.

By this step, the metasurface structures 90 of the tenth embodiment are almost completed.

Note that, since formation of the hollow structure requires high etching selectivity between the pillars 93, the transparent protective film 97, and the reflection preventing film 91 that are to remain after the processing and the sacrificial film 95 to be removed after the processing, combinations of materials and removing means are limited. In one specific example, when SiO2 is used as the sacrificial film 95, examples of the removing means include wet etching using hydrofluoric acid and the like, and suitable examples of the materials to remain include amorphous silicon, polysilicon, titanium oxide, silicon nitride, and the like. Moreover, Ge, SiC, SiOC, and SiNC can also be materials to remain.

Alternatively, when aluminum or an aluminum alloy including AlCu, AlSi, or the like is used as the sacrificial film 95, examples of the removing means include wet etching using nitric acid, phosphoric acid, sulfuric acid, hydrochloric acid, a mixed solution of any of these and a hydrogen peroxide solution, SC-1, or the like, for example, and suitable examples of the materials to remain include amorphous silicon, polysilicon, silicon nitride, and the like. Moreover, $Nb_2O_5$, Ge, $SiO_2$, SiON, SiC, SiOC, and SiNC can also be materials to remain.

Alternatively, when pure aluminum or titanium is used as the sacrificial film 95, examples of the removing means include dry etching using a chlorine gas and the like, and suitable examples of the materials to remain include amorphous silicon, polysilicon, silicon nitride and the like. Moreover, $Nb_2O_5$, $ZrO_2$, $Al_2O_3$, $HfO_2$, $SiO_2$, SiON, SiC, SiOC, and SiNC can also be materials to remain.

Alternatively, when Cu is used as the sacrificial film 95, examples of the removing means include wet etching using a mixed solution of phosphoric acid, sulfuric acid, or hydrochloric acid and a hydrogen peroxide solution, for example, and suitable examples of the materials to remain include titanium oxide, silicon nitride, and the like. Moreover, $Nb_2O_5$, Ge, $SiO_2$, SiON, SiC, SiOC, and SiNC can also be materials to remain.

Alternatively, when an SOG film is used as the sacrificial film 95, examples of the removing means include wet etching using an AZ remover or the like, for example, and suitable examples of the materials to remain include amorphous silicon, polysilicon, titanium oxide, silicon nitride, and the like. Moreover, $Nb_2O_5$, $ZrO_2$, Ge, $HfO_2$, $SiO_2$, SiON, SiC, SiOC, and SiNC can also be materials to remain.

Alternatively, when tungsten is used as the sacrificial film 95, examples of the removing means include dry etching using a SF6 gas and the like, and suitable examples of the materials to remain include amorphous silicon, polysilicon, titanium oxide, silicon nitride, and the like. Moreover, $Nb_2O_5$, $ZrO_2$, $Al_2O_3$, $HfO_2$, $SiO_2$, SiON, SiC, SiOC, and SiNC can also be materials to remain.

Alternatively, when an organic film is used as the sacrificial film 95, examples of the removing means include dry etching using an oxygen gas, wet etching using a mixed solution of sulfuric acid and an oxidant such as a hydrogen peroxide solution, for example, and suitable examples of the materials to remain include amorphous silicon, polysilicon, titanium oxide, silicon nitride, and the like. Moreover, $Nb2O_5$, $ZrO_2$, Ge, $HfO_2$, $SiO_2$, SiON, SiC, SiOC, and SiNC can also be materials to remain. In the case of $Al_2O_3$, it can remain if dry etching using an oxygen gas is performed.

Note that the materials and removing means described above are disclosed as combinations that are found through experiments conducted by the authors to provide high etching selectivity and to not cause defects due to remnants or the like almost at all, but these are not the sole examples.

The solid-state image capturing device 1E according to the tenth embodiment can also provide advantages similar to those of the solid-state image capturing device 1A according to the first embodiment described above.

In addition, the method of manufacturing the solid-state image capturing device 1E according to the tenth embodiment can also provide advantages similar to those of the method of manufacturing the solid-state image capturing device 1A according to the first embodiment described above.

In addition, the solid-state image capturing device 1E according to the tenth embodiment can also further increase the refractive index difference from the pillars 93 similarly to the solid-state image capturing device 1D according to the fifth embodiment described above.

[Eleventh Embodiment]

A solid-state image-capturing-device manufacturing method according to an eleventh embodiment of the present technology is explained. The explanation here focuses on a metasurface-structure manufacturing method, and uses FIG. 35A to FIG. 35D.

First, after steps similar to the steps depicted in FIG. 9A to FIG. 9E of the first embodiment and steps similar to the steps depicted in FIG. 34A to FIG. 34C of the tenth embodiment are implemented, as depicted in FIG. 35A, the transparent protective film 97 that extends two-dimensionally (planarly) over the pillars 93 and the sacrificial film 95 on a side opposite to the reflection preventing film 91 side of each of the pillars 93 and the sacrificial film 95 is formed by a method similar to that of the tenth embodiment described above. The transparent protective film 97 of the eleventh embodiment is formed to have a film thickness thinner than the film thickness of the transparent protective film 97 of the tenth embodiment described above.

Next, as depicted in FIG. 35B, a through-hole 97a that penetrates the transparent protective film 97 from the front to the back of the transparent protective film 97 is formed. The through-hole 97a is a hole for making it easier to supply an etching solution or an etching gas to the sacrificial film 95 at the time of removal of the sacrificial film 95, and, is preferably formed as an opening at the pixel boundary, in an ineffective region, and so on. The through-hole 97a is formed by use of a well-known photolithography technology and etching technology. The through-hole 97a is formed at a position overlapping the sacrificial film 95 in the plan view.

Next, as depicted in FIG. 35C, the sacrificial film 95 is removed selectively. The removal of the sacrificial film 95 is performed by use of a wet etching method or a dry etching method that attains high selectivity relative to the reflection preventing film 91, the pillars 93, and the transparent protective film 97. In this embodiment, the sacrificial film 95 is removed by use of a wet etching method using hydrofluoric acid (HF) as an etching chemical solution.

In this step, since the etching chemical solution is supplied from the outer circumference side of the transparent protective film 97 and is also supplied from the through-hole 97a of the transparent protective film 97, it is useful in a case where there is a problem related to remnants, processing time, or the like.

In this step, the one end side of each of mutually adjacent pillars 93 is supported by the transparent protective film 97, and the voids 99 are formed between the reflection preventing film 91 and the transparent protective film 97.

Next, as depicted in FIG. 35D, the through-hole 97a is closed by forming a film on the top surface of the transparent protective film 97. It is useful if the closure of the through-hole 97a is performed by a film formation method with low coverage, for example, a sputtering method or the like. The film formation for closing the through-hole 97a increases the film thickness of the transparent protective film 97. In addition, it becomes possible to avoid the influence on characteristics by forming the opening at the pixel boundary, in the ineffective region, and so on, although a trace of the through-hole 97a remains.

By this step, the metasurface structures 90 of the eleventh embodiment are almost completed.

Note that the closure of the through-hole 97a is not necessarily required to be performed, and the closure of the through-hole 97a does not have to be performed in a case where there are no problems related to remnants or the like in latter steps.

The solid-state image capturing device according to the eleventh embodiment can also provide advantages similar to those of the solid-state image capturing device 1E according to the tenth embodiment described above.

In addition, the solid-state image-capturing-device manufacturing method according to the eleventh embodiment can also provide advantages similar to those of the method of manufacturing the solid-state image capturing device 1E according to the tenth embodiment described above.

[Twelfth Embodiment]

A solid-state image-capturing-device manufacturing method according to a twelfth embodiment of the present technology is explained. The explanation here focuses on a metasurface-structure manufacturing method, and uses FIG. 36A to FIG. 36F. Whereas a process in which the sacrificial film is formed after the pillars are formed is explained in the tenth embodiment described above, a process in which openings of a negative/positive inverted pattern of pillars are formed through the sacrificial film and the pillars are formed by embedding a pillar forming film (pillar material) in the openings is explained in the twelfth embodiment.

First, after steps similar to the steps depicted in FIG. 9A to FIG. 9E of the first embodiment are implemented, as depicted in FIG. 36A, the reflection preventing film 91 and the sacrificial film 95 are formed on the insulating film 48 in this order from the insulating film 48 side.

Next, as depicted in FIG. 36B, multiple openings 95a are formed through the sacrificial film 95. The multiple openings 95a are formed in a negative/positive inverted pattern of pillars. The multiple openings 95a can be formed by use of a well-known photolithography technology and etching technology.

Next, as depicted in FIG. 36C, the inside of each of the multiple openings 95a is filled with a pillar forming film 92 by a film formation method such as ALD or CVD that attains high coverage such that voids are not generated. The pillar forming film 92 is formed to have a film thickness thicker than the depth of the openings 95a in such a manner as to cover the sacrificial film 95.

Next, as depicted in FIG. 36D, the pillar forming film 92 on the sacrificial film 95 is removed selectively by a CMP method or a full surface etch back method such that the pillar forming film 92 remains in each of the multiple openings 95a, and the sacrificial film 95 is exposed.

In this step, a pillar 93 including a pillar forming film 92a is formed in each of the multiple openings 95a.

Next, as depicted in FIG. 36E, the transparent protective film 97 is formed. Preferably, the film thickness of the transparent protective film 97 is designed such that reflection preventing conditions taking into consideration what is generally called the $\lambda/(4n)$ rule are satisfied. In addition, the transparent protective film 97 may be formed by use of a multilayer film to ensure the reflection preventing functionality. Thereafter, as depicted in FIG. 36F, the sacrificial film 95 is removed.

By this step, the one end side of each of mutually adjacent pillars 93 is supported by the transparent protective film, and the voids 99 are formed between the reflection preventing film 91 and the transparent protective film 97. In addition, by this step, the metasurface structures 90 of the twelfth embodiment are almost completed.

The solid-state image capturing device according to the twelfth embodiment can also provide advantages similar to those of the solid-state image capturing device 1E according to the tenth embodiment described above.

In addition, the solid-state image-capturing-device manufacturing method according to the twelfth embodiment can also provide advantages similar to those of the method of manufacturing the solid-state image capturing device 1E according to the tenth embodiment described above.

In addition, since the twelfth embodiment adopts the process of forming the pillars 93 by embedding the pillar forming film (Pillar material) 92 in the openings 95a of the sacrificial film 95, this is useful in a case where the pillars 93 are formed by use of a material such as titanium oxide which is difficult to be etched.

[Thirteenth Embodiment]

A solid-state image-capturing-device manufacturing method according to a thirteenth embodiment of the present technology is explained. The explanation here focuses on a metasurface-structure manufacturing method, and uses FIG. 37A to FIG. 37D. The manufacturing process of the thirteenth embodiment is a combination of the manufacturing process of the twelfth embodiment described above and the manufacturing process of the 211st embodiment described above.

First, after steps similar to the steps depicted in FIG. 9A to FIG. 9E of the first embodiment and steps similar to the steps depicted in FIG. 34A to FIG. 34D of the twelfth embodiment are implemented, as depicted in FIG. 37A, the transparent protective film 97 is formed, and thereafter, as depicted in FIG. 37B, the through-hole 97a is formed through the transparent protective film 97. The through-hole 97a is a hole for making it easier to supply an etching solution or an etching gas to the sacrificial film 95 at the time of removal of the sacrificial film 95, and is preferably formed as an opening at the pixel boundary, in an ineffective region, and so on. The through-hole 97a is formed by use of a well-known photolithography technology and etching technology. Thereafter, as depicted in FIG. 37C, the sacrificial film 95 is removed selectively.

Then, after this, as depicted in FIG. 37D, the through-hole 97a is closed by forming a film on the top surface of the transparent protective film 97. The steps of FIG. 37A to FIG. 37D are identical to the steps of FIG. 35A to FIG. 35D of the eleventh embodiment described above.

By this step, the metasurface structures 90 of the thirteenth embodiment are almost completed.

Note that the closure of the through-hole 97a is not necessarily required to be performed, and the closure of the through-hole 97a does not have to be performed in a case where there are no problems related to remnants, processing time, or the like.

The solid-state image capturing device according to the thirteenth embodiment can also provide advantages similar to those of the solid-state image capturing device 1E according to the tenth embodiment described above.

In addition, the solid-state image-capturing-device manufacturing method according to the eleventh embodiment can also provide advantages similar to those of the method of manufacturing the solid-state image capturing device 1E according to the tenth embodiment described above.

[Fourteenth Embodiment]

A solid-state image-capturing-device manufacturing method according to a fourteenth embodiment of the present technology is explained. The explanation here focuses on a metasurface-structure manufacturing method, and uses FIG. 38A to FIG. 38D.

First, steps similar to the steps depicted in FIG. 9A to FIG. 9E of the first embodiment and steps similar to the steps depicted in FIG. 36A to FIG. 36C of the twelfth embodiment are implemented to attain the state depicted in FIG. 38A.

Next, as depicted in FIG. 38B, a through-hole 92b that reaches the sacrificial film 95 from the surface of the pillar forming film 92 is formed at a position overlapping the sacrificial film 95 of the pillar forming film 92 in the plan view. The through-hole 92b is a hole for making it easier to supply an etching solution or an etching gas to the sacrificial film 95 at the time of removal of the sacrificial film 95, and is preferably formed as an opening at the pixel boundary, in an ineffective region, and so on. The through-hole 92b is formed by use of a well-known photolithography technology and etching technology.

Next, as depicted in FIG. 38C, the sacrificial film 95 is removed selectively, and the voids 99 are formed. The removal of the sacrificial film 95 is performed by use of a wet etching method or a dry etching method that attains high selectivity relative to the reflection preventing film 91 and the pillar forming film 92. In this embodiment, the sacrificial film 95 is removed by use of a wet etching method using hydrofluoric acid (HF) as an etching chemical solution.

In this step, since the etching chemical solution is supplied from the outer circumference side of the pillar forming film 92, and is also supplied from the through-hole 92b of the pillar forming film 92, it is useful in a case where there is a problem related to remnants, processing time, or the like.

In this step, the multiple pillars 93 that include the pillar forming film 92, are surrounded by the voids 99, and have the other end side that is coupled by the pillar forming film 92 are formed.

Next, as depicted in FIG. 38D, the transparent protective film 97 that extends two-dimensionally (planarly) is formed on a side opposite to the reflection preventing film 91 side of the pillar forming film 92, and also the through-hole 92b is closed with the transparent protective film 97. The transparent protective film 97 is formed by a method similar to that for the transparent protective film 97 of the tenth embodiment described above. Since, if the pillar forming film 92 remains planarly, reflection is likely to occur due to the refractive index difference, it is preferable that the transparent protective film 97 having a reflection functionality be provided.

By this step, the metasurface structures 90 of the fourteenth embodiment are almost completed.

Note that the closure of the through-hole 92b may be performed by a film formation method that attains low coverage, for example, a sputtering method or the like. In addition, it becomes possible to avoid the influence on characteristics by forming the opening at the pixel boundary, in the ineffective region, and so on, although a trace of the through-hole 92b remains.

The solid-state image capturing device according to the fourteenth embodiment can also provide advantages similar to those of the solid-state image capturing device 1E according to the tenth embodiment described above.

In addition, the solid-state image-capturing-device manufacturing method according to the fourteenth embodiment can also provide advantages similar to those of the method of manufacturing the solid-state image capturing device 1E according to the tenth embodiment described above.

[Fifteenth Embodiment]

A solid-state image capturing device 1F according to a fifteenth embodiment of the present technology basically has a configuration similar to that of the solid-state image capturing device 1E according to the tenth embodiment described above, but is different in the following respects.

That is, as depicted in FIG. 39 and FIG. 40, the solid-state image capturing device 1F according to the fifteenth embodiment includes metasurface structures 90A instead of the metasurface structures 90 depicted in FIG. 32 and FIG. 33 of the tenth embodiment described above. The configuration is generally similar to that of the tenth embodiment described above in other respects.

The difference between the metasurface structures 90A of the fifteenth embodiment and the metasurface structures 90 of the tenth embodiment described above is that the metasurface structures 90A include reflection preventing films 94. That is, the metasurface structures 90A of the fifteenth embodiment include the reflection preventing films 94 between the other end side of the pillars 93 and the transparent protective film 97.

As depicted in FIG. 39 and FIG. 40, a reflection preventing film 94 is provided for each pillar 93 on the other end of the pillar 93 that is on a side opposite to the semiconductor layer 31 side. In order to suppress reflection of light (incident light) at a refractive index interface at the tops of the pillars 93, the reflection preventing films 94 have a film thickness taking into consideration what is generally called the $\lambda/(4n)$ rule. Further, in the fifteenth embodiment, the transparent protective films 97 having a different refractive index are stacked in order to enhance the reflection preventing effect.

The solid-state image capturing device 1E according to the fifteenth embodiment can also provide advantages similar to those of the solid-state image capturing device 1D according to the tenth embodiment described above.


[Sixteenth Embodiment]


A solid-state image capturing device 1G according to a sixteenth embodiment of the present technology basically has a configuration similar to that of the solid-state image capturing device 1A according to the first embodiment described above, but is different in the following respects.

That is, as depicted in FIG. 41, the solid-state image capturing device 1G according to the sixteenth embodiment includes metasurface structures that are stacked on two stages. The configuration is generally similar to that of the tenth embodiment described above in other respects.

Here, metasurface structures at the lower stage of the two stages are the metasurface structures 90. The metasurface structures 90 include the reflection preventing film 91 provided on the light incidence surface side of the insulating film 48, the multiple pillars 93 that are arranged, on the light incidence surface side of the reflection preventing film 91, at distances therebetween which are shorter than the wavelength of incident light to be treated, the voids 99 provided between mutually adjacent pillars 93, and the transparent protective film 97 provided on a side opposite to the semiconductor layer 31 side of the pillars 93.

Further, metasurface structures at the upper stage of the two stages are the metasurface structures 50. The metasurface structures 50 include the multiple pillars 54 that are arranged, on the light incidence surface side of the transparent protective film 97, at distances therebetween which are shorter than the wavelength of incident light to be treated, the reflection preventing film 53 provided on the one end side of the pillars 54, the transparent material 55 filling the spaces between mutually adjacent pillars 54, and the transparent protective film 57 provided on the light incidence surface side of the transparent material 55.

In such a manner, by stacking the metasurface structures at the two stages, it becomes possible to cope with a wide band of wavelengths, multiple spectra, and the like by combining varied designs of the metasurface structures at the respective stages. Further, it becomes possible to realize polarization control.

In addition, although it becomes difficult in some cases to increase the height of the pillars due to collapses of the pillars 54 or the like caused by wet chemical cleaning, it is possible to avoid the problem accompanying an increase of the height of the pillars, by stacking the metasurface structures at the two stages as in the sixteenth embodiment.

Note that, whereas the metasurface structures are stacked at two stages in the case explained in the sixteenth embodiment, the metasurface structures may be stacked at two or more stages (multiple stages), and further, any combinations of metasurface structures in the embodiments described above are possible.


[Seventeenth Embodiment]


FIG. 42 is a schematic vertical cross-sectional view depicting a schematic configuration of the pixel array section and the periphery of a solid-state image capturing device according to a seventeenth embodiment of the present technology.

FIG. 43 is a plan view depicting a configuration example of the light blocking film in FIG. 42, and FIG. 44, FIG. 45, and FIG. 46 are plan views depicting modification examples of the light blocking film.

In FIG. 43, the light blocking film 47 is formed between adjacent photoelectric converting sections 21. As a result, crosstalk can be suppressed by inter-pixel light blocking. As depicted in FIG. 42 and FIG. 43, black reference pixels also are light-blocked.

FIG. 44 depicts a structure without inter-pixel light blocking. In FIG. 44, it is attempted to control stray light at pixel boundaries by use of pillars 93, and increase the sensitivity without inter-pixel light blocking.

FIG. 45 depicts a structure including image surface phase difference pixels. In FIG. 45, it becomes possible to calculate a subject distance on the basis of an image shift amount by forming pixels with different parallaxes by use of the light blocking film 47 and perform a fast focusing process of a camera lens or distance measurement (sensing). Since the angle of incidence at angle-of-view ends varies between different lenses in a case of an interchangeable camera, it is necessary to provide a phase difference pixel for each angle. It is impossible with on-chip lenses of conventional technologies to change pupil correction for each pixel 3, pixels whose opening sizes of the light blocking film 47 become narrow emerge, and the sensitivity deteriorates.

On the other hand, when the present embodiment is used, since it becomes possible to condense light at any angles of incidence onto pixel centers, it is possible to prevent opening sizes from becoming narrow. Accordingly, sensitivity deterioration can be avoided.

FIG. 46 depicts a pinhole structure. In FIG. 46, the light blocking film 47 is provided as pinholes, and incident light is guided for each pixel such that the light passes through a pinhole while it is being condensed at a metasurface structure 90. Note that the opening rate of the pinholes here is desirably equal to or lower than 25%. By providing the light blocking film 47 in such a manner, light that has passed through the pinholes, has reflected on the second surface S2 of the semiconductor layer 31, and has not arrived at photoelectric converting sections 21 is re-reflected at the bottom surfaces of the pinholes, and is caused to return to the photoelectric converting sections 21, thereby being able to improve the sensitivity. Alternatively, even in a case where light that has penetrated the semiconductor layer 31 has been re-reflected on the first surface S1 or the multilayer wiring layer 35 and has exited from the second surface 2 on the opposite side, the light is re-reflected at the bottom surfaces of the pinholes, and is caused to return to the photoelectric converting sections 21, thereby being able to improve the sensitivity.

The confinement structure realized by the pinholes can suppress reflection light released from the optical detecting device to the outside, and can reduce image quality deterioration called flares or ghosts. Further, advantages not only in terms of suppression of reflection light that occurs in the optical detecting device, but also in terms of blocking of unnecessary light that is not desired to enter the optical detecting device can be enjoyed.

The pinhole structure is effective for the optical detecting device which is aimed for near-infrared light that easily penetrates the semiconductor base 30. On the other hand, restricting near-infrared light with a long wavelength requires on-chip lenses including a material having a high refractive index, for example, amorphous silicon, polysilicon, germanium, or the like, but if there is an interface on a plane having a large refractive index difference, intense reflection occurs undesirably. Regarding the reflection on the on-chip lenses, light is condensed not by use of lens shapes with curved surfaces, but pillars are used. As a result, it becomes possible to make an adjustment to appropriate effective refractive indices, and it becomes possible to suppress reflection on the lens interfaces.

The present embodiment increases the sensitivity by adjusting condensation points to pinholes. On the other hand, it is also possible to generate low-sensitivity pixels and high-sensitivity pixels by defocusing by changing a pillar design for each pixel 100, and realize high dynamic range (HDR). Alternatively, it is possible to realize HDR also by changing a pinhole size for each pixel.

FIG. 47 is a vertical cross-sectional view depicting a configuration example of separation regions in FIG. 42, and FIG. 48 to FIG. 52 are vertical cross-sectional views depicting modification examples of the separation regions.

The metasurface design controls the phase/wave surface of target light with microstructures with sizes which are equal to or smaller than the wavelength of the light, but microscopic stray light is generated undesirably to no small extent at discontinuous substance interfaces. In a case where metasurface elements are mounted on the photodetector, it is essential to ensure element separation such that the stray light does not become inter-pixel crosstalk. Here, an embodiment of the element separation regions that are necessary for suppressing crosstalk caused by metasurface structures is described.

FIG. 47 depicts a structure that includes inter-pixel light blocking separation realized by use of the light blocking film 47 directly above the semiconductor layer 31 and reduces charge crosstalk by use of a potential realized by ion implantation on the semiconductor layer 31 side. Although crosstalk of stray light having entered the semiconductor layer 31 cannot be suppressed, processing damage to the semiconductor layer 31 is small, and this is advantageous in terms of characteristics at dark settings.

FIG. 48 depicts a structure in which a trench is formed deep into or to penetrate the semiconductor layer 31, the pinning on the side wall is ensured by use of a fixed electric charge film, and an insulating film 33a is embedded. As compared to FIG. 47, charge crosstalk is ensured, and it is possible to cause a part of stray light to return to the photoelectric converting section 21 of the subject pixel by use of the refractive index difference between the semiconductor layer 31 and the insulating film 33a. It should be noted that there is a fear that the number of steps increases and characteristics at dark settings worsen due to interface damage caused by the trench processing.

FIG. 49 depicts a structure in which a trench with a very small width (e.g., equal to or smaller than 100 nm) is formed in the semiconductor layer 31, the upper end of the trench is closed when the fixed electric charge film 45 is formed on the side wall, and a void 33b is formed. The refractive index difference is greater than in the case of the insulating film 33a in FIG. 48, and interfacial reflection is more likely to occur, and an effect in terms of confinement of stray light within the subject pixel can be enhanced. It should be noted that there is a problem of large variation of closedness.

FIG. 50 depicts a structure in which a shallow trench (e.g., 100 to 400 nm) is formed in the semiconductor layer 31, the fixed electric charge film 45 and the insulating film 46 are provided, and then a part of the light blocking film 47 is caused to protrude toward the semiconductor layer 31 side. Although it becomes possible to interrupt a crosstalk path between the light blocking film 47 and the semiconductor layer 31 as compared to FIG. 47, there is concern that characteristics at dark settings deteriorate due to damage and contamination deterioration caused by the processing.

FIG. 51 depicts a structure in which a trench is formed deep into or to penetrate the semiconductor layer 31, the pinning of the side wall is ensured by the fixed electric charge film 45, the insulating film is embedded, and the light blocking metal is embedded in the space of the insulating film. Although the light blocking film absorbs stray light and crosstalk is suppressed as compared to FIG. 48, components of the stray light to return to the subject pixel decrease, the sensitivity deteriorates slightly, and there is concern over deterioration of characteristics at dark settings due to processing damage or contamination.

FIG. 52 depicts a structure in which the fixed electric charge film 45 ensures the pinning of the side walls of a deep trench with a thin line width and a trench formed shallow with a line width thicker than the deep trench, the insulating film 46 is embedded, and the light blocking metal is embedded only in the shallow trench. As compared to FIG. 47, a crosstalk path between the light blocking film 47 and the semiconductor layer 31 is interrupted, suppression of charge crosstalk in the semiconductor layer 31 at a deep position is then ensured, an effect in terms of confinement of stray light within the subject pixel is attained even at the deep position, and it becomes possible to reduce sensitivity loss that occurs in the case of FIG. 51. It should be noted that there is concern over an increase of the number of steps and deterioration of characteristics at dark settings due to processing damage or contamination.

[Eighteenth Embodiment]

FIG. 53 is a schematic vertical cross-sectional view depicting a schematic configuration of a pixel array section of a solid-state image capturing device according to an eighteenth embodiment of the present technology.

FIG. 54A is a figure depicting a horizontal cross-sectional structure along a line a54-a54 in FIG. 53, and FIG. 54B is a figure depicting a horizontal cross-sectional structure along a line b54-b54 in FIG. 53. FIG. 54C is a figure depicting a horizontal cross-sectional structure along a line c54-c54 in FIG. 53, and FIG. 54D is a figure depicting a horizontal cross-sectional structure along a line d54-d54 in FIG. 53.

As depicted in FIG. 53 and FIG. 54A to FIG. 54D, the solid-state image capturing device according to the eighteenth embodiment includes the semiconductor layer 31, the photoelectric converting section 21 provided on the semiconductor layer 31 for each pixel 3, the fixed electric charge film 45, the insulating film 46, the light blocking film 47, the insulating film 48, the multilayer wiring layer 35, and the metasurface structures 90. In addition, the solid-state image capturing device according to the eighteenth embodiment includes a diffraction/scattering element 101 provided with regular recesses and projections at an interface on the light incidence surface side of the semiconductor layer 31. The multilayer wiring layer 35 may include a reflecting plate 47a including parts of the wires 37 in regions overlapping the photoelectric converting sections 21 in the plan view.

Since element separation is ensured for suppressing stray light that occurs at the metasurface structures 90, an effect of suppressing stray light other than that is also attained. That is, if combined with a technology of processing the substrate surface for obliquely transmitting light having entered the substrate for increasing the sensitivity, it becomes possible, with one element separating section 213, to simultaneously suppress stray light that is generated at metasurface elements and stray light that is generated on the substrate surface.

<Configuration on Light Reception Surface Side of Semiconductor Layer>

FIG. 55 is a figure depicting a diffraction/scattering element provided on an interface on the light incidence surface side of a semiconductor layer ((a) is a vertical cross-sectional view, and (b) is a horizontal cross-sectional view). FIG. 56 is a figure depicting a light splitting section provided on the interface on the light incidence surface side of the semiconductor layer ((a) is a vertical cross-sectional view, and (b) is a horizontal cross-sectional view) (No. 1). FIG. 57 is a figure depicting the light splitting section provided on the interface on the light incidence surface side of the semiconductor layer ((a) is a vertical cross-sectional view, and (b) is a horizontal cross-sectional view) (No. 2). FIG. 58 is a figure depicting the light splitting section provided on the interface on the light incidence surface side of the semiconductor layer ((a) is a vertical cross-sectional view, and (b) is a horizontal cross-sectional view) (No. 3).

In FIG. 55 ((a) and (b)), the interface on the light incidence surface side (light reception surface side) of the semiconductor layer 31 where the photoelectric converting section 21 is formed includes the diffraction/scattering element 101 where regular recesses and projections are provided. The recesses and projections serve as a diffraction grating, high-order components are diffracted in oblique directions, optical path lengths in the photoelectric converting section 21 can be increased, and particularly, the sensitivity to near-infrared light components can be improved. Specifically, for example, quadrangular pyramids formed by use of wet etching of a Si (111) plane using AKW (Alkali Water) can be applied to the diffraction/scattering structure. This is not the sole example, and the diffraction/scattering structure may be formed by dry etching. Further, by adopting a shape whose cross-sectional area varies in the depth direction, reflection is suppressed, and the sensitivity also improves slightly.

In FIG. 56 ((a) and (b)), by causing light to split at a shallow groove where an oxide film is embedded and giving the light an angle, zeroth-order light can be reduced, and the sensitivity can be improved. The light splitting section is formed by forming a trench at the top of the photoelectric converting section 21 and embedding the fixed electric charge film 45 and the insulating film 46, for example, $SiO_2$, by ALD or the like. A light splitting section 102 may be formed linearly in the plan view at a position where light is condensed, or can be provided as portions that cross at the angle of 90° in a case where the light splitting section 102 is seen from the incident-light side. At this time, the crossing angle is not limited to 90°.

Moreover, as depicted in FIG. 57 and FIG. 58, in addition to light splitting sections 102 including crossing portions, still other light splitting sections than the light splitting sections 102 may be provided. Since the etching rate at the crossing portions becomes higher undesirably due to the microloading effect, it is also possible to enhance the uniformity in the depth direction by providing a space between the crossing portions and separating the crossing portions.

It is also possible to reduce the number of steps by embedding the fixed electric charge film 45 or the oxide film in trench grooves of the light splitting sections 102 simultaneously when the separation regions (element separating sections) 32 are embedded.


[Nineteenth Embodiment]


<Deflecting Section with Prism Functionality and On-Chip Lens>


FIG. 59 is a main-section schematic vertical cross-sectional view depicting a combination of a deflecting section with a prism functionality and an on-chip lens in an optical detecting device according to a nineteenth embodiment of the present technology.

The metasurface design can also give a lens functionality in addition to the prism functionality, but this requires a corresponding amount of additional phase differences. In a case where a turn of phase differences is necessary due to a constraint of pillar heights, there is concern over stray light due to scattering at the turn portion.

As a measure to avoid this, pillars 93 may specialize only in the prism functionality for guiding light to the photoelectric converting section 21 vertically, and light condensation may be realized by providing an on-chip lens 103.

By providing the pillars 93 and the on-chip lens 103 in such a manner, phase differences that are necessary in the pixel can be reduced, and a turn can be avoided in the pixel as much as possible.

Further, by providing the on-chip lens 103 on a deflecting section 106, the amount of light hitting a turn at the pixel boundary of the pixel 3 can be reduced, and stray light can also be reduced.


<Deflecting Section Combining Prism Functionality and Lens Functionality and On-Chip Lens>


FIG. 60 is a main-section schematic vertical cross-sectional view depicting a combination of the deflecting section combining the prism functionality and the lens functionality and the on-chip lens.

By increasing the lens power and further narrowing down light in the above-described configuration including the light blocking film 47 as pinholes, the pinhole diameter can be reduced. If the pinhole diameter can be reduced, the effect in terms of confinement of light and the flare sensitivity suppressing effect can be enhanced. Possible means for increasing the lens power is to provide the on-chip lens 103 in a state where pillars 93 are given the prism functionality and the lens functionality. Further, pupil correction may be added to the on-chip lens 103 in order to reduce stray light at a pixel 3 at an angle-of-view end resulting from light hitting the boundary of the pixel 3 of the pillars 93.

In both FIG. 59 and FIG. 60, the on-chip lenses 103 can be formed by use of an organic material such as a styrene-based resin, an acrylic resin, a styrene-acrylic resin, or a siloxane-based resin. In addition, the on-chip lenses 103 can also be formed by dispersing titanium oxide particles to the organic material described above or a polyimide-based resin. The on-chip lenses 103 may also be formed by use of an inorganic material such as silicon nitride or silicon oxynitride. In addition, a material film having a refractive index different from that of the on-chip lenses 103 for preventing reflection can also be arranged on the surface of the on-chip lenses 103. In addition, in a case of the use for NIR, a material such as amorphous Si, Poly Si, or germanium may also be used.

Note that the deflecting section 106 may be formed by use of any of the metasurface structures according to the embodiments described above. Although FIG. 59 and FIG. 60 and FIG. 61 to FIG. 66, FIG. 69, FIG. 70, FIG. 72, FIG. 74, and FIG. 76 described later depict the metasurface structures 90 as an example, this is not the sole example.

<Deflecting Section with Prism Functionality and Inner Lens>

FIG. 61 is a main-section schematic vertical cross-sectional view depicting a combination of the deflecting section 106 with the prism functionality (metasurface structure 90) and an inner lens 104.

The metasurface design can give also the lens functionality in addition to the prism functionality, but this requires phase differences. In a case where a turn of phase differences is necessary due to a constraint of pillar heights, there is concern over stray light due to scattering at the turn portion.

As a measure to avoid this, pillars 93 may specialize only in the prism functionality for guiding light to the photoelectric converting section 21 vertically, and light condensation may be realized by providing the inner lens 104.

By providing the pillars 93 and the inner lens 104 in such a manner, phase differences that are necessary in the pixel can be reduced, and a turn can be avoided in the pixel as much as possible.

<Deflecting Section Combining Prism Functionality and Lens Functionality and Inner Lens>

FIG. 62 is a main-section schematic vertical cross-sectional view depicting a combination of the deflecting section combining the prism functionality (metasurface structure 90) and the lens functionality and the inner lens.

By increasing the lens power and further narrowing down light in the above-described configuration including the light blocking film 47 as pinholes, the pinhole diameter can be reduced. If the pinhole diameter can be reduced, the effect in terms of confinement of light and the flare sensitivity suppressing effect can be enhanced. Possible means for increasing the lens power is to provide the inner lens 104 in a state where pillars 93 are given the prism functionality and the lens functionality.

In both FIG. 61 and FIG. 62, the inner lenses may be formed by use of an inorganic material such as silicon nitride or silicon oxynitride. In addition, the material film 105 having a refractive index different from that of the inner lenses 104 for preventing reflection can also be arranged on the surfaces of the inner lenses 104.

In addition, in a case of the use for near-infrared light, a material such as amorphous Si, Poly-Si, or germanium may also be used for the inner lenses 104. Further, the inner lenses 104 may be provided as box lenses having rectangular cross-sectional shapes. Even if the cross-sectional shapes are rectangular, it is possible to attain a lens effect by bending a wave surface by use of a refractive index difference from the refractive index of a material between box lenses.

[Twentieth Embodiment]

<Configuration Example of Light Blocking Wall>

FIG. 63 to FIG. 66 are main-section schematic vertical cross-sectional views depicting a configuration of light blocking walls in the optical detecting device according to a twentieth embodiment of the present technology.

In a case where the distance between the deflecting section 106, for example, metasurface structure 90, and the semiconductor layer 31 is increased for increasing the height, for example, in a case where condensation points are adjusted to pinhole structures or the deflecting section 106 is formed at multiple stages, crosstalk paths between the deflecting section 106 and the semiconductor layer 31 are widened, and there is concern over characteristics deterioration undesirably. As a measure against this, light blocking walls or clad sections may be provided between the deflecting section 106 and the semiconductor layer 31.

The structure in FIG. 63 includes light blocking walls 108 that are formed by forming trenches through the insulating film 107 to reach the light blocking film 47, embedding a light blocking material, for example, tungsten, and performing CMP. By providing the light blocking walls 108 in such a manner, it becomes possible to interrupt crosstalk paths between the semiconductor layer 31 and the deflecting section 106.

The structure in FIG. 64 is provided with light blocking walls 108 whose upper ends are at a distance from the deflecting section 106 in order to reduce vignetting of the upper ends of the light blocking walls 108. Although crosstalk deteriorates slightly, sensitivity deterioration can be suppressed.

The structure in FIG. 65 is provided with, as clad sections 109, a material having a refractive index lower than that of the insulating film 107. By providing the clad sections 109 in such a manner, the clad sections 109 do not absorb light, and sensitivity deterioration can be suppressed. It should be noted that the property in terms of crosstalk interruption deteriorates. Note that the clad sections 109 may be formed as voids and the insulating film 107 may be formed by a film formation method with low coverage to close the upper ends of the voids.

The structure in FIG. 66 is provided with the clad sections 109, for example, voids, over the deflecting section 106. By providing the clad sections 109 in such a manner, the waveguide effect can be enhanced. It should be noted that there is concern over the fragility of the structure.

[Twenty-First Embodiment]

<Configuration of Division of Photoelectric Converting Section>

FIG. 67 is a plan view depicting a configuration of division of a photoelectric converting section in an optical detecting device according to a twenty-first embodiment of the present technology.

By dividing a photoelectric converting section 21 of a pixel 3 into multiple portions and generating a difference, it become possible to calculate a subject distance on the basis of an image shift amount and perform a camera lens fast focusing process or distance measurement (sensing). At the time of signal processing for image enhancement, the S/N may be improved by output addition within the pixel 100, or the blurred amount may be reduced by shifted-addition of images with different parallaxes.

There are various possible modification examples of division of a photoelectric converting section 21, and in a case of horizontal division into two depicted in FIG. 67, distance measurement of a subject with vertical stripe contrast is possible. In addition, in a case of horizontal and vertical division depicted in FIG. 68, distance measurement of both vertical stripes and horizontal stripes becomes possible. Division of a photoelectric converting section 212 is not limited to these.

In addition, derived examples similar to the instances described with regard to the boundaries of pixels 3 can be described with regard to the separation regions 32 in the pixels 3. Further, if the number of steps is increased, element separation in pixels 3 and element separation between the pixels 3 can also be combined differently. For example, it becomes possible to suppress inter-pixel crosstalk while the sensitivity in the pixels 3 is maintained, by embedding, as the separation regions 32 between the pixels 3, the light blocking film 47 as in FIG. 51 and attaining element separation in the pixels 3 by embedding a silicon oxide film as in FIG. 48. Note that this is not the sole example of combination.

[Twenty-Second Embodiment]

<Configuration of Color Filters>

Since the optimal design of a pillar-type metasurface structure including deflecting elements principally varies depending on wavelengths, it is desirable that a single wavelength be treated as a target wavelength as much as possible. For example, this metasurface structures are suitable for a case where, in sensing, light is actively projected from an IR-LED of a single color and reflection light is sensed or for other cases.

On the other hand, in a case where an image of a subject based on a light source of wide-band continuous wavelengths is to be captured, the metasurface designs are difficult if no measures are taken. However, it becomes easier to find design solutions of the metasurface elements by restricting the wavelength band by providing filters in the pixels.

FIG. 69 is a main-section schematic vertical cross-sectional view depicting an example of a configuration in which color filters 110 including generally used pigments or dyes are provided under deflecting elements in an optical detecting device according to a twenty-second embodiment of the present technology. By providing the color filters 110, it becomes possible to narrow the wavelength range, and the light controllability can be enhanced. In this case, it is desirable that the deflecting sections 106 have the lens functionality in addition to the prism functionality. Note that pillars in this case need to be included with different designs for different colors of pixels. The deflecting sections 106, for example, the metasurface structures 90, are arranged on the color filters 110 with an insulating film 111 being interposed therebetween.

FIG. 70 is a main-section schematic vertical cross-sectional view depicting an example of a configuration in which the color filters are provided on the deflecting sections. Such a configuration becomes possible since the fluctuation of transmission spectrums of the color filters 110 including pigments or dyes for oblique incidence is small. In a case of this configuration, the on-chip lenses 103 may be provided on the color filters 110 for oblique incident light at angle-of-view ends, and pupil correction may be applied. It becomes possible to reduce sensitivity loss due to inter-pixel light blocking. The color filters 110 are arranged on the deflecting sections 106, for example, the metasurface structures 90, with a flattening film 112 being interposed therebetween.

Next, FIGS. 71(a) to 71(d) depict array examples of color filters. FIG. 71(a) depicts a Bayer array including the three primary colors, RGB. FIG. 71(b) depicts a GRB-W array including pixels not having color filters mounted thereon. FIG. 71(c) depicts a Quad-Bayer array that enables 2 × 2 pixel addition or individual output. FIG. 71(d) depicts a clear bid array that improves the image resolution with an array rotated 45 degrees. For example, there may be arrays of complementary colors or arrays combining primary colors and complementary colors, and these are not the sole examples.

<Modification Examples of Color Filters>

<Combination with Plasmon Filter>

FIG. 72 is a main-section schematic vertical cross-sectional view depicting a combination with a plasmon filter. FIG. 73 is a schematic plan view of the plasmon filter as seen from above.

A plasmon filter 113 is an optical element that attains a light filtering effect by use of surface plasmon resonance, and uses a metallic conductor thin film as its base material. Efficiently attaining the surface plasmon resonance effect requires reduction of the electrical resistance of the surface of the conductor thin film as much as possible. As the metallic conductor thin film, aluminum or an alloy thereof that has low electrical resistance and can be processed easily is often used (e.g., Japanese Patent Laid-open No. 2018-98641).

It is known that the transmittance spectrum of the plasmon filter 113 varies for oblique incidence undesirably, and it is desirable that deflecting elements (metasurface structures) of the present technology be provided on the plasmon filter 113 and the deflecting elements be designed such that a principal ray from a camera lens is incident vertically for the peak wavelength of a spectrum of 0-degree incidence. The plasmon filter 113 is covered with an insulating film 114. Further, the deflecting sections 106 are arranged on the light incidence surface side of the plasmon filter 113 with the insulating film 114 being interposed therebetween. By providing the plasmon filter 113 in such a manner, the uniformity of the transmission spectrum in the angle of view can be improved.

<Combination with GMR Filter>

FIG. 74 is a main-section schematic vertical cross-sectional view depicting a combination with a GMR filter. FIG. 75 is a plan view of the GMR filter as seen from above.

A GMR (Guided Mode Resonance) filter 115 is an optical filter that allows transmission of only light in a narrow wavelength band (narrow band) by combining a diffraction grating (A) and a clad-core structure (B) (e.g., Japanese Patent Laid-open No. 2018-195908). The GMR filter 115 uses resonance of a waveguide mode that occurs in a waveguide and diffracted light, provides high light use efficiency, and attains a sharp resonance spectrum.

It is known that the transmittance spectrum of the GMR filter 115 varies for oblique incidence undesirably, and it is preferable that the deflecting sections 106 of the present embodiment be provided on the GMR filter 115 and deflecting elements be designed for each pixel such that a principal ray from a camera lens is incident vertically to the GMR filter 115. By providing the GMR filter 115 in such a manner, the uniformity of the transmission spectrum in the angle of view can be improved.

<Combination with Stacked Filter Having Different Refractive Indices>

FIG. 76 is a main-section schematic vertical cross-sectional view depicting a combination with a stacked filter having different refractive indices. FIG. 77 is an enlarged view of a part of the stacked filter having the different refractive indices.

A stacked filter 117 includes alternately-stacked films that have different refractive indices and whose film thicknesses are controlled, and can give a particular transmission/reflection spectrum by a light interference effect. In addition, it is also possible to design a narrow-band spectrum by setting a pseudo defect layer that disturbs regularity by a technology called photonic crystal.

However, due to the fact that, if light is incident obliquely on the stacked filter 117, the effective film thickness increases undesirably, the spectrum shifts to short wavelengths undesirably.

Preferably, for such a stacked filter 117, the deflecting sections 106 are provided on the stacked filter 117, and deflecting elements are designed for each pixel such that a principal ray from a camera lens is incident vertically to the stacked filter 117.

As described above, according to the embodiment, as the deflecting sections 106, the metasurface structures having the prism functionality with pillars 93 which are different among different pixels 3 are provided on the light incidence surface side of the photoelectric converting sections 21. As a result, optical characteristics regarding crosstalk and non-uniformity of sensitivity and a transmission spectrum due to oblique incidence at angle-of-view ends can be improved. In addition, a process of changing the shapes of on-chip lenses 103 becomes unnecessary, and with a simple process of using the metasurface elements, optical characteristics regarding crosstalk and non-uniformity of sensitivity and a transmission spectrum due to oblique incidence at angle-of-view ends can be improved.

In addition, according to the embodiment, by providing the deflecting sections 106 at at least two or more stages via flat films, optical characteristics regarding crosstalk and sensitivity non-uniformity due to oblique incidence at angle-of-view ends can be improved, and control for each color of a continuous wavelength spectrum can also be realized even in a case where sufficient phase differences cannot be attained with a single layer.

In addition, according to the embodiment, since pillars 93 having a high refractive index can reflect light easily, by providing the reflection preventing films having different refractive indices to the pillars 93, reflection prevention can be realized from the viewpoint of sensitivity and flares.

[Configuration Example of Pillars]

<Derivation of Metaface Design (Prism Functionality)>

Next, derivation of a metasurface design with the prism functionality is explained.

(Step 1) Derivation of Phase Difference Map for Each Pixel

As depicted in FIG. 78, when it is assumed that the angle of incidence of light of a certain pixel 3 is θ, its pixel size is D, an expected wavelength is X, and a pillar position in the pixel is x, a phase difference necessary for vertical incidence can be determined according to Formula (1).
[Math. 1]

$$\Delta\varphi_{pri}(x) = \frac{x \cdot \sin\theta - D \cdot \sin\theta}{\lambda} \qquad \ldots \text{Formula (1)}$$

Whereas a prism angle in the x direction is depicted for simplification here, a phase difference map corresponding to prism angles of any directions can be created by two-dimensional extension as depicted in FIG. 79.
Note that, since it is sufficient if relative phase differences are set between pillars 93 in a prism design, the variability of constants is tolerated.

(Step 2) Derivation of Phase Difference Library

For the structure to be mounted on the photodetector, taking into consideration the pitches, heights, refractive indices, extinction coefficients, and shapes of pillars, the film composition near the pillars, and the like, a phase difference library associating phase differences and pillar diameters is created as depicted in FIG. 80.
The phase difference library may be calculated by performing optical simulation such as FDTD or RCWA or can also be determined experimentally. Note that light with a phase difference α is equivalent to α + 2π × N (N is an integer). That is, even in a case where the phase difference of 2π + φ is necessary, it is sufficient if only the phase difference of φ is set. Such replacement with an equivalent phase is called a "2π turn."

(Step 3) Derivation of Pillar Layout

On the basis of the phase difference map, a phase difference of each pillar 93 can be replaced with a pillar diameter by use of the phase difference library, but since there are constraints in terms of process limitations due to various causes such as the resolution of lithography or pattern collapses of pillars with high aspect ratios, these are specified as design rules, and control is performed such that pillars 93 to be generated satisfy the design rules.
Specifically, a possible process is to replace the phase difference of each pillar 93 with a pillar diameter depicted in FIG. 81(c) by adjustment (uniform offset process) of constant terms depicted in FIG. 81(a) and a process of a 2n turn depicted in FIG. 81(b) for phase differences. In a case where the design rules cannot be satisfied with these processes, the following measures are implemented.
The first measure is to forcibly make a non-2n turn. In a case where this process is performed, there is concern that scattering occurs at a turn portion and stray light is generated.
The second measure is to forcibly perform a rounding process such that pillar diameters of patterns not satisfying the design rules approximate to the pillar diameters of their closest phases satisfying the design rules. The amounts of rounding can be errors, but this can be tolerated if the influence on pixel characteristics is only to the extent that does not cause a problem.

[Modification Example of Pillar Configuration]

Next, derivation of a metasurface design combining the prism functionality and the lens functionality is explained.
FIG. 82 is a plan view depicting the angle of view of a photodetector according to the embodiment.
FIG. 83 is a plan view depicting an arrangement example of pillars for each image height.

In a deflecting section 106 in FIG. 82, pillars 93 of each pixel are designed to have a combination of a lens design to condense light onto the center of the pixel and a deflection design according to a prism angle necessary for the image height, according to image heights in order to use light at angle-of-view ends of the photodetector effectively. That is, as represented by FIG. 82(1), a principal ray of a module lens is incident vertically on a pixel 3 positioned at the angle-of-view middle (the center of the image height), a deflecting section 106-1 corresponding to the pixel 3 is arranged point-symmetrically about the pixel center as depicted in FIG. 83(1), and the degrees of phase advances increase as the distances to the periphery decrease, that is, light having passed through the deflecting section 106-1 is condensed toward the center of the pixel 3. Since the pillars 93 are arranged point-symmetrically, the direction of the principal ray does not vary.

In a case of an image height (2) represented by FIG. 82(2), a principal ray is incident at an inclination of 10 deg in the horizontal direction, and a deflecting section 106-2 is provided to a pixel 3 corresponding to the image height (2). In the deflecting section 106-2, as depicted in FIG. 83(2), in addition to the lens design of the center of the image height described above, pillars 93 are arranged with linearly shifted phase differences in the horizontal direction in such a manner as to attain prism angles that make light with the angle of incidence of 10 deg in the horizontal direction vertical. With the arrangement in such a manner, the deflecting section 106-2 can simultaneously combine the lens functionality of condensing light toward the pixel center and the prism functionality of attaining the prism angles of 10 deg.

In a case of an image height (3) represented by FIG. 82(3), a principal ray is incident at an inclination of 20 deg in the horizontal direction, and a deflecting section 106-3 is provided to a pixel 3 corresponding to the image height (3). In the deflecting section 106-3, as depicted in FIG. 83(3), in addition to the lens design of the center of the image height described above, pillars 93 are arranged with linearly shifted phase differences in the horizontal direction in such a manner as to attain prism angles that make light with the angle of incidence of 20 deg in the horizontal direction vertical. This linear inclination of phase differences is approximately twice as large as the inclination at the time of 10 deg. With the arrangement in such a manner, the deflecting section 106-3 can simultaneously combine the lens functionality of condensing light toward the pixel center and the prism functionality of attaining the prism angles of 20 deg.

In a case of an image height (4) represented by FIG. 82(4), a principal ray is incident at an inclination of 30 deg in the horizontal direction, and a deflecting section 106-4 is provided to a pixel 3 corresponding to the image height (4). In the deflecting section 106-4, as depicted in FIG. 83(4), in addition to the lens design of the center of the image height described above, pillars 93 are arranged with linearly shifted phase differences in the horizontal direction in such a manner as to attain prism angles to make light with the angle of incidence of 30 deg in the horizontal direction vertical. With the arrangement in such a manner, the deflecting section 106-4 can simultaneously combine the lens functionality of condensing light toward the pixel center and the prism functionality of attaining the prism angles of 30 deg. Note that FIG. 82(1) to 82(4) are examples, and it also becomes possible to adopt a layout which is different in terms of 2n turns of phase differences or offset processes. What is important is relative phase differences between pillars 93.

<Derivation of Metasurface Design>

(Step 1) Derivation of Phase Difference Map for Each Pixel

If a phase difference map for attaining a lens functionality and a phase difference map for attaining a prism functionality can be determined, these are simply added for each pillar, and it is thereby possible to synthesize a phase difference map (FIG. 84(c)) combining the lens functionality and the prism functionality. An explanation of the procedure of deriving a prism phase difference map depicted in FIG. 84(a) is omitted since it is described before. Phase differences in a lens phase difference map depicted in FIG. 84(b) can be calculated from lens thicknesses corresponding to respective pillar positions and an expected wavelength if expected lens shapes and refractive indices are known. Alternatively, the phase differences may be calculated by performing optical simulation such as FDTD or RCWA or can also be determined experimentally. Note that it is also possible to give only the lens functionality without adopting a prism design for each pixel 3.

In a more generalized expression, if a refractive index and a geometric shape of a material at the time when it is attempted to mount, on each pixel, an optical element which is given a certain functionality can be given, it is possible to make the shape reflected in a phase difference map, and the functionality can be realized by specifying the diameter of each pillar by conversion based on a phase difference library and creating pillar elements (metasurface structures). Further, by synthesizing multiple phase difference maps designed in such a manner, it also becomes possible to realize multiple functionalities simultaneously.

As depicted in FIG. 85, if a function of a lens thickness $T(x,y)$ regarding the geometric shape is given for the position $(x,y)$ of a pillar, a lens phase difference map is determined according to Formula (2) assuming that the refractive index of a lens is ni and the refractive index above the lens (e.g., atmospheric air) is $n_2$.
[Math. 2]

$$\Delta\varphi_{lens}(x,y) = \frac{T(x,y)}{(n_1 - n_2)\lambda}$$

... Formula (2)

[Twenty-Third Embodiment]

<<Example of Application to Electronic Equipment>>

The present technology (the technology according to the present disclosure) can be applied to various types of electronic equipment such as image capturing devices such as digital still cameras or digital video cameras, mobile phones having an image-capturing functionality, or other equipment having an image-capturing functionality, for example.

FIG. 86 is a figure depicting a schematic configuration of electronic equipment (e.g., a camera) according to a twenty-third embodiment of the present technology.

As depicted in FIG. 86, electronic equipment 200 includes a solid-state image capturing device 201, the optical lens 202, a shutter device 203, a drive circuit 204 and a signal processing circuit 205. The electronic equipment 200 represents an embodiment in a case where, as the solid-state image capturing device 201, a solid-state image capturing device according to an embodiment of the present technology and a distance measurement sensor are used for electronic equipment (e.g., a camera).

The optical lens 202 causes an image of image light (the incident light 206) from a subject to be formed, onto the image capturing surface of the solid-state image capturing device 201. As a result, a signal charge is accumulated in the solid-state image capturing device 201 over a predetermined period. The shutter device 203 controls the light illumination period and light blocking period of light heading toward the solid-state image capturing device 201. The drive circuit 204 supplies drive signals for controlling a transfer operation of the solid-state image capturing device 201 and a shutter operation of the shutter device 203. Signal transfer of the solid-state image capturing device 201 is performed according to drive signals (timing signals) supplied from the drive circuit 204. The signal processing circuit 205 performs various types of signal processing on a signal (pixel signal) output from the solid-state image capturing device 201. A video signal having been subjected to the signal processing is stored on a storage medium such as a memory or output to a monitor or the like.

The solid-state image capturing device 201 has metasurface structures, the direction of an inclined incident principal ray from the optical lens 202 is controlled for each pixel, and, for example, the principal rays can be caused to be incident vertically on photoelectric converting sections at any image heights. With such a configuration, the electronic equipment 200 of the nineteenth embodiment can ameliorate sensitivity non-uniformity or shading in the angle of view, crosstalk deterioration, and the like.

Note that the electronic equipment 200 to which a solid-state image capturing device according to one of the embodiments described above can be applied is not limited to a camera, and a solid-state image capturing device according to one of the embodiments described above can be applied also to other electronic equipment. For example, it may be applied to an image capturing device such as a camera module for mobile equipment such as a mobile phone or a tablet terminal.

[Twenty-Fourth Embodiment]

[Example of Application to Electronic Equipment]

This embodiment is an example in which the structure of pixels according to the present disclosure is applied to a light-receiving section of a distance measuring device that performs distance measurement by use of reflection of light. FIG. 87 is a block diagram depicting a configuration of an example of electronic equipment using a distance measuring device that can be applied to the present embodiment. Electronic equipment 300 includes a distance measuring device 301 and an application section 320.

For example, the application section 320 is realized by a program being operated on a CPU, requests the distance measuring device 301 to execute distance measurement, and receives distance information which is a result of distance measurement or the like from the distance measuring device 301.

The distance measuring device 301 includes a light source section 310, a light-receiving section 311, and a distance measurement processing section 312. For example, the light source section 310 includes a light-emitting element that emits light with an infrared region wavelength and a drive circuit that drives the light-emitting element to cause the light-emitting element to emit light. For example, an LED (Light Emitting Diode) can be applied as the light-emitting element included in the light source section 310. This is not the sole example, and a VCSEL (Vertical Cavity Surface Emitting LASER) in which multiple light-emitting elements are formed in an array can also be applied as the light-emitting element included in the light source section 310.

For example, the light-receiving section 311 includes light-receiving elements that can detect light with an infrared region wavelength and a signal processing circuit that outputs pixel signals according to light detected by the light-receiving elements. The pixels 3 explained in the first embodiment can be applied as the light-receiving elements included in the light-receiving section 311.

For example, the distance measurement processing section 312 executes a distance measurement process in the distance measuring device 301 according to a distance measurement instruction from the application section 320. For example, the distance measurement processing section 312 generates a light source control signal for driving the light source section 310, and supplies the light source control signal to the light source section 310.

In addition, the distance measurement processing section 312 controls light-reception by the light-receiving section 311 in synchronization with the light source control signal supplied to the light source section 310. For example, the distance measurement processing section 312 generates an exposure control signal for controlling an exposure period at the light-receiving section 311 in synchronization with the light source control signal, and supplies the exposure control signal to the light-receiving section 311. The light-receiving section 311 outputs effective pixel signals in the exposure period represented by the exposure control signal.

The distance measurement processing section 312 calculates distance information on the basis of the pixel signals output from the light-receiving section 311 according to the light-reception and the light source control signal for driving the light source section 310. In addition, the distance measurement processing section 312 can also generate predetermined image information on the basis of the pixel signals. The distance measurement processing section 312 passes, to the application section 320, the distance information and the image information calculated and generated on the basis of the pixel signals.

In such a configuration, for example, the distance measurement processing section 312 generates the light source control signal for driving the light source section 310, according to the instruction for execution of distance measurement from the application section 320, and supplies the light source control signal to the light source section 310. Along with this, the distance measurement processing section 312 controls light-reception by the light-receiving section 311 on the basis of the exposure control signal synchronized with the light source control signal.

In the distance measuring device 301, the light source section 310 emits light according to the light source control signal generated by the distance measurement processing section 312. The light emitted at the light source section 310 is emitted from the light source section 310 as exiting light 330. For example, the exiting light 330 is reflected on a measurement-target object 331, and received by the light-receiving section 311 as reflection light 332.

The light-receiving section 311 supplies, to the distance measurement processing section 312, pixel signals according to the reception of the reflection light 332. The distance measurement processing section 312 measures a distance D to the measurement-target object 331 on the basis of the timing at which the light source section 310 emits the light and the timing at which the light is received by the light-receiving section 311. Here, as distance measurement schemes using reflection light, the direct ToF (Time of Flight) scheme and the indirect ToF scheme are known.

In the direct ToF scheme, measurement of the distance D is performed on the basis of the difference (temporal difference) between the timing of light-emission by the light source section 310 and the timing at which light is received by the light-receiving section 311. In addition, in the indirect ToF scheme, measurement of the distance D is performed on the basis of the phase difference between the phase of light emitted by the light source section 310 and the phase of light received by the light-receiving section 311.

In the direct ToF, avalanche elements are often used to amplify electrons. If light is incident obliquely on photoelectric converting sections 212 at angle-of-view ends, inter-pixel variation in time of arrival of photoelectrically-converted electrons at the avalanche elements occurs, and this becomes a cause of a distance measurement error. On the other hand, if the present embodiment is applied, it becomes possible to cause light to be incident vertically on photoelectric converting elements at any image heights, and the inter-pixel variation in time of arrival at the avalanche elements can be reduced.

In the indirect ToF, two charge accumulating sections called FD (Floating Difusion) are provided, and are read out alternately to calculate phases. If light is incident obliquely on photoelectric converting sections 212 at angle-of-view ends, an output difference is generated due to different crosstalk called PLS between the two FDs, and a shifted phase is calculated, causing a distance measurement error undesirably. On the other hand, if the present embodiment is applied, it becomes possible to cause light to be incident vertically on photoelectric converting elements at any image heights, the crosstalk difference between the two FDs is not generated, and distance measurement precision with less error can be realized. The present embodiment can be applied to the light-receiving section 311 of either the direct ToF or the indirect ToF.

It should be noted that the present technology may also adopt the following configurations.

(1) An optical detecting device including:

a pixel array section having multiple pixels that are arranged two-dimensionally therein, in which each pixel of the multiple pixels includes

a photoelectric converting section provided on a semiconductor layer, and
a metasurface structure that is provided on a light incidence surface side of the semiconductor layer and guides incident light to the photoelectric converting section, and

the metasurface structure includes

multiple pillars that are arranged at distances therebetween which are shorter than a wavelength of the incident light,
an underlying layer that is in contact from a semiconductor layer side of the pillars, and
a transparent support that connects and supports at least some of the multiple pillars, the transparent support being at a height position which is different from a height position of the underlying layer.

(2) The optical detecting device according to (1) above, in which

the transparent support is a transparent material filling spaces between the multiple pillars, and
the transparent material and the pillars have different refractive indices.

(3) The optical detecting device according to (1) above, in which the transparent support is reinforcement beams provided at a height position different from ends of the pillars.
(4) The optical detecting device according to (1) above, in which

the transparent support is a transparent protective film that planarly supports ends of the multiple pillars that are on a side opposite to the semiconductor layer side, and
the metasurface structure further includes voids provided between mutually adjacent ones of the pillars.

(5) The optical detecting device according to any one of (1) to (4) above, in which at least some of the pixels include pillars having different thicknesses, array pitches, or shapes in the pixels.
(6) The optical detecting device according to any one of (1) to (5) above, in which the metasurface structure is stacked at multiple stages.
(7) The optical detecting device according to any one of (1) to (6) above, in which the underlying layer that is in contact from the semiconductor layer side of the multiple pillars has recesses at portions between mutually adjacent ones of the pillars in a plan view.
(8) The optical detecting device according to any one of (1) to (7) above, in which the metasurface structure further includes a reflection preventing film that is provided on at least any one of the semiconductor layer side of the pillars and a side opposite to the semiconductor layer side and that has a refractive index different from a refractive index of the pillars.
(9) The optical detecting device according to (8) above, in which the reflection preventing film provided on the semiconductor layer side of the pillars is formed by use of a material having high etching selectivity relative to the pillars.
(10) The optical detecting device according to any one of (1) to (9) above, further including:
a light blocking film that is positioned between the light incidence surface side of the semiconductor layer and the metasurface structure and has openings at at least parts in the pixels.
(11) The optical detecting device according to any one of (1) to (10) above, in which a lens section having a curved surface shape is provided on at least any one of a light incidence surface side of the metasurface structure and a side opposite to the light incidence surface side.
(12) The optical detecting device according any one of (1) to (11) above, in which at least some of the pixels have a recess/projection shape on the light incidence surface side of the semiconductor layer.
(13) The optical detecting device according to any one of (1) to (12) above, in which the pillars include any material selected from amorphous silicon, polycrystalline silicon, germanium, titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure in which at least any two or more materials selected from the amorphous silicon, the polycrystalline silicon, the germanium, the titanium oxide, the niobium oxide, the tantalum oxide, the aluminum oxide, the hafnium oxide, the silicon nitride, the silicon oxide, the silicon oxynitride, the silicon carbide, the silicon oxycarbide, the silicon carbonitride, and the zirconium oxide are stacked.
(14) The optical detecting device according to (2) above, in which

the underlying layer that is in contact from the semiconductor layer side of the pillars includes

a main section two-dimensionally extending immediately below and around the pillars, and
protrusions that protrude from the main section immediately below the pillars and have widths narrower than widths of bottoms of the pillars, and

the pillars and the protrusions of the reflection preventing film are surrounded by the transparent material.

(15) The optical detecting device according to (2) above, in which the transparent material is divided by grooves in units of the pixels.

(16) The optical detecting device according to (2) above, in which the transparent material is formed by use of any material selected from siloxane-based resin, styrene-based resin, acrylic resin, and styrene-acrylic copolymer resin, a material containing fluorine in any material selected from the siloxane-based resin, the styrene-based resin, the acrylic resin, and the styrene-acrylic copolymer resin, or a material including any material selected from the siloxane-based resin, the styrene-based resin, the acrylic resin, and the styrene-acrylic copolymer resin and beads that have a refractive index lower than refractive indices of the siloxane-based resin, the styrene-based resin, the acrylic resin, and the styrene-acrylic copolymer resin and that internally fill the one selected from the siloxane-based resin, the styrene-based resin, the acrylic resin, and the styrene-acrylic copolymer resin.

(17) The optical detecting device according to (2) or (3), in which the transparent material or the reinforcement beams is/are formed by use of at least any material selected from silicon oxide, niobium oxide, tantalum oxide, aluminum oxide, hafnium oxide, silicon nitride, silicon oxynitride, silicon carbide, silicon oxycarbide, silicon carbonitride, and zirconium oxide or a stacked structure in which at least any two or more materials selected from the silicon oxide, the niobium oxide, the tantalum oxide, the aluminum oxide, the hafnium oxide, the silicon nitride, the silicon oxynitride, the silicon carbide, the silicon oxycarbide, the silicon carbonitride, and the zirconium oxide are stacked.

(18) The optical detecting device according to (11), in which the metasurface structure further includes a transparent protective film that is provided on a side opposite to the semiconductor layer of the transparent material and that is formed by use of an inorganic material.

(19) The optical detecting device according to (3), in which the metasurface structure further includes a transparent material that includes a material different from a material of the reinforcement beams and that fills spaces between mutually adjacent ones of the pillars.

(20) The optical detecting device according to (3), in which the reinforcement beams are provided, at multiple stages, being spaced apart from each other in a height direction of the pillars.

(21) The optical detecting device according to (4), in which the transparent protective film includes a material having a refractive index which is different from a refractive index of the pillars, and has a reflection preventing functionality.

(22) The optical detecting device according to (2), in which a refractive index difference between the pillars and the transparent material is equal to or greater than 0.3.

(23) The optical detecting device according to (3), further including:

a transparent material filling spaces between the multiple pillars, in which
a refractive index difference between the reinforcing material and the transparent material is equal to or smaller than 0.2.

(24) An optical-detecting-device manufacturing method including:

forming multiple pillars on a light incidence surface side of an underlying layer, the multiple pillars being arranged at distances therebetween which are shorter than a wavelength of incident light; and
filling spaces between mutually adjacent ones of the pillars with a transparent material.

(25) An optical-detecting-device manufacturing method including:

forming a transparent support on a light incidence surface side of an underlying layer; and
forming multiple pillars provided on the light incidence surface side of the underlying layer, mutually adjacent ones of the multiple pillars being supported by the transparent support.

(26) An optical-detecting-device manufacturing method including:

forming multiple pillars on a light incidence surface side of an underlying layer; and

forming reinforcement beams in a plan view at a height position which is different from a height position of ends of the pillars.

(27) An optical-detecting-device manufacturing method including:

forming multiple pillars on a light incidence surface side of an underlying layer, the multiple pillars being arranged at distances therebetween which are shorter than a wavelength of incident light; and
forming a transparent protective film that supports a side of each of the pillars which is opposite to a semiconductor layer side, such that there are voids between mutually adjacent ones of the pillars.

(28) Electronic equipment including:

an optical detecting device;
an optical lens that forms an image of image light from a subject onto an image capturing surface of the optical detecting device; and
a signal processing circuit that performs signal processing on a signal output from the optical detecting device, in which
a pixel array section having multiple pixels that are arranged two-dimensionally is provided,
each pixel of the multiple pixels includes

a photoelectric converting section provided on a semiconductor layer, and
a metasurface structure that is arranged on a light incidence surface side of the semiconductor layer and guides incident light to the photoelectric converting section, and

the metasurface structure includes

multiple pillars that are arranged at distances therebetween which are shorter than a wavelength of the incident light,
an underlying layer that is in contact from a semiconductor layer side of the pillars, and
a transparent support that connects and supports at least some of the multiple pillars, the transparent support being at a height position which is different from a height position of the underlying layer.

The scope of the present technology is not limited to the depicted and described illustrative embodiments, and also include all embodiments that can attain advantages that are equivalent to those aimed for by the present technology. Further, the scope of the present technology is not limited to combinations of features of the invention defined by claims, and can be defined by every desired combination of particular features in all the respective disclosed features.

[Reference Signs List]

1A, 1B, 1C: Solid-state image capturing device
2: Semiconductor chip
2A: Pixel array section
2B: Periphery
3: Pixel
4: Vertical drive section
5: Column signal processing section
8: Control section
8a, 8b: Signal line
11, 12: Signal line
21: Photoelectric converting section
22: Charge retaining section
23, 24, 25, 26: MOS transistor (MOSFET)
29: Pixel circuit
30: Semiconductor base
31: Semiconductor layer
32: Separation region

33: P-type semiconductor region

33b, 81, 99: Void

34: N-type semiconductor region

35: Multilayer wiring layer

36: Interlayer dielectric film

37: Wire

41: Support substrate

42: Warp correction film

45: Fixed electric charge film

46, 48, 107: Insulating film

47: Light blocking film

50, 70, 70A, 70B, 70C, 70D, 70E, 90, 90A: Metasurface structure

51, 53: Reflection preventing film

51a: Main section

51b: Protrusion

52: Pillar forming film

54: Pillar

55, 56: Transparent material

57, 97: Transparent protective film

58: Groove

60: Semiconductor wafer

61: Scribe line

62: Chip formation region

71: Reflection preventing film

72, 74, 95: Sacrificial film

73: Support forming film

75: Amorphous carbon film

77: Reinforcement beam

90, 90A: Metasurface structure

91: Reflection preventing film

92: Pillar forming film

93: Pillar

94: Reflection preventing film

95: Sacrificial film

97: Transparent protective film

99: Void

101: Diffraction/scattering element

102: Light splitting section

103: On-chip lens

104: Inner lens

106: Deflecting section

107: Insulating film

108: Light blocking wall

109: Clad section

110: Color filter

112: Flattening film

113: Plasmon filter

114: Insulating film

115: GMR filter

117: Stacked filter

200: Electronic equipment

201: Solid-state image capturing device

202: Optical lens

203: Shutter device

204: Drive circuit

205: Signal processing circuit

300: Electronic equipment

301: Distance measuring device

310: Light source section
311: Light-receiving section
312: Distance measurement processing section
320: Application section
330: Exiting light
331: Measurement-target object
332: Reflection light
RST: Reset signal line
SEL: Selection signal line
TR: Transfer signal line
Vdd: Power line

**Claims**

1. An optical detecting device comprising:

   a pixel array section having multiple pixels that are arranged two-dimensionally therein, wherein
   each pixel of the multiple pixels includes

      a photoelectric converting section provided on a semiconductor layer, and
      a metasurface structure that is provided on a light incidence surface side of the semiconductor layer and
      guides incident light to the photoelectric converting section, and

   the metasurface structure includes

      multiple pillars that are arranged at distances therebetween which are shorter than a wavelength of the
      incident light,
      an underlying layer that is in contact from a semiconductor layer side of the pillars, and
      a transparent support that connects and supports at least some of the multiple pillars, the transparent
      support being at a height position which is different from a height position of the underlying layer.

2. The optical detecting device according to claim 1, wherein

   the transparent support is a transparent material filling spaces between the multiple pillars, and
   the transparent material and the pillars have different refractive indices.

3. The optical detecting device according to claim 1, wherein the transparent support is reinforcement beams provided
   at a height position different from ends of the pillars.

4. The optical detecting device according to claim 1, wherein

   the transparent support is a transparent protective film that planarly supports ends of the multiple pillars that
   are on a side opposite to the semiconductor layer side, and
   the metasurface structure further includes voids provided between mutually adjacent ones of the pillars.

5. The optical detecting device according to claim 1, wherein at least some of the pixels include pillars having different
   thicknesses, array pitches, or shapes in the pixels.

6. The optical detecting device according to claim 1, wherein the metasurface structure is stacked at multiple stages.

7. The optical detecting device according to claim 1, wherein the underlying layer that is in contact from the semiconductor layer side of the multiple pillars has recesses at portions between mutually adjacent ones of the pillars in a
   plan view.

8. The optical detecting device according to claim 1, wherein the metasurface structure further includes a reflection
   preventing film that is provided on at least any one of the semiconductor layer side of the pillars and a side opposite
   to the semiconductor layer side and that has a refractive index different from a refractive index of the pillars.

9. The optical detecting device according to claim 8, wherein the reflection preventing film provided on the semiconductor layer side of the pillars is formed by use of a material having high etching selectivity relative to the pillars.

10. The optical detecting device according to claim 1, further comprising:
a light blocking film that is positioned between the light incidence surface side of the semiconductor layer and the metasurface structure and has openings at at least parts in the pixels.

11. The optical detecting device according to claim 1, wherein a lens section having a curved surface shape is provided on at least any one of a light incidence surface side of the metasurface structure and a side opposite to the light incidence surface side.

12. The optical detecting device according to claim 1, wherein at least some of the pixels have a recess/projection shape on the light incidence surface side of the semiconductor layer.

13. The optical detecting device according to claim 1, wherein the pillars include any material selected from amorphous silicon, polycrystalline silicon, germanium, titanium oxide, niobium oxide, tantalum oxide, aluminum oxide, hafnium oxide, silicon nitride, silicon oxide, silicon oxynitride, silicon carbide, silicon oxycarbide, silicon carbonitride, and zirconium oxide or a stacked structure in which at least any two or more materials selected from the amorphous silicon, the polycrystalline silicon, the germanium, the titanium oxide, the niobium oxide, the tantalum oxide, the aluminum oxide, the hafnium oxide, the silicon nitride, the silicon oxide, the silicon oxynitride, the silicon carbide, the silicon oxycarbide, the silicon carbonitride, and the zirconium oxide are stacked.

14. The optical detecting device according to claim 2, wherein

the underlying layer that is in contact from the semiconductor layer side of the pillars includes

a main section two-dimensionally extending immediately below and around the pillars, and
protrusions that protrude from the main section immediately below the pillars and have widths narrower than widths of bottoms of the pillars, and

the pillars and the protrusions of the reflection preventing film are surrounded by the transparent material.

15. The optical detecting device according to claim 2, wherein the transparent material is divided by grooves in units of the pixels.

16. The optical detecting device according to claim 2, wherein the transparent material is formed by use of any material selected from siloxane-based resin, styrene-based resin, acrylic resin, and styrene-acrylic copolymer resin, a material containing fluorine in any material selected from the siloxane-based resin, the styrene-based resin, the acrylic resin, and the styrene-acrylic copolymer resin, or a material including any material selected from the siloxane-based resin, the styrene-based resin, the acrylic resin, and the styrene-acrylic copolymer resin and beads that have a refractive index lower than refractive indices of the siloxane-based resin, the styrene-based resin, the acrylic resin, and the styrene-acrylic copolymer resin and that internally fill the one selected from the siloxane-based resin, the styrene-based resin, the acrylic resin, and the styrene-acrylic copolymer resin.

17. The optical detecting device according to claim 2 or 3, wherein the transparent material or the reinforcement beams is/are formed by use of at least any material selected from silicon oxide, niobium oxide, tantalum oxide, aluminum oxide, hafnium oxide, silicon nitride, silicon oxynitride, silicon carbide, silicon oxycarbide, silicon carbonitride, and zirconium oxide or a stacked structure in which at least any two or more materials selected from the silicon oxide, the niobium oxide, the tantalum oxide, the aluminum oxide, the hafnium oxide, the silicon nitride, the silicon oxynitride, the silicon carbide, the silicon oxycarbide, the silicon carbonitride, and the zirconium oxide are stacked.

18. The optical detecting device according to claim 11, wherein the metasurface structure further includes a transparent protective film that is provided on a side opposite to the semiconductor layer of the transparent material and that is formed by use of an inorganic material.

19. The optical detecting device according to claim 3, wherein the metasurface structure further includes a transparent material that includes a material different from a material of the reinforcement beams and that fills spaces between mutually adjacent ones of the pillars.

20. The optical detecting device according to claim 3, wherein the reinforcement beams are provided, at multiple stages, being spaced apart from each other in a height direction of the pillars.

21. The optical detecting device according to claim 4, wherein the transparent protective film includes a material having a refractive index which is different from a refractive index of the pillars, and has a reflection preventing functionality.

22. The optical detecting device according to claim 2, wherein a refractive index difference between the pillars and the transparent material is equal to or greater than 0.3.

23. The optical detecting device according to claim 3, further comprising:

a transparent material filling spaces between the multiple pillars, wherein
a refractive index difference between the reinforcing material and the transparent material is equal to or smaller than 0.2.

24. An optical-detecting-device manufacturing method comprising:

forming multiple pillars on a light incidence surface side of an underlying layer, the multiple pillars being arranged at distances therebetween which are shorter than a wavelength of incident light; and
filling spaces between mutually adjacent ones of the pillars with a transparent material.

25. An optical-detecting-device manufacturing method comprising:

forming a transparent support on a light incidence surface side of an underlying layer; and
forming multiple pillars provided on the light incidence surface side of the underlying layer, mutually adjacent ones of the multiple pillars being supported by the transparent support.

26. An optical-detecting-device manufacturing method comprising:

forming multiple pillars on a light incidence surface side of an underlying layer; and
forming reinforcement beams in a plan view at a height position which is different from a height position of ends of the pillars.

27. An optical-detecting-device manufacturing method comprising:

forming multiple pillars on a light incidence surface side of an underlying layer, the multiple pillars being arranged at distances therebetween which are shorter than a wavelength of incident light; and
forming a transparent protective film that supports a side of each of the pillars which is opposite to a semiconductor layer side, such that there are voids between mutually adjacent ones of the pillars.

28. Electronic equipment comprising:

an optical detecting device;
an optical lens that forms an image of image light from a subject onto an image capturing surface of the optical detecting device; and
a signal processing circuit that performs signal processing on a signal output from the optical detecting device, wherein
the optical detecting device includes a pixel array section having multiple pixels that are arranged two-dimensionally therein,
each pixel of the multiple pixels includes

a photoelectric converting section provided on a semiconductor layer, and
a metasurface structure that is arranged on a light incidence surface side of the semiconductor layer and guides incident light to the photoelectric converting section, and

the metasurface structure includes

multiple pillars that are arranged at distances therebetween which are shorter than a wavelength of the incident light,
an underlying layer that is in contact from a semiconductor layer side of the pillars, and
a transparent support that connects and supports at least some of the multiple pillars, the transparent support being at a height position which is different from a height position of the underlying layer.

# FIG.1

# F I G . 2

# FIG.3

# F I G . 4

# FIG.5

# FIG.6

# FIG.7

# FIG.8A

# FIG.8B

# FIG.9A

# FIG.9B

FIG.9C

FIG.9D

# FIG. 9E

# FIG. 9F

# FIG.9G

RM1

53

52

51

48

# FIG.9H

RM1

53

54

51

48

# FIG.9I

# FIG.9J

# FIG.9K

# FIG.9L

# FIG.10

57 50
55
53 — n1
54
51 — n2
48 — n3

51c  51c

# FIG.11

(1)   (2)   (3)

54

(4)   (5)   (6)   (7)   (8)

(9)   (10)   (11)   (12)   (13)   (14)

(15)   (16)   (17)   (18)   (19)   (20)   (21)

(22)   (23)

# FIG.12

# FIG.13A

# FIG.13B

# FIG.13C

Th1

55

51

48

# FIG.13D

Th1    Th1

52

55

51

48

# FIG.13E

Th1    54

55

51

48

## F I G . 1 3 F

# FIG.14

# FIG.15

# FIG.16

Legend:
- h_600mm (○)
- h_700mm (□)
- h_800mm (△)

X-axis: PILLAR DIAMETER ($\mu$m)
Y-axis: POSITION SHIFT (/2$\pi$)

# FIG.17

NO PHASE TURN
→ WAVE SURFACE IS CONTINUOUS

NECESSARY PHASE DELAY < PHASE DELAY AT PILLAR

PHASE ADVANCE

PHASE DELAY

PHASE TURN
→ WAVE SURFACE IS DISCONTINUOUS

NECESSARY PHASE DELAY > PHASE DELAY AT PILLAR
→ OVERLAPPED WITH PHASE SHIFT OF 2n

OVERLAPPED WITH PHASE SHIFT OF 2n
→ TURN OF PHASE

# FIG.18

FIG.19

FIG.20A

# FIG.20B

# FIG.20C

FIG.20D

Th1

78

74

77

72

71

48

FIG.20E

79

Th1

74

77

72

71

48

# FIG.20F

# FIG.20G

## FIG. 20H

## FIG. 21

# FIG. 22A

76
75
74
73
72
73
72
71
48

# FIG. 22B

Th1   Th1

76
75
74
77 (73)
72
77 (73)
72
71
48

FIG.22C

Th1   Th1

78
74
77 (73)
72
77 (73)
72
71
48

FIG.23

70B   81   79   79   81   77a

80
77
79
71
48

# FIG.24A

78
71
48

# FIG.24B

79(78)
71
48

# FIG.24C

# FIG.24D

FIG.24E

79  77a

79
77
72
71
48

FIG.24F

79  77a

74
77
79
72
71
48

# FIG.24G

# FIG.24H

FIG.25

FIG.26A

# FIG.26B

# FIG.26C

# FIG.27A

# FIG.27B

# FIG.28A

# FIG.28B

FIG.28C

FIG.29

FIG.30A

FIG.30B

FIG.30C

FIG.31A

$$P_A - P_R = \frac{2\gamma\cos\theta}{D}$$

FIG.31B

# FIG.32

# FIG.33

# FIG.34A

FIG.34B

95
93
91
48

FIG.34C

95
93
91
48

# F I G . 3 4 D

# F I G . 3 4 E

FIG.35A

FIG.35B

# FIG.35C

# FIG.35D

FIG.36A

95
91
48

FIG.36B

95a        95a

95

91
48

FIG.36C

95a    95a

92

95

91
48

# FIG.36D

95a  95a

93 (92)
95
91
48

# FIG.36E

95a

97
93
95
91
48

# FIG.36F

99

97
93
91
48

# FIG.37A

97
93
95
91
48

# FIG.37B

97a
97
95
93
91
48

# FIG.37C

# FIG.37D

# FIG.38A

# FIG.38B

# FIG.38C

# FIG.38D

# FIG.39

FIG.40

90A

99    99

97

94

93

91

48

# FIG.41

# FIG.42

# FIG.43

BLACK REFERENCE PIXELS      EFFECTIVE PIXELS

21

47

# FIG.44

BLACK REFERENCE PIXELS      EFFECTIVE PIXELS

21

47

# FIG.45

IMAGE SURFACE PHASE DIFFERENCE PIXELS

21

47    BLACK REFERENCE PIXELS         EFFECTIVE PIXELS

# FIG.46

21

47    BLACK REFERENCE PIXELS         EFFECTIVE PIXELS

# FIG.47

# FIG.48

# FIG.49

# F I G . 5 0

# FIG.51

# FIG.52

# FIG.53

# FIG.54A

47

# FIG.54B

101
21

# FIG.54C

21

# FIG.54D

37a
35

# FIG.55

(a)

(b)

# FIG.56

(a)

(b)

# FIG.57

(a)

(b)

# FIG.58

(a)

(b)

# FIG.59

# FIG.60

# FIG.61

# FIG.62

FIG.63

# FIG.64

FIG.65

# FIG.66

# FIG.67

# FIG.68

# FIG.69

# F I G . 7 0

# FIG.71

(a)

(b)

(c)

(d)

# FIG.72

# FIG.73

113

# FIG.74

# FIG.75

115

(A)

(B)

# FIG.76

# FIG.77

← 117

# FIG.78

PIXEL PITCH D

WAVE SURFACE OF ANGLE
OF INCIDENCE $\theta$

$D \cdot \sin\theta$

$x \cdot \sin\theta$

$\theta$

PIXEL
END

PIXEL
END

POSITION x

# FIG.79

| | | | | | | | | | |
|---|---|---|---|---|---|---|---|---|---|
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |

# FIG.80

Graph of PHASE SHIFT ($/2\pi$) versus PILLAR DIAMETER (um).

# FIG.81

(a)

PHASE DIFFERENCES
OF 10 × 10 PILLARS

REGION WHERE
PHASE DIFFERENCES
EXCEED 2π

(b)

2π TURN PROCESS

PHASE DIFFERENCE library

(c)

93

# FIG.82

ANGLE OF VIEW OF OPTICAL
DETECTING ELEMENT

IMAGE CIRCLE OF
MODULE LENS

◇ ○ △ □
(1) (2) (3) (4)

□ CRA0deg
△ CRA10deg
○ CRA20deg
◇ CRA30deg

# FIG.83

(1) 0 deg      (2) HORIZONTAL 10 deg      (3) HORIZONTAL 20 deg      (4) HORIZONTAL 30 deg

106-1    93       106-2       93       106-3    93       106-4       93

EP 4 383 333 A1

# FIG.84

**PRISM PHASE DIFFERENCE MAP**

| -0.09 | -0.28 | -0.47 | -0.65 | -0.84 | -1.02 | -1.21 | -1.40 | -1.58 | -1.77 |
|---|---|---|---|---|---|---|---|---|---|
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |
| -0.09 | -0.28 | -0.47 | -0.65 | -0.84 | -1.02 | -1.21 | -1.40 | -1.58 | -1.77 |

+

**LENS PHASE DIFFERENCE MAP**

| 0.00 | -0.09 | -0.25 | -0.34 | -0.38 | -0.38 | -0.34 | -0.25 | -0.09 | 0.00 |
|---|---|---|---|---|---|---|---|---|---|
| -0.09 | -0.29 | -0.42 | -0.50 | -0.54 | -0.54 | -0.50 | -0.42 | -0.29 | -0.09 |
| -0.25 | -0.42 | -0.54 | -0.61 | -0.64 | -0.64 | -0.61 | -0.54 | -0.42 | -0.25 |
| -0.34 | -0.50 | -0.61 | -0.67 | -0.70 | -0.70 | -0.67 | -0.61 | -0.50 | -0.34 |
| -0.38 | -0.54 | -0.64 | -0.70 | -0.74 | -0.74 | -0.70 | -0.64 | -0.54 | -0.38 |
| -0.38 | -0.54 | -0.64 | -0.70 | -0.74 | -0.74 | -0.70 | -0.64 | -0.54 | -0.38 |
| -0.34 | -0.50 | -0.61 | -0.67 | -0.70 | -0.70 | -0.67 | -0.61 | -0.50 | -0.34 |
| -0.25 | -0.42 | -0.54 | -0.61 | -0.64 | -0.64 | -0.61 | -0.54 | -0.42 | -0.25 |
| -0.09 | -0.29 | -0.42 | -0.50 | -0.54 | -0.54 | -0.50 | -0.42 | -0.29 | -0.09 |
| 0.00 | -0.09 | -0.25 | -0.34 | -0.38 | -0.38 | -0.34 | -0.25 | -0.09 | 0.00 |

**LENS + PRISM PHASE DIFFERENCE MAP**

| -0.09 | -0.37 | -0.71 | -0.99 | -1.22 | -1.41 | -1.55 | -1.64 | -1.67 | -1.77 |
|---|---|---|---|---|---|---|---|---|---|
| -0.18 | -0.57 | -0.89 | -1.15 | -1.37 | -1.56 | -1.71 | -1.82 | -1.88 | -1.86 |
| -0.34 | -0.70 | -1.00 | -1.26 | -1.48 | -1.66 | -1.82 | -1.93 | -2.00 | -2.02 |
| -0.43 | -0.78 | -1.07 | -1.32 | -1.54 | -1.73 | -1.88 | -2.00 | -2.08 | -2.11 |
| -0.47 | -0.82 | -1.10 | -1.36 | -1.57 | -1.76 | -1.91 | -2.04 | -2.12 | -2.15 |
| -0.47 | -0.82 | -1.10 | -1.36 | -1.57 | -1.76 | -1.91 | -2.04 | -2.12 | -2.15 |
| -0.43 | -0.78 | -1.07 | -1.32 | -1.54 | -1.73 | -1.88 | -2.00 | -2.08 | -2.11 |
| -0.34 | -0.70 | -1.00 | -1.26 | -1.48 | -1.66 | -1.82 | -1.93 | -2.00 | -2.02 |
| -0.18 | -0.57 | -0.89 | -1.15 | -1.37 | -1.56 | -1.71 | -1.82 | -1.88 | -1.86 |
| -0.09 | -0.37 | -0.71 | -0.99 | -1.22 | -1.41 | -1.55 | -1.64 | -1.67 | -1.77 |

# F I G . 8 5

LENS THICKNESS T(x,y)

# F I G . 8 6

FIG. 87

## INTERNATIONAL SEARCH REPORT

| International application No. |
| --- |
| **PCT/JP2022/029175** |

**A. CLASSIFICATION OF SUBJECT MATTER**

*H01L 27/146*(2006.01)i; *G02B 1/11*(2015.01)i; *G02B 5/00*(2006.01)i; *G02B 5/30*(2006.01)i; *H01L 31/0232*(2014.01)i; *H01L 31/10*(2006.01)i

FI: H01L27/146 D; H01L31/10 A; H01L31/02 D; G02B1/11; G02B5/30; G02B5/00 A

According to International Patent Classification (IPC) or to both national classification and IPC

**B. FIELDS SEARCHED**

Minimum documentation searched (classification system followed by classification symbols)

H01L27/146; G02B1/11; G02B5/00; G02B5/30; H01L31/0232; H01L31/10

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2019/124562 A1 (SONY SEMICONDUCTOR SOLUTIONS CORP.) 27 June 2019 (2019-06-27)<br>paragraphs [0062]-[0096], [0107]-[0113], [0122]-[0137], [0167]-[0173], fig. 7-13, 21, 23-25, 36 | 1, 2, 5, 6, 8, 9, 11, 13, 17, 18, 22, 24, 25, 28 |
| Y | | 5, 8-10, 12, 15, 16 |
| A | | 3, 4, 7, 14, 19-21, 23, 26, 27 |
| Y | JP 2015-28960 A (SONY CORP.) 12 February 2015 (2015-02-12)<br>paragraphs [0045]-[0052], [0099]-[0106], fig. 5, 16 | 8-10 |
| Y | WO 2018/092632 A1 (SONY SEMICONDUCTOR SOLUTIONS CORP.) 24 May 2018 (2018-05-24)<br>paragraphs [0016]-[0022], fig. 1 | 12 |
| Y | US 2021/0091130 A1 (OMNIVISION TECHNOLOGIES, INC.) 25 March 2021 (2021-03-25)<br>paragraph [0049], fig. 8 | 15 |

☑ Further documents are listed in the continuation of Box C.    ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **22 September 2022** | **04 October 2022** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT

International application No.

**PCT/JP2022/029175**

### C. DOCUMENTS CONSIDERED TO BE RELEVANT

| Category* | Citation of document, with indication, where appropriate, of the relevant passages | Relevant to claim No. |
|---|---|---|
| Y | JP 2012-182430 A (CANON INC.) 20 September 2012 (2012-09-20) paragraph [0052] | 16 |
| X | WO 2018/230186 A1 (NIKON CORP.) 20 December 2018 (2018-12-20) paragraphs [0011]-[0020], [0052]-[0061], fig. 1, 8 | 1, 2, 4, 6, 11, 13, 16-18, 21, 22, 24, 25, 27, 28 |
| Y | | 5, 8-10, 12, 15 |
| A | | 3, 7, 14, 19, 20, 23, 26 |
| A | JP 2011-40441 A (PANASONIC CORP.) 24 February 2011 (2011-02-24) entire text, all drawings | 1-28 |
| A | US 2017/0034500 A1 (SAMSUNG ELECTRONICS CO., LTD.) 02 February 2017 (2017-02-02) entire text, all drawings | 1-28 |
| A | JP 2009-157390 A (PANASONIC CORP.) 16 July 2009 (2009-07-16) entire text, all drawings | 1-28 |

Form PCT/ISA/210 (second sheet) (January 2015)

**INTERNATIONAL SEARCH REPORT**
Information on patent family members

International application No.

**PCT/JP2022/029175**

| Patent document cited in search report | | | Publication date (day/month/year) | Patent family member(s) | | | Publication date (day/month/year) |
|---|---|---|---|---|---|---|---|
| WO | 2019/124562 | A1 | 27 June 2019 | US | 2021/0366964 | A1 | |
| | | | | paragraphs [0202]-[0237], [0248]-[0254], [0263]-[0276], [0308]-[0314], fig. 7-13, 21, 23-25, 36 | | | |
| | | | | CN | 111357112 | A | |
| | | | | KR | 10-2020-0098490 | A | |
| JP | 2015-28960 | A | 12 February 2015 | WO | 2013/080872 | A1 | |
| WO | 2018/092632 | A1 | 24 May 2018 | US | 2019/0280026 | A1 | |
| | | | | paragraphs [0056]-[0063], fig. 1 | | | |
| | | | | CN | 109983578 | A | |
| US | 2021/0091130 | A1 | 25 March 2021 | (Family: none) | | | |
| JP | 2012-182430 | A | 20 September 2012 | US | 2012/0200751 | A1 | |
| | | | | paragraph [0056] | | | |
| | | | | CN | 102637702 | A | |
| WO | 2018/230186 | A1 | 20 December 2018 | EP | 3640987 | A1 | |
| | | | | paragraphs [0011]-[0020], [0052]-[0061], fig. 1, 8 | | | |
| | | | | US | 2020/0106969 | A1 | |
| JP | 2011-40441 | A | 24 February 2011 | (Family: none) | | | |
| US | 2017/0034500 | A1 | 02 February 2017 | KR | 10-2017-0015108 | A | |
| JP | 2009-157390 | A | 16 July 2009 | US | 2008/0272454 | A1 | |
| | | | | entire text, all drawings | | | |
| | | | | WO | 2006/025496 | A1 | |
| | | | | EP | 1785750 | A1 | |
| | | | | CN | 1993634 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020537193 W
- WO 2019046827 A
- JP 2018098641 A
- JP 2018195908 A